(19) Europäisches Patentamt
European Patent Office
Office européen des brevets

(11) **EP 4 217 700 B1**

(12) **EUROPÄISCHE PATENTSCHRIFT**

(45) Veröffentlichungstag und Bekanntmachung des Hinweises auf die Patenterteilung:
**01.10.2025 Patentblatt 2025/40**

(21) Anmeldenummer: **21762596.1**

(22) Anmeldetag: **10.08.2021**

(51) Internationale Patentklassifikation (IPC):
*G01L 27/00* (2006.01)  *G01M 99/00* (2011.01)
*H03M 1/12* (2006.01)  *G01R 17/10* (2006.01)
*G01D 3/08* (2006.01)

(52) Gemeinsame Patentklassifikation (CPC):
**G01L 27/007; G01M 99/00; G01R 17/10;**
G01D 3/08; H03M 1/1225

(86) Internationale Anmeldenummer:
**PCT/DE2021/100681**

(87) Internationale Veröffentlichungsnummer:
**WO 2022/057970 (24.03.2022 Gazette 2022/12)**

(54) **VERFAHREN ZUR ISO 26262 KONFORMEN AUSWERTUNG EINES DRUCKSENSORSIGNALS**

METHOD FOR ISO 26262-COMPLIANT EVALUATION OF A PRESSURE-SENSOR SIGNAL

PROCÉDÉ D'ÉVALUATION CONFORME À ISO 26262 D'UN SIGNAL DE CAPTEUR DE PRESSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.09.2020 DE 102020123930**

(43) Veröffentlichungstag der Anmeldung:
**02.08.2023 Patentblatt 2023/31**

(60) Teilanmeldung:
**24020075.8 / 4 376 303**

(73) Patentinhaber: **Elmos Semiconductor SE 44227 Dortmund (DE)**

(72) Erfinder: **BUDDE, Wolfram 44577 Castrop-Rauxel (DE)**

(56) Entgegenhaltungen:
EP-A2- 1 087 219    EP-A2- 2 362 203
CN-A- 109 212 258    DE-A1- 3 207 833

JP-A- 2001 183 254    US-A1- 2005 038 623

• WEI CHIA-LING ET AL: "Respiration Detection Chip With Integrated Temperature-Insensitive MEMS Sensors and CMOS Signal Processing Circuits", IEEE TRANSACTIONS ON BIOMEDICAL CIRCUITS AND SYSTEMS, IEEE, US, vol. 9, no. 1, 1 February 2015 (2015-02-01), pages 105 - 112, XP011571111, ISSN: 1932-4545, [retrieved on 20150123], DOI: 10.1109/TBCAS.2014.2315532

• GODOY P ET AL: "Chopper Stabilization of Analog Multipliers, Variable Gain Amplifiers, and Mixers", IEEE JOURNAL OF SOLID-STATE CIRCUITS, IEEE, USA, vol. 43, no. 10, 1 October 2008 (2008-10-01), pages 2311 - 2321, XP011235955, ISSN: 0018-9200, DOI: 10.1109/JSSC.2008.2004328

## Beschreibung

### Feld der Erfindung

Die Erfindung legt ein Verfahren zur Überwachung eines Sensorsystems im Betrieb mit einem Sensorelement (WB), insbesondere einer piezoresistiven Wheatstone-Brücke (WB) eines Drucksensors, und die zugehörigen Vorrichtungen und Verfahrensmodifikationen offen.

### Allgemeine Einleitung

Automobile Anwendungen setzen typischerweise zahlreiche sicherheitsrelevante Sensoren ein, die das Steuersystem des Fahrzeugs während ihres Betriebs typischerweise auf korrekte Funktion überwachen muss. Hierzu zählen beispielsweise Druckmessvorrichtungen in Bremssystemen.

### Stand der Technik

Aus dem Stand der Technik sind verschiedene Chopper-Verfahren zur Verbesserung des Signal-zu-Rauschverhältnisses in Verstärkern bekannt. Dabei multipliziert ein Multiplizierer vor dem Verstärker das Signal mit einem Chopper-Signal mit einer Chopper-Frequenz, dann verstärkt und dann wieder mit dem Chopper-Signal multipliziert. Dabei mischt diese Multiplikation das verstärkte Signal zum einen herauf- und zum anderen auch herunter. Da nur der heruntergemischte Anteil von Interesse ist, unterdrückt ein Tiefpassfilter die Signalanteile mit der Chopper-Frequenz und alle höheren Frequenzen. Dies unterdrückt typischerweise das 1/f-Rauschen der Verstärkerstufe.

Die Kombination eines solchen Verfahrens mit einem Sensorelement führt zu einem rauscharmen Sensorsystem.

Ein solches Sensorsystem realisiert somit dann ein Verfahren zum Betrieb eines Sensorsystems, bei dem das Sensorsystem ein Sensorelement aufweist, dass ein Eingangssignal mit einem zeitlichen Verlauf seines Eingangssignalwerts liefert. Ein solches Sensorsystem weist einen Signalpfad auf. Der Signalpfad umfasst an einer ersten Stelle des Signalpfads einen Verstärker mit einem Eingang und einem Ausgang. Der Signalpfad beginnt mit dem Eingangssignal des Sensorelements und endet mit einem ersten Ausgangssignal des Sensorsystems. Der Wert des ersten Ausgangssignals oder der Wert eines daraus abgeleiteten Signals stellt dabei den Messwert dar. Ein erster Schritt des Verfahrens aus dem Stand der Technik ist ein erstes Mischen des Signals im Signalpfad mit dem Chopper-Signal an einer zweiten Stelle im Signalpfad. Dabei befindet sich diese zweite Stelle im Signalpfad zwischen dem Eingangssignal des Sensorelements am Anfang des Signalpfads und dem Eingang des Verstärkers, der sich an der ersten Stelle im Signalpfad befindet. Das Chopper-Signal ist typischerweise monofrequent. Als weiterer Schritt erfolgt das zweite Mischen des Signals an einer dritten Stelle im Signalpfad. Das zweite Mischen des Signals ist typischerweise ein Heruntermischen des Signals mit dem Chopper-Signal zu einem ersten demodulierten Signal. Diese dritte Stelle befindet sich im Signalpfad zwischen dem Ausgang des Verstärkers, der sich an der ersten Stelle im Signalpfad befindet, und dem erstem Ausgangssignal des Sensorsystems, das sich am Ende des Signalpfads befindet. Ein erstes Filtern des ersten demodulierten Signals oder eines daraus abgeleiteten Signals erfolgt an einer vierten Stelle im Signalpfad. Die vierte Stelle im Signalpfad liegt zwischen der dritten Stelle im Signalpfad einerseits und dem Ausgangssignal des Sensorsystems am Ende des Signalpfads andererseits. Dabei erfolgt dieses erste Filtern mittels Anwendung einer ersten Filterfunktion auf das erste demodulierte Signal oder auf ein daraus abgeleitetes Signal. Die erste Filterfunktion beschreibt dabei den Zusammenhang zwischen dem zeitlichen Verlauf des ersten demodulierten Signals bzw. des daraus abgeleiteten Signals einerseits und dem zeitlichen Verlauf des Signals unmittelbar nach der ersten Filterung. Das erste Ausgangssignal ist von diesem Signal, das das Ergebnis der ersten Filterung ist, abhängig oder ist das Ergebnis dieser ersten Filterung.

Die erste Filterfunktion F1[] ist so gewählt, dass im Wesentlichen eine Filterung des Chopper-Signals Cs mit der ersten Filterfunktion F[] verschwindet, also F1[Cs]=0 gilt, und dass eine Filterung einer Konstanten F1[1]=$\beta_1$ mit $\beta_1$ als reellem oder komplexen Wert in Form einer Konstanten ergibt.

Der Nachteil ist, dass das Steuersystem solche Sensorsysteme für eine Überprüfung der Funktionstüchtigkeit im Betrieb typischerweise abschalten muss.

WEI CHIA-LING et al ("Respiration Detection Chip With Integrated Temperature-Insensitive MEMS Sensors and CMOS Signal Processing Circuits", IEEE Transactions on biomedical circuits and systems, Bd.9, Nr.1, S.105-112) offenbart ein Verfahren zur Überwachung eines Sensorsystems im Betrieb, wobei das Sensorsystem ein Sensorelement (MEMS Sensor) aufweist, das ein Eingangssignal mit einem zeitlichen Verlauf eines Eingangssignalwerts des Eingangssignals liefert und wobei das Sensorsystem einen Signalpfad aufweist und wobei der Signalpfad an einer ersten Stelle des Signalpfads einen Verstärker (DDA) mit einem Eingang und einem Ausgang umfasst und wobei der Signalpfad mit dem Eingangssignal des Sensorelements beginnt und wobei der Signalpfad mit einem ersten Ausgangssignal des Sensorsystems endet und wobei ein Wert des ersten Ausgangssignals oder ein Wert eines daraus abgeleiteten Signals einen Messwert darstellt.

Die US 2005/038623 A1 offenbart einen Vergleich eines Ausgangsensorsignals mit einem Referenzsignal (Erwartungswertintervall) zur Erkennung eines Sensorfehlers oder seiner elektronischen Komponenten.

GODOY et al. ("Chopper Stabilization of Analog Multipliers, variable gain amplifiers, and mixers", IEEE Journal of solid-state circuits, Bd.43, Nr.10, S.2311-2321) offenbart die Verwendung von orthogonalen Chopper-Signalen im Bereich der analogen Multiplizierer und Verstärker.

Die CN 109 212 258 A offenbart die Verwendung eines Chopper-Schaltkreises in einem Signalpfad zur Unterdrückung von Rauschen von Signalen eines Sensorsystems.

Auch die in diesen Druckschriften offenbarten Lösungen weißen den Nachteil auf, dass das Sensorsystem zur Überprüfung der korrekten Funktion der Schaltungsteile im Signalpfad abgeschaltet werden muss.

## Aufgabe

Aufgabe des Vorschlags ist daher, eine Lösung zu schaffen die diesen Nachteil des Stands der Technik nicht aufweist und weitere Vorteile aufweist. Ein Verfahren gemäß der unabhängigen Ansprüche löst diese Aufgabe.

## Lösung der Aufgabe

Zur Lösung des Problems schlägt die hier vorgelegte Schrift hier ein Verfahren zur Überwachung eines Sensorsystems im Betrieb vor, bei dem das Sensorsystem ein Sensorelement WB aufweist, das ein Eingangssignal Si mit einem zeitlichen Verlauf Si(t) seines Eingangssignalwerts liefert. Das Sensorsystem weist einen Signalpfad auf, in dem verschiedene Vorrichtungselemente das Signal im Signalpfad modifizieren und auswerten. Der Signalpfad umfasst an einer ersten Stelle des Signalpfads einen Verstärker DV mit einem Eingang und einem Ausgang. Der Signalpfad beginnt mit dem Eingangssignal Si, das das Ausgangssignal des Sensorelements WB ist. Der Signalpfad endet bei dem ersten Ausgangssignal out1 des Sensorsystems. Der Wert des ersten Ausgangssignals out1 des Sensorsystems oder der Wert eines daraus ggf. beispielsweise durch Verstärkung, Filterung oder sonstige weitere Aufbereitung abgeleiteten Signals stellt dann typischerweise den Messwert dar. Das vorgeschlagene Verfahren umfasst als einen beispielhaften ersten Schritt ein erstes Mischen des Signals im Signalpfad mittels eines ersten Mischers, beispielsweise eines ersten Multiplizierers M1, mit einem Chopper-Signal Cs an einer zweiten Stelle im Signalpfad, die typischerweise von der ersten Stelle, an der sich der Verstärker DV befindet, abweicht. Bevorzugt befindet sich also der Mischer bzw. erste Multiplizierer M1 an dieser zweiten Stelle im Signalpfad. Natürlich ist es auch denkbar, diese Mischung durch eine entsprechende Konstruktion des Verstärkers DV im Verstärker DV durchzuführen, wobei dann beispielsweise die Verstärkung des Verstärkers DV von dem Chopper-Signal Cs abhängen würde. Beispielsweise kann hierzu der Verstärker DV einen Gilbert-Multiplizierer als eine Verstärkerstufe umfassen. Es hat sich aber stattdessen allgemein bewährt, den Signalpfad differentiell auszuführen und den ersten Multiplizierer M1 als Umschalter zu realisieren, der in Abhängigkeit von dem Chopper-Signal Cs die beiden Signale des differentiellen Signals im Signalpfad vertauscht. Dies ist insbesondere bei der Verwendung einer Wheatstone-Brücke als Sensorelement WB sinnvoll, da diese bereits ein differentielles Signal liefert. Diese zweite Stelle für die Durchführung dieser ersten Mischung, also beispielsweise die Positionierung des ersten Multiplizierers, befindet sich typischerweise im Signalpfad zwischen dem Eingangssignal Si, das das Ausgangssignal des Sensorelements ist, am Anfang des Signalpfads und dem Eingang des Verstärkers DV an der ersten Stelle im Signalpfad. Damit die Unterdrückung des 1/f-Rauschens zuverlässig funktioniert, ist das Chopper-Signal Cs bevorzugt bandbegrenzt oder monofrequent. Diese Maßnahme hebt das Sensorausgangssignal, also der zeitliche Verlauf Si(t) des typischerweise sehr niederfrequenten Eingangssignals Si, um die Frequenz des Chopper-Signals Cs im Frequenzspektrum an. Die nachfolgenden Verstärkerstufen, Analog-zu-Digital-Wandler-Stufen und Filterstufen kontaminieren hierdurch den Frequenzbereich des somit frequenzangehobenen Eingangssignals Si nur noch mit weißem Rauschen und das Signal zu Rauschverhältnis verbessert sich. Um das verstärkte und digitalisierte Sensorsignal dann wieder nutzen zu können, muss das Sensorsystem diesen Vorgang wieder rückgängig machen. Hierzu führt typischerweise ein zweiter Mischer, der typischerweise ein zweiter Multiplizierer M2 ist, ein zweites Mischen des Signals an einer dritten Stelle im Signalpfad mit dem Chopper-Signal Cs zu einem ersten demodulierten Signal DM1 aus. Bevorzugt befindet sich diese dritte Stelle im Signalpfad zwischen dem Ausgang des Verstärkers DV, der sich ja an der ersten Stelle im Signalpfad befindet, und dem ersten Ausgangssignal out1 des Sensorsystems am Ende des Signalpfads. Ein erstes Filtern des ersten demodulierten Signals DM1 oder eines daraus abgeleiteten Signals erfolgt an einer vierten Stelle im Signalpfad zwischen der dritten Stelle im Signalpfad einerseits und dem Ausgangssignal out1 des Sensorsystems am Ende des Signalpfads andererseits. Typischerweise führt ein erster Tiefpass LP1 diese erste Filterung mit einer ersten Filterfunktion F1[] durch. Somit erfolgt dieses erste Filtern mittels der Anwendung der besagten ersten Filterfunktion F1[] auf das erste demodulierte Signal DM1 oder des daraus abgeleiteten Signals durch den ersten Tiefpassfilter LP1. Statt eines Tiefpassfilters sind anwendungsabhängig auch andere Filter denkbar. Die hier vorgelegte Schrift geht aber davon aus, dass der zu ermittelnde Messwert sich nur langsam und nicht vorhersehbar zyklisch ändert und dass somit der Gleichanteil des Messwerts die wesentliche Information darstellt. Die erste Filterfunktion F1[] beschreibt dabei den Zusammenhang zwischen dem zeitlichen Verlauf DM1(t) des ersten demodulierten Signals DM1 bzw. des daraus abgeleiteten Signals einerseits und dem zeitlichen Verlauf des Signals unmittelbar nach der ersten Filterung. Das erste Ausgangssignal out1 hängt von diesem Signal unmittelbar nach der ersten Filterung unter Anwendung der ersten Filterfunktion F1[] ab. Das erste Ausgangssignal out1 kann aber auch direkt das Ergebnis dieser ersten Filterung unter Anwendung der ersten Filterfunktion F1[] sein. Um nun im Gegensatz zum Stand der Technik die Signalverarbeitungsvorrichtungen im Signalpfad zu zumindest zu großen Teilen überwachen zu können, speist das Sensorsystem nun ein Testsignal TSS in den Signalpfad ein. Das Sensorsystem entnimmt das modifizierte Testsignal TSS nach dem Durchlaufen des Signalpfads wieder aus dem Signalpfad. Das Sensorsystem bewertet anschließend dieses wieder entnommene Testsignal. Die Konstruktion gestaltet die erste Filterfunktion F1[] und das Testsignal TSS sind dabei vorzugsweise so, dass bevorzugt das erste Ausgangssignal out1 keine wesentlichen Anteile des Testsignals TSS mehr enthält. Ein erster Tiefpassfilter LP1, der die erste Filterfunktion F1[] in dem Sensorsystem implementiert, sperrt also die Transmission von Signalanteilen entsprechend dem Testsignal TSS von seinem Eingang zu seinem Ausgang. Um diese Testsignalinjektion und -extraktion im Signalpfad vornehmen zu können umfasst das vorgeschlagene Verfahren zusätzliche Schritte. Hierzu gehört insbesondere das Addieren eines orthogonalen Chopper-Signals Cs90 oder eines daraus abgeleiteten Testsignals TSS zu dem Signal in dem Signalpfad. Diese Addition findet an einer fünften Stelle im Signalpfad statt. Diese fünfte Stelle befindet sich bevorzugt zwischen dem Eingangssignal Si, das das Ausgangssignal des Sensorelements WB ist, am Beginn des Signalpfads und dem Eingang des Verstärkers DV an der ersten Stelle im Signalpfad. Das Chopper-Signal Cs weist einen zeitlichen Verlauf Cs(t) des Chopper-Signals Cs auf und das orthogonale Chopper-Signal Cs90 weist analog dazu einen zeitlichen Verlauf Cs90(t) des orthogonalen Chopper-Signals Cs90 auf. Der zeitliche Verlauf Cs(t) des Chopper-Signals Cs muss einigen Bedingungen, die diese Schrift später angibt, genügen. Solange diese Bedingungen erfüllt sind, ist die Wahl des zeitlichen Verlaufs des Chopper-Signals Cs relativ frei. Die hier vorgelegte Schrift empfiehlt allerdings, die Frequenzbandbreite des Chopper-Signals nicht zu breit zu wählen, da ansonsten unter Umständen die Reaktionszeit des Sensorsystems leiden kann. Der zeitliche Verlauf Cs90(t) des orthogonalen Chopper-Signals Cs90 muss ebenfalls einigen, allerdings engeren Bedingungen, die diese Schrift später ebenfalls angibt, genügen. Solange diese Bedingungen erfüllt sind, ist die Wahl des zeitlichen Verlaufs des orthogonalen Chopper-Signals Cs90 relativ frei. Diese Schrift empfiehlt allerdings, die Frequenzbandbreite des orthogonalen Chopper-Signals Cs90 ebenfalls nicht zu breit zu wählen, da ansonsten unter Umständen die Reaktionszeit des Sensorsystems ebenfalls leiden kann. Der zeitliche Verlauf Cs90(t) des orthogonalen Chopper-Signals Cs90 weist bezüglich der besagten ersten Filterfunktion F1[] im Wesentlichen bis auf Rauschen und ähnliche Signalfehlern die Eigenschaft F1[Cs90(t) x Cs(t)]=0 zumindest zeitweise auf. Das bedeutet, dass das orthogonale Chopper-Signal Cs90 zu typischerweise vorbestimmbaren Zeiten orthogonal zum Chopper-Signal Cs ist.

Zur Erläuterung nehmen wir an, dass X(t) der zeitliche Verlauf eines beliebigen, nicht weiter definierten Signals ist. Wir nehmen beispielhaft an, dass die erste Filterfunktion F1[X] das zeitliche unbestimmte Integral des zeitlichen Verlaufs des beispielhaften Signals X(t) ist. Wir nehmen also an, dass gilt:

$$F1[X] = \int X \, dt$$

Unter dieser Voraussetzung würde dann gelten:

$$F1[\mathrm{Cs90(t)\ x\ Cs(t)}] = \int \mathrm{Cs90(t)\ x\ Cs(t)}\, dt$$

Die erste Filterfunktion F1[] wäre dann in diesem Beispiel nichts anderes als das L2-Produkt des Chopper-Signals Cs und des orthogonalen Chopper-Signals Cs90. Zum L2-Produkt verweisen wir beispielsweise auf https://de.wikipedia.org/wiki/Lp-Raum#Der_Hilbertraum_L2 und dort auf den Abschnitt "Der Hilbertraum $L^2$". Beim L2-Produkt handelt es sich um ein Skalarprodukt auf $L^2$. Eine andere Schrift ist beispielsweise das Skriptum "Einführung in die Differentialgeometrie" von Christopher R. Nerz, S198, Definition X.1.5, die der Leser zum Zeitpunkt der Anmeldung dieser Schrift unter https://www.math.uni-tuebingen.de/de/forschung/gadr/lehre/sose2015/diffgeo.pdf finden kann. Beispielsweise ist es vorstellbar, dass das Chopper-Signal Cs einer zeitlichen Sinusfunktion folgt und das orthogonale Chopper-Signal Cs90 einer zeitlichen Cosinus-Funktion folgt. In einem solchen Fall ist dann offensichtlich, dass dann die Bedingung F1[Cs90(t) x Cs(t)]=0 nicht immer, sondern nur zu bestimmten Zeiten erfüllt ist. Führt der besagte erste Tiefpassfilter LP1 die erste Filterfunktion aus, ist es somit sinnvoll, wenn die Konstruktion des Sensorsystems am Ausgang dieses ersten Tiefpassfilters LP1 eine Halteschaltung vorsieht., Die Halteschaltung tastet immer dann, wenn die

Bedingung F1[Cs90(t) x Cs(t)]=0 erfüllt ist, den aktuellen Wert der ersten Filterfunktion F1[] des ersten Tiefpassfilters LP1 ab. Die Halteschaltung friert dann bis zur nächsten Erfüllung der Bedingung F1[Cs90(t) x Cs(t)]=0 diesen aktuellen Wert an ihrem Ausgang ein. Diese Abtastung durch die Halteschaltung überführt das unbestimmte Integral des Beispiels in ein bestimmtes Integral.

$$F1[Cs90(t) \times Cs(t)] = \int_0^{T_p} Cs90(t) \times Cs(t)\, dt$$

Hierbei sei angenommen, dass das Chopper-Signal Cs und das orthogonale Chopper-Signal bezüglich einer gemeinsamen Signalperiode $T_p$ periodisch seien. Diese Abtastung des Filterausgangssignals eines Filters zu Zeitpunkten der tatsächlich vorliegenden Orthogonalität, also der Erfüllung der Randbedingungen soll auch für die im Folgenden noch erwähnten Filter und deren Filterungen gelten.

Als weiterer Schritt erfolgt ein drittes Mischen. Das dritte Mischen ist ein Mischen des ersten demodulierten Signals DM1 oder eines daraus abgeleiteten Signals einerseits mit dem orthogonalen Chopper-Signal Cs90 oder mit einem aus dem orthogonalen Chopper-Signal Cs90 abgeleiteten Signal andererseits. Das dritte Mischen erzeugt ein zweites demoduliertes Signal DM2. In diesem dritten Schritt filtert eine zweite Filterfunktion F2[] typischerweise als zweites Filtern auch das zweite demodulierte Signal DM2 oder ein daraus abgeleitetes Signal zu einem zweiten Ausgangssignal out2.

Die zweite Filterfunktion F2[] ist typischerweise so gewählt, dass im Wesentlichen die Bedingungen F2[Cs(t)]=0 und F2[Cs90(t)]=0 und F2[Cs(t)x Cs90(t)]=0 und F2[1]=$\beta_2$ mit $\beta_2$ als reellen oder komplexen Werten gelten. Des Weiteren ist die erste Filterfunktion F1[] typischerweise so gewählt, dass im Wesentlichen die Bedingungen F1[Cs90(t)]=0 und F1[Cs(t)]=0 und F1[Cs(t)x Cs90(t)]=0 und F1[1]=$\beta_1$ mit $\beta_1$ als reellem oder komplexen Wert gelten. Hierbei erfolgt bevorzugt jeweils eine Abtastung des Filterausgangssignals des zweiten Tiefpassfilters LP2 mit der zweiten Filterfunktion F2[] immer zu den Zeitpunkten, an denen diese Bedingungen für die zweite Filterfunktion F2[] erfüllt sind. Hierbei erfolgt eine Abtastung des Filterausgangssignals des ersten Tiefpassfilters LP1 mit der ersten Filterfunktion F1[] immer analog zu den Zeitpunkten, an denen diese Bedingungen für die erste Filterfunktion F1[] erfüllt sind. Das zweite Ausgangssignal out2 besteht daher bevorzugt aus den Abtastwerten des Ausgangswerts der zweiten Filterfunktion F2[DM2] des zweiten Tiefpassfilters LP2, die das Sensorsystem zu Zeiten, an denen die Bedingungen für die zweite Filterfunktion F2[] erfüllt sind, abtastet. Das erste Ausgangssignal out1 besteht daher bevorzugt aus den Abtastwerten des Ausgangswerts der ersten Filterfunktion F1[DM1] des ersten Tiefpassfilters LP1, die das Sensorsystem zu Zeiten, an denen die Bedingungen für die erste Filterfunktion F1[] erfüllt sind, abtastet.

Um nun auf die korrekte Funktion der Vorrichtungsteile im Signalpfad zu schließen, erfolgt ein erster Vergleich des Werts des zweiten Ausgangssignals out2 oder des Werts eines daraus abgeleiteten Signals einerseits mit einem Erwartungswertintervall andererseits. Des Weiteren folgt das Schließen auf einen Fehler eines Vorrichtungsteils im Signalpfad, wenn der Wert des zweiten Ausgangssignals out2 bzw. des daraus abgeleiteten Signals außerhalb des Erwartungswertintervalls liegt.

Es ist dem Fachmann offensichtlich, dass er ggf. Teile des Signalpfads in einem Signalprozessor und einem zugehörigen Signalprozessorprogramm implementieren kann. Wenn hier von einem Signalpfad die Rede ist, wird aus der räumlichen Positionierung im Falle einer Realisierung als Programm in einem Signalprozessor eine zeitliche Positionierung. Somit wandeln sich dann die Positionen im Signalpfad zu Bearbeitungszeitpunkten in der Abfolge der Signalverarbeitungsschritte. Die Ansprüche umfassen daher, auch wenn sie von der Formulierung her eine örtliche Positionierung und Anordnung nahelegen, auch eine zeitliche Positionierung und Abfolge.

Ein Dicke-Verfahren zur Reduktion des weißen Rauschens kann ggf. das vorgeschlagene Verfahren ergänzen. Die Grundidee eines Dicke-Receivers ist es das in einer rauschenden Umgebung platzierte Messobjekt mit einer Äquivalenzrauschquelle zu vergleichen.

Als Referenzrauschquelle verwendet unser Beispiel einer Wheatstone-Brücke WB daher eine zweite Wheatstone-Brücke, die Referenz-Wheatstone-Brücke RW, die die Konstruktion des Sensorsystem bevorzugt komplett gleich ausführt und die daher der Herstellungsprozess typischerweise gleich fertigt. Die Referenz-Wheatstone-Brücke RW kann typischerweise aber bevorzugt kein Messsignal zeigen. Ist das Sensorelement beispielsweise ein piezoresistiver mikromechanischer Drucksensor, bei dem eine Wheatstone-Brücke mit piezoresistiven Widerständen auf einer Membran über einer Kavität angeordnet ist, so kann beispielsweise das Referenzelement RW ein zweiter, exakt gleich gebauter und bevorzugt auf dem gleichen Silizium-Kristall realisierter zweiter Drucksensor mit einer zweiten gleich gebauten Wheatstone-Brücke sein. In dem nun folgenden Vorschlag erzeugt das Sensorsystem wird ein zweites Ausgangssignal out2, dass den Unterschied zwischen dem Ausgangssignal des Referenzelements, im Folgenden Referenzsignal Rs genannt, und dem Ausgangssignal des Sensorelements, hier das Eingangssignal Si, angibt. Für den Fall der Gleichheit von Sensorelement WB und Referenzelement RW, sollte dieses zweite Ausgangssignal out2 Null sein. Aufgrund von Fertigungstoleranzen und trotz aller Nähe doch leicht unterschiedlichen Betriebsparamatern wie der Temperatur und des unvermeidlichen Systemrauschens, wird dieses zweite Ausgangssignal out2 jedoch niemals in der Realität ganz Null sein. Vielmehr wird es sich wertmäßig innerhalb eines Erwartungswertintervalls bewegen müssen, was das Sensorsystem prüfen kann. Dies gilt auch für den Fall, dass das Referenzelement keinen Messwert liefern kann. Im Falle des beispielhaften mikromechanischen Drucksensors als Sensorelement, kann das Referenzelement RW beispielsweise auch nur die Referenz-Wheatstone-Brücke ohne eine Membran und ohne eine Kavität umfassen, sodass der Einfluss des Drucks massiv kleiner ist. In diesem Beispiel ist die Referenz-Wheatstone-Brücke gleich zur Wheatstone-Brücke gleich (englisch "matching") ausgeführt. In diesem Beispiel eines piezoresistiven Drucksensors sind die Wheatstone-Brücke des Drucksensors zusammen mit dessen Membran und dessen Kavität und zusammen mit der Referenz-Wheatstone-Brücke auf einem gemeinsamen Siliziumkristall untergebracht. In diesem beispielhaften Fall rauschen die Referenz-Wheatstone-Brücke und die Wheatstone-Brücke dann in gleicher Weise, was die Eliminierung des Rauschens ermöglicht.

Das vorgeschlagene Verfahren zur Reduktion des Rauschens umfasst daher als erstes das Bereitstellen eines Referenzelements RW, das ein Referenzsignal Rs liefert. Bei diesem Referenzelement RW kann es sich beispielsweise um die beispielhaft erwähnte Referenz-Wheatstone-Brücke handeln. Analog zur Verarbeitung des Eingangssignals Si im Signalpfad erfolgt ein entsprechendes Verarbeiten des Referenzsignals Rs in einem Referenzsignalpfad. Dabei ist von besonderer Wichtigkeit, dass der Referenzsignalpfad gleich dem Signalpfad zur Verarbeitung des Eingangssignals Si gestaltet ist. Dies bedeutet, dass der Referenzpfad Positionen der Bearbeitung des Referenzsignals im Referenzpfad aufweist, die direkt mit entsprechenden Positionen der Bearbeitung des Signals im Signalpfad entsprechen. Nimmt eine Vorrichtung im Referenzpfad eine Bearbeitung an einer Position im Referenzpfad vor, so nimmt eine entsprechende gleich ausgeführte Vorrichtung im Signalpfad die gleiche Bearbeitung des Signals im Signalpfad in der gleichen Weise vor. Somit ist die Signalverarbeitung des Referenzsignals Rs im Referenzpfad zunächst eine räumlich parallele Verarbeitung zur Signalverarbeitung des Eingangssignals Si im Signalpfad, die in möglichst gleicher Weise wie die Signalverarbeitung des Eingangssignals Si im Signalpfad erfolgt.

Eine alternative Konstruktion kann diesen Raummultiplex ggf. nun durch einen Zeitmultiplex in bestimmten Teilen des Signalpfads ersetzen, was den Vorteil hat, dass das Sensorsystem dann nicht nur gleiche Vorrichtungteile und Verfahrensschritte verwendet, sondern identische. Dies erhöht gegenüber dem Raummultiplex die Gleichheit des Rauschens im Referenzsignalpfad und im Signalpfad.

Unter Raummultiplex verstehen wir hier die zeitlich PARALLELE Verarbeitung von Signalen in mehreren gleichen oder ähnlichen Vorrichtungen. Im Gegensatz verstehen wir hier unter Zeitmultiplex die zeitlich SERIELLE Verarbeitung von Signalen in einer Vorrichtung. Beim Zeitmultiplex erfolgt die Verarbeitung in Signalpaketen, die die besagte Vorrichtung zeitlich nacheinander verarbeitet.

Der Referenzsignalpfad beginnt am Referenzelement RW mit dem Referenzsignal Rs. Der Referenzsignalpfad endet an dem zweiten Ausgangssignal out2.

Um das Referenzelement RW nutzen zu können, muss allerdings der Referenzsignalpfad am Beginn des Referenzpfads beim Referenzsignal Rs vom Signalpfad am Beginn des Signalpfads beim Eingangssignal Si verschieden sein. In dem hier vorgelegten Vorschlag soll zumindest der Verstärker DV dem Referenzsignalpfad und dem Signalpfad gemeinsam sein. Der Referenzsignalpfad umfasst somit an einer ersten Stelle des Referenzsignalpfads den Verstärker DV mit dem Eingang und dem Ausgang. Diese erste Stelle des Referenzsignalpfads mit dem Verstärker DV mit seinem Eingang und Ausgang ist somit auch die erste Stelle des Signalpfads mit dem Verstärker DV mit seinem Eingang und Ausgang. Somit ist der Verstärker DV Teil des Referenzsignalpfads an einer ersten Stelle im Referenzsignalpfad und gleichzeitig auch Teil des Signalpfads an der ersten Stelle des Signalpfads. Das Referenzsignal Rs befindet sich am Beginn des Referenzpfads. Der Referenzpfad weist eine sechste Stelle im Referenzpfad zwischen dem Referenzsignal Rs und dem Eingang des Verstärkers DV an der ersten Stelle im Referenzpfad auf. Der Signalpfad weist eine sechste Stelle im Signalpfad an einer korrespondierenden sechsten Stelle im Signalpfad zwischen dem Eingangssignal Si, das sich am Beginn des Signalpfads befindet, und dem Eingang des Verstärkers DV an der ersten Stelle im Signalpfad, die Signalpfad und Referenzpfad gemeinsam ist, auf. In dem Referenzsignalpfad befindet sich und in dem Signalpfad befindet sich an einer gemeinsamen sechsten Stelle im Referenzpfad und Signalpfad ein dem Signalpfad und dem Referenzpfad gemeinsamer Umschalter DS mit einem ersten Eingang und einem zweiten Eingang. In dem Referenzsignalpfad befindet sich der gemeinsame Umschalter DS somit an der sechsten Stelle im Referenzpfad. In dem Signalpfad befindet sich der gemeinsame Umschalter DS somit an einer korrespondierenden sechsten Stelle im Signalpfad, die eine gemeinsame sechste Stelle im Referenzpfad und Signalpfad ist.

Der gemeinsame Umschalter DS wählt als seinen aktiven Eingang in Abhängigkeit von einem zweiten Chopper-Signal Cs2 zwischen seinem ersten Eingang und seinem zweiten Eingang aus.

Der Signalpfad umfasst dabei den ersten Eingang des Umschalters DS, während der Referenzpfad den zweiten Eingang des Umschalters DS umfasst. Entsprechend umfasst der Signalpfad den zweiten Eingang des Umschalters DS nicht und der Referenzpfad den ersten Eingang des Umschalters DS nicht.

Der gemeinsame Umschalter DS wählt seinen aktiven in Abhängigkeit von einem zweiten Chopper-Signal Cs2 gewählten Eingang aus und schaltet dementsprechend den aktuellen Wert an diesem aktiven Eingang des gemeinsamen Umschalters DS an seinen Ausgang des gemeinsamen Umschalters DS durch.

Der Referenzpfad und der Signalpfad sind somit in dem Abschnitt vom Ausgang des gemeinsamen Umschalters

DS an der sechsten Stelle im Referenzsignalpfad und Signalpfad und dem Eingang des Verstärkers DV an der ersten Stelle im Referenzsignalpfad und Signalpfad identisch.

Die erste Filterung mit der ersten Filterfunktion F1[] ist hierbei aber ausgeklammert und ausdrücklich nicht Teil des Referenzsignalpfads. Typischerweise ist somit der angesprochene beispielhafte erste Tiefpassfilter TP kein Teil des Referenzsignalpfads.

Ein viertes Mischen des ersten demodulierten Signals DM1 oder eines daraus abgeleiteten Signals mit dem zweiten Chopper-Signal Cs2 erzeugt ein drittes demoduliertes Signal DM3. Dieses dritte Mischen kann in einem dritten Mischer, beispielsweise einem dritten Multiplizierer M3, erfolgen.

Ein drittes Filtern des dritten demodulierten Signals DM3 oder eines daraus abgeleiteten Signals mittels einer dritten Filterfunktion F3[] zu einem dritten Ausgangssignal out3 schließt die Signalverarbeitung zunächst hier ab. Dieses dritte Filtern kann beispielsweise in einem dritten Tiefpassfilter LP3 erfolgen, der die dritte Filterfunktion F3[] dann realisiert.

Das Sensorsystem muss eine saubere Trennung i) des Messsignalanteils des Sensorelements und ii) des Differenzsignalanteils aus der Differenz zwischen dem Messsignalanteil des Sensorelements WB und dem Referenzsignalanteil des Referenzelements RW und iii) des Testsignalanteils gewährleisten. Hierfür müssen a) die erste Filterfunktion F1[] des beispielhaften ersten Tiefpassfilters LP1 und b) die zweite Filterfunktion F2[] des beispielhaften zweiten Tiefpassfilters LP2 und c) die dritte Filterfunktion F3[] des beispielhaften dritten Tiefpassfilters LP3 bestimmte Bedingungen erfüllen.

Daher wählt die Konstruktion des Sensorsystems die erste Filterfunktion F1[] so, dass im Wesentlichen die folgenden Bedingungen erfüllt sind:

$$F1[Cs(t)]=0 \text{ und } F1[Cs2(t)]=0$$

$$F1[Cs90(t)]=0$$

$$F1[Cs(t)x\ Cs2(t)]=0$$

$$F1[Cs(t)x\ Cs90(t)]=0$$

$$F1[Cs2(t)x\ Cs90(t)]=0$$

$$F1[Cs(t)\ x\ Cs2(t)x\ Cs90(t)]=0$$

$$F1[1]=\beta_1$$

$\beta_1$ ist dabei ein reeller oder komplexer Wert. Wie zuvor erwähnt, tastet eine Vorrichtung des Sensorsystems bevorzugt der Ausgang des beispielhaften ersten Tiefpassfilters LP1 zu genau solchen Zeitpunkten ab, zu denen diese Bedingungen erfüllt sind, wenn man von den unvermeidlichen leichten Abweichungen durch Rauschen und Fertigungsfehler etc. absieht.

Die Konstruktion des Sensorsystems wählt auch die zweite Filterfunktion F2[] so, dass im Wesentlichen die folgenden Bedingungen erfüllt sind:

$$F2[Cs(t)]=0$$

$$F2[Cs2(t)]=0$$

$$F2[Cs90(t)]=0$$

$$F2[Cs(t)x\ Cs2(t)]=0$$

$$F2[Cs(t)x\ Cs90(t)]=0$$

$$F2[Cs2(t)x\ Cs90(t)]=0$$

$$F2[Cs(t)\ x\ Cs2(t)x\ Cs90(t)]=0$$

$$F2[1]=\beta_2\ .$$

$\beta_2$ ist dabei ein reeller oder komplexer Wert. Wie zuvor erwähnt, tastet eine Vorrichtung des Sensorsystems bevorzugt den Ausgang des beispielhaften zweiten Tiefpassfilters LP2 zu genau solchen Zeitpunkten ab, zu denen diese Bedingungen erfüllt sind. Dabei sieht die technische Lehre dieser Schrift von den unvermeidlichen leichten Abweichungen durch Rauschen und Fertigungsfehler etc. ab.

In gleicher Weise wählt die Konstruktion des Sensorsystem die dritte Filterfunktion F3[] so, dass im Wesentlichen die folgenden Bedingungen erfüllt sind:

$$F3[Cs(t)]=0$$

$$F3[Cs2(t)]=0$$

$$F3[Cs90(t)]=0$$

$$F3[Cs(t)x\ Cs2(t)]=0$$

$$F3[Cs(t)x\ Cs90(t)]=0$$

$$F3[Cs2(t)x\ Cs90(t)]=0$$

$$F3[Cs(t)\ x\ Cs2(t)x\ Cs90(t)]=0$$

$$F3[1]=\beta_3$$

Dabei ist $\beta_3$ ein reeller oder komplexer Wert. Bevorzugt tastet eine Halteschaltung des Sensorsystems bevorzugt den Ausgang des beispielhaften dritten Tiefpassfilters LP3 zu Abtastzeitpunkten ab. Diese Abtastzeitpunkt sind dabei genau solchen Zeitpunkten, zu denen die vorstehenden Bedingungen erfüllt sind. Dabei sieht die technische Lehre dieser Schrift von den unvermeidlichen leichten Abweichungen durch Rauschen und Fertigungsfehler etc. ab.

Um nun einen Defekt des Referenzelements oder des Sensorelements zu detektieren, erfolgt bevorzugt ein zweiter Vergleich des Werts des dritten Ausgangssignals out3 oder des Werts eines daraus abgeleiteten Signals mit einem dritten Erwartungswertintervall. Des Weiteren erfolgt das Schließen auf einen Fehler, wenn der Wert des dritten Ausgangssignals out3 bzw. der Wert des daraus abgeleiteten Signals außerhalb des dritten Erwartungswertintervalls liegt. Beispielsweise ein dritter Komparator und ein vierter Komparator oder ein Signalprozessor oder dergleichen können diesen Vergleich durchführen. Der dritte Komparator vergleicht dabei ggf. den Wert des dritten Ausgangssignals out3 mit einem dritten Schwellwert. Der vierte Komparator vergleicht dabei ggf. den Wert des dritten Ausgangssignals out3 mit einem vierten Schwellwert.

Der Nachteil der oben angegebenen Verfahren ist, dass das Sensorelement, hier die beispielhafte Wheatstone-Brücke WB, nicht Teil des mit dem Testsignal TSS geprüften Signalpfadteils ist. Die vorgeschlagene Verfahrensmodifikation behebt dies nun.

Somit schlägt diese Schrift nun ein modifiziertes Verfahren zur Überwachung eines Sensorsystems im Betrieb vor, bei dem das Sensorsystem wie zuvor ein Sensorelement WB aufweist, dass ein Eingangssignal Si mit einem Eingangssignalwert in Abhängigkeit von einem Testsignal TSS liefert.

Wie zuvor weist auch hier das Sensorsystem einen Signalpfad auf, der wieder an einer ersten Stelle im Signalpfad einen Verstärker DV mit einem Eingang und einem Ausgang umfasst.

Wie zuvor beginnt der Signalpfad mit dem Eingangssignal Si des Sensorelements WB und endet mit einem ersten Ausgangssignal out1.

Auch hier stellt der Wert des Ausgangssignals out1 den Messwert dar.

Wieder erfolgt ein erstes Mischen des Signals im Signalpfad mit einem Chopper-Signal Cs an einer zweiten Stelle im Signalpfad. Dabei befindet sich diese zweite Stelle im Signalpfad zwischen dem Eingangssignal Si des Sensorelements am Anfang des Signalpfads und dem Eingang des Verstärkers DV an der ersten Stelle im Signalpfad.

Das Chopper-Signal Cs ist wieder bandbegrenzt oder monofrequent.

Auch erfolgt wieder ein zweites Mischen des Signals an einer dritten Stelle im Signalpfad mit dem Chopper-Signal Cs zu einem ersten demodulierten Signal DM1. Dabei befindet sich die dritte Stelle im Signalpfad zwischen dem Ausgang des Verstärkers DV an der ersten Stelle im Signalpfad und dem ersten Ausgangssignal out1 des Sensorsystems am Ende des Signalpfads.

Wie zuvor erfolgt auch wieder ein erstes Filtern des ersten demodulierten Signals DM1 oder eines daraus abgeleiteten Signals an einer vierten Stelle im Signalpfad zwischen der dritten Stelle im Signalpfad einerseits und dem Ausgangssignal out1 am Ende des Signalpfads andererseits. Dabei erfolgt dieses erste Filtern mittels Anwendung einer ersten Filterfunktion F1[] auf das erste demodulierte Signal DM1 oder auf ein daraus abgeleitetes Signals. Dabei beschreibt die erste Filterfunktion F1[] den Zusammenhang zwischen dem zeitlichen Verlauf DM1(t) des ersten demodulierten Signals DM1 bzw. des daraus abgeleiteten Signals einerseits und dem zeitlichen Verlauf des Signals. Dieser Verlauf des Signals ist dabei der unmittelbar nach der ersten Filterung, also typischerweise der Verlauf des Filterausgangssignals. Das erste Ausgangssignal out1 hängt wieder von diesem Signal unmittelbar nach der ersten Filterung ab oder ist selbst das Ergebnis dieser ersten Filterung.

Im Gegensatz zum Stand der Technik erfolgt nun jedoch auch das Erzeugen des Testsignals TSS in Abhängigkeit von einem orthogonalen Chopper-Signal Cs90. Dabei weist das Chopper-Signal Cs einen zeitlichen Verlauf Cs(t) des Chopper-Signals Cs auf. Das orthogonale Chopper-Signal Cs90 weist dabei einen zeitlichen Verlauf Cs90(t) des orthogonalen Chopper-Signals Cs90 auf. Der zeitliche Verlauf Cs90(t) des orthogonalen Chopper-Signals Cs90 weist dabei bezüglich der besagten ersten Filterfunktion F1[] im Wesentlichen bis auf Rauschen und ähnliche Signalfehler die Eigenschaft $F1[Cs90(t) \times Cs(t)]=0$ zumindest zeitweise auf. Zumindest weist der zeitliche Verlauf Cs90(t) des orthogonalen Chopper-Signals Cs90 diese Eigenschaften zu den bereits diskutierten Zeitpunkten auf.

Im Gegensatz zum Stand der Technik erfolgen des Weiteren ein drittes Mischen des ersten demodulierten Signals DM1 oder eines daraus abgeleiteten Signals mit dem orthogonalen Chopper-Signal Cs90 oder einem daraus abgeleiteten Signal und die Erzeugung eines zweiten demodulierten Signals DM2.

Ein zweites Filtern des zweiten demodulierten Signals DM2 oder eines daraus abgeleiteten Signals mittels einer zweiten Filterfunktion F2[] resultiert in einem zweiten Ausgangssignal out2.

Die zweite Filterfunktion F2[] ist dabei so gewählt, dass im Wesentlichen $F2[Cs(t)]=0$ und $F2[Cs90(t)]=0$ und $F2[Cs(t) \times Cs90(t)]=0$ und und $F2[1]=\beta_2$, mit $\beta_2$ als reellem oder komplexen Wert, gelten. Wie zuvor tastet eine zweite Halteschaltung (englisch: Sample & Hold) den Ausgangswert des beispielhaften zweiten Tiefpassfilters LP2, der bevorzugt die zweite Filterfunktion F2[DM2] implementiert, zu Zeitpunkten ab, zu denen diese Bedingungen erfüllt sind.

Die erste Filterfunktion F1[] ist dabei so gewählt, dass im Wesentlichen $F1[Cs(t)]=0$ und $F1[Cs90(t)]=0$ und $F1[Cs(t) \times Cs90(t)]=0$ $F1[1]=\beta_1$, mit $\beta_1$ als reellem oder komplexen Wert, gelten. Wie zuvor tastes eine erste Halteschaltung (englisch: Sample & Hold) den Ausgangswert des beispielhaften ersten Tiefpassfilters LP1, der bevorzugt die erste Filterfunktion F1[DM1] implementiert, zu Zeitpunkten ab, zu denen diese Bedingungen erfüllt sind.

Ggf. kann eine Sensorvorrichtung eine erste Trigger-Schaltung umfassen. Die erste Trigger-Schaltung signalisiert zu Zeitpunkten, an dem die Bedingungen $F1[Cs(t)]=0$ und $F1[Cs90(t)]=0$ und $F1[Cs(t) \times Cs90(t)]=0$ und $F1[1]=\beta_1$ erfüllt sind, der ersten Halteschaltung eine Abtastung des Ergebnisses der ersten Filterfunktion F1[]. Hierbei ist $\beta_1$ ein reeller oder komplexer Wert. Die erste Halteschaltung wendet die Abtastung auf das erste demodulierte Signal DM1 an. Die erste Halteschaltung bildet durch diese Abtastung das erste Ausgangssignal out1.

Ggf. kann eine Sensorvorrichtung eine zweite Trigger-Schaltung umfassen. Die zweite Trigger-Schaltung signalisiert zu Zeitpunkten, an dem die Bedingungen $F2[Cs(t)]=0$ und $F2[Cs90(t)]=0$ und $F2[Cs(t) \times Cs90(t)]=0$ und $F2[1]=\beta_2$ erfüllt sind, der zweiten Halteschaltung eine Abtastung des Ergebnisses der zweiten Filterfunktion F2[]. Hierbei ist $\beta_2$ ein reeller oder komplexer Wert. Die zweite Halteschaltung wendet die Abtastung auf das zweite demodulierte Signal DM2 an. Die zweite Halteschaltung bildet durch diese Abtastung das zweite Ausgangssignal out2.

Abschließend erfolgt wieder ein erster Vergleich des Werts des zweiten Ausgangssignals out2 oder des Werts eines daraus abgeleiteten Signals mit einem Erwartungswertintervall und schließen auf einen Fehler, wenn der Wert des zweiten Ausgangssignals out2 bzw. des daraus abgeleiteten Signals außerhalb des Erwartungswertintervalls liegt. Hier verweisen wir auf die Ausführungen in den vorausgehenden Abschnitten.

Auch hier ist es wieder sinnvoll das Sensorelement und das Referenzelement in den geprüften Signalpfad mit einzubeziehen. In diesem Fall erfolgt auch hier ein Bereitstellen eines Referenzelements RW, das ein Referenzsignal Rs liefert. Das Sensorsystem verarbeitet das Referenzsignal Rs in dem Referenzsignalpfad. Der Referenzsignalpfad ist wieder gleich dem Signalpfad zur Verarbeitung des Eingangssignals Si gestaltet. An dieser Stelle verweist die hier vorgelegte Schrift auf das bereits beschriebene Verfahren. Wieder beginnt der Referenzsignalpfad mit dem Referenzsignal Rs und endet wieder mit dem zweiten Ausgangssignal out2.

Wie zuvor, sind der Referenzsignalpfad am Beginn des Referenzsignalpfads beim Referenzsignal Rs und der Signalpfad am Beginn des Signalpfads beim Eingangssignal Si verschieden.

Wie zuvor, umfasst der Referenzsignalpfad an der ersten Stelle des Referenzsignalpfads den Verstärker DV mit dem Eingang und dem Ausgang. Somit ist auch hier, wie oben, der Verstärker DV Teil des Referenzsignalpfads an der ersten Stelle im Referenzsignalpfad und gleichzeitig Teil des Signalpfads an der ersten Stelle des Signalpfads.

Wie zuvor weist der Referenzsignalpfad eine sechsten Stelle im Referenzpfad zwischen Referenzsignal Rs am Beginn des Referenzpfads und Eingang des Verstärkers DV an der ersten Stelle im Referenzpfad auf. Wiederum weist der Signalpfad eine sechste Stelle im Signalpfad zwischen Eingangssignal Si am Beginn des Signalpfads und Eingang des Verstärkers DV an der ersten Stelle im Signalpfad auf, die Signalpfad und Referenzpfad gemeinsam ist. Wieder umfassen der Referenzsignalpfad und der Signalpfad an dieser gemeinsamen sechsten Stelle im Referenzpfad und Signalpfad ein dem Signalpfad und dem Referenzpfad einen gemeinsamen Umschalter DS mit einem ersten Eingang und einem zweiten Eingang.

Der dem Signalpfad und dem Referenzsignalpfad gemeinsame Umschalter DS wählt seinen aktiven Eingang unter diesen beiden Eingängen, wie oben beschrieben, in Abhängigkeit von einem zweiten Chopper-Signal Cs2 zwischen seinem ersten Eingang und seinem zweiten Eingang aus.

Der Signalpfad umfasst dabei wieder den ersten Eingang des Umschalters DS und den zweiten Eingang des Umschalters DS nicht. Der Referenzpfad umfasst dementsprechend den zweiten Eingang des Umschalters DS und den ersten Eingang des Umschalters DS nicht.

Der gemeinsame Umschalter DS wählt seinen aktiven in Abhängigkeit von einem zweiten Chopper-Signal Cs2 gewählten Eingang aus und schaltet den Wert an diesem aktiven Eingang des gemeinsamen Umschalters DS an den Ausgang des gemeinsamen Umschalters DS durch.

Der Referenzpfad und der Signalpfad sind in dem Abschnitt vom Ausgang des gemeinsamen Umschalters DS an der sechsten Stelle im Referenzsignalpfad und Signalpfad und dem Eingang des Verstärkers DV an der ersten Stelle im Referenzsignalpfad und Signalpfad identisch.

Die erste Filterung mit der ersten Filterfunktion F1[], also beispielsweise der erste Tiefpassfilter LP1 ist nicht Teil des Referenzpfads.

Ein drittes Filtern des dritten, demodulierten Signals DM3 oder eines daraus abgeleiteten Signals mittels einer dritten Filterfunktion F3[], beispielsweise in einem dritten Tiefpassfilter LP3, erzeugt ein drittes Ausgangssignal out3.

Das Sensorsystem muss eine saubere Trennung i) des Messsignalanteils des Sensorelements und ii) des Differenzsignalanteils aus der Differenz zwischen dem Messsignalanteil des Sensorelements WB und dem Referenzsignalanteil des Referenzelements RW und iii) des Testsignalanteils zu gewährleisten. Hierfür müssen die erste Filterfunktion F1[] des beispielhaften ersten Tiefpassfilters LP1 und die zweite Filterfunktion F2[] des beispielhaften zweiten Tiefpassfilters LP2 und die dritte Filterfunktion des beispielhaften dritten Tiefpassfilters LP3 wieder bestimmte Bedingungen erfüllen.

Daher wählt die Konstruktion des Sensorsystems die erste Filterfunktion F1[] so, dass im Wesentlichen die folgenden Bedingungen erfüllt sind:

$$F1[Cs(t)]=0$$

$$F1[Cs2(t)]=0$$

$$F1[Cs90(t)]=0$$

$$F1[Cs(t)\times Cs2(t)]=0$$

$$F1[Cs(t)\times Cs90(t)]=0$$

$$F1[Cs2(t)\times Cs90(t)]=0$$

$$F1[Cs(t)\times Cs2(t)\times Cs90(t)]=0$$

$$F1[1]=\beta$$

Hierbei ist $\beta_1$ ein reeller oder komplexer Wert. Wie zuvor erwähnt tastet bevorzugt eine Abtastschaltung (Englisch Sample&Hold) bevorzugt den Ausgang des beispielhaften ersten Tiefpassfilters LP1 zu genau solchen Zeitpunkten ab, zu denen diese Bedingungen erfüllt sind. Dabei sieht die technische Lehre dieser Schrift von den unvermeidlichen leichten Abweichungen durch Rauschen und Fertigungsfehler etc. ab.

Auch wählt die Konstruktion des Sensorsystems die zweite Filterfunktion F2[] so, dass im Wesentlichen die folgenden Bedingungen erfüllt sind:

$$F2[Cs(t)]=0$$

$$F2[Cs2(t)]=0$$

$$F2[Cs90(t)]=0$$

$$F2[Cs(t)\times Cs2(t)]=0$$

$$F2[Cs(t)\times Cs90(t)]=0$$

$$F2[Cs2(t)\times Cs90(t)]=0$$

$$F2[Cs(t)\times Cs2(t)\times Cs90(t)]=0$$

$$F2[1]=\beta_2$$

Hierbei ist $\beta_2$ ein reeller oder komplexer Wert. Wie zuvor erwähnt, tastet bevorzugt eine Abtastschaltung (Englisch Sample&Hold) bevorzugt den Ausgang des beispielhaften zweiten Tiefpassfilters LP2 zu genau solchen Zeitpunkten ab, zu denen diese Bedingungen erfüllt sind. Die technische Lehre dieser Schrift sieht dabei von den unvermeidlichen leichten Abweichungen durch Rauschen und Fertigungsfehler etc. ab.

In gleicher Weise wählt die Konstruktion des Sensorsystems die dritte Filterfunktion F3[] so , dass im Wesentlichen die folgenden Bedingungen erfüllt:

$$F3[Cs(t)]=0$$

$$F3[Cs2(t)]=0$$

$$F3[Cs90(t)]=0$$

$$F3[Cs(t)\times Cs2(t)]=0$$

$$F3[Cs(t)\times Cs90(t)]=0$$

$$F3[Cs2(t)\times Cs90(t)]=0$$

$$F3[Cs(t)\times Cs2(t)\times Cs90(t)]=0$$

$$F3[1]=\beta_3$$

Dabei ist $\beta_3$ ein reeller oder komplexer Wert. Wie zuvor erwähnt, tastet bevorzugt eine Abtastschaltung (Englisch Sample&Hold) bevorzugt der Ausgang des beispielhaften dritten Tiefpassfilters LP3 zu genau solchen Zeitpunkten ab, zu denen diese Bedingungen erfüllt sind. Die technische Lehre dieser Schrift sieht dabei von den unvermeidlichen leichten Abweichungen durch Rauschen und Fertigungsfehler etc. ab.

Um nun einen Defekt des Referenzelements oder des Sensorelements zu detektieren, erfolgt bevorzugt ein zweiter Vergleich des Werts des dritten Ausgangssignals out3 oder des Werts eines daraus abgeleiteten Signals mit einem dritten Erwartungswertintervall. Des Weiteren folgt bevorzugt das Schließen auf einen Fehler, wenn der Wert des dritten Ausgangssignals out3 bzw. der Wert des daraus abgeleiteten Signals außerhalb des dritten Erwartungswertintervalls liegt. Ein dritter Komparator kann beispielsweise den Wert des dritten Ausgangssignals out3 mit einem dritten Schwellwert vergleichen. Ein vierter Komparator kann beispielsweise den Wert des dritten Ausgangssignals out3 mit einem vierten Schwellwert vergleichen. Beispielsweise der dritte Komparator und ein vierter Komparator oder ein Signalprozessor oder dergleichen können den zweiten Vergleich durchführen.

Um nun solche Verfahren durchführen zu können, sind besondere Drucksensoren bzw. Sensoren vorteilhaft.

Es wird somit ein Drucksensor zur Verwendung in einem Verfahren nach einem oder mehreren der zuvor beschriebenen Verfahren vorgeschlagen. Der vorgeschlagene Drucksensor umfasst eine Wheatstone-Brücke mit vier piezoresistiven Widerständen R1, R2, R3, R4 und eine Referenz-Wheatstone-Brücke mit vier piezoresistiven Referenzwiderständen R5, R6, R7, R8. Bevorzugt sind die Referenzwiderstände R5, R6, R7, R8 der Referenz-Wheatstone-Brücke RW in gleicher Weise wie die Widerstände R1, R2, R3, R4 der Wheatstone-Brücke WB angeordnet. Um eine gute thermische Kopplung und damit eine bessere Gleichheit des Rauschens zu erreichen, ist der Drucksensor mit der Wheatstone-Brücke WB als Sensorelement und der Referenz-Wheatstone-Brücke RW als Referenzelement auf einem monolithischen Kristall gemeinsam angeordnet. Hierdurch sind sie bei der Fertigung und im Betrieb in etwa den gleichen Einflüssen ausgesetzt. Die gleiche Ausrichtung der Bauelemente und die gleiche Anordnung der Bauelemente zueinander maximiert diese Gleichheit.

Der Drucksensor umfasst mindestens eine erste Kavität, die auf zumindest einer Seite durch eine erste Membran verschlossen ist und von einem durchgängigen Wall umgeben ist. Die der ersten Membran gegenüberliegende Kavitätsfläche der ersten Kavität kann im Fall von Differenzdrucksensoren ganz oder teilweise geöffnet sein, um einem Medium Zutritt zu gewähren, oder im Fall von Absolutdrucksensoren geschlossen sein. Die piezoresistiven Widerstände R1, R2, R3, R4 der Wheatstone-Brücke WB sind bevorzugt zumindest teilweise auf der ersten Membran angeordnet. In diesem Zusammenhang verweist die hier vorgelegte Schrift beispielhaft auf die Schutzrechte EP 2 524 389 B1,EP 2 524 390 B1, EP 2 524 198 B1, EP 2 523 896 B1 und EP 2 523 895 B1.

Für das Referenzsensorelement gibt es nun mehrere Möglichkeiten:

A) Das Referenzsensorelement kann so gestaltet sein, dass es ein Referenzsignal Rs liefert, das gleich dem Eingangssignal Si sein sollte. Dabei sind das Referenzsignal Rs und das Eingangssignal Si von dem Wert der physikalischen Größe, die das jeweilige Ausgangssignal des Sensorelements und das Ausgangssignal des Referenzelements beeinflusst, in gleicher Weise abhängig. Somit hat dann eine Änderung des Werts dieser physikalischen Größe eine wertgleiche Änderung des Eingangssignals Si und des Referenzsignals Rs zur Folge. In dem hier diskutierten Beispiel eines Drucksensors ist diese beispielhafte physikalische Größe der Druck.

B) Das Referenzsensorelement kann so gestaltet sein, dass es ein Referenzsignal Rs liefert. Dieses Referenzsignal Rs sollte in vorbekannter Weise abweichend von dem Eingangssignal Si sein. Das Eingangssignal Si liefert dabei das Sensorelement. Dabei sind das Referenzsignal Rs und das Eingangssignal Si von dem Wert der physikalischen Größe, die das jeweilige Ausgangssignal des Sensorelements und das Ausgangssignal des Referenzelements beeinflusst, in ungleicher Weise abhängig. Somit hat eine Änderung des Werts dieser physikalischen Größe eine nicht wertgleiche Änderung des Eingangssignals Si und eine nicht verschwindende Änderung des Referenzsignals Rs zur Folge. In dem hier diskutierten Beispiel eines Drucksensors ist diese beispielhafte physikalische Größe typischerweise der Druck.

C) Das Referenzsensorelement kann so gestaltet sein, dass es ein Referenzsignal Rs liefert, das in vorbekannter Weise abweichend dem Eingangssignal Si, nämlich im Wesentlichen konstant, sein sollte. Dabei ist das Referenzsignal Rs hier nun bevorzugt im Wesentlichen nicht von dem Wert der physikalischen Größe, die das jeweilige Ausgangssignal des Sensorelements beeinflusst, abhängig. Demgegenüber ist das Eingangssignal Si weiterhin von dem Wert der physikalischen Größe, die das jeweilige Ausgangssignal des Sensorelements beeinflusst, abhängig, sodass eine Änderung des Werts dieser physikalischen Größe eine Änderung des Eingangssignals Si und keine oder nur eine vernachlässigbare Änderung des Referenzsignals Rs zur Folge hat. In dem hier diskutierten Beispiel eines Drucksensors ist diese beispielhafte physikalische Größe der Druck.

Fall A) Referenzelement und Sensorelement sind gleich ausgeführt.

In dem Drucksensorbeispiel des Falls A umfasst der Drucksensor eine Referenzkavität, die auf zumindest einer Seite durch eine zweite Membran verschlossen ist und von einem durchgängigen Wall umgeben ist. Die zweite Membran ist bevorzugt gleich der ersten Membran ausgeführt. Bevorzugt sind die Dimensionen und die Form der ersten Membran gleich den Dimensionen und der Form der zweiten Membran. Bevorzugt ist die Referenzkavität in der gleichen Weise ausgeführt wie die erste Kavität. Die der zweiten Membran gegenüberliegende Kavitätsfläche der Referenzkavität kann ganz oder teilweise geöffnet sein, um einem Medium Zutritt zu gewähren, oder geschlossen sein. Bevorzugt ist diese Kavitätsfläche der Referenzkavität geschlossen, wenn die entsprechende Kavitätsfläche der ersten Kavität geschlossen ist. Bevorzugt ist diese Kavitätsfläche der Referenzkavität geöffnet, wenn die entsprechende Kavitätsfläche der ersten Kavität geöffnet ist, wobei dann die Öffnungen der entsprechenden Kavitätsflächen in gleicher Weise ausgeführt sind. Im Falle von geschlossenen Kavitäten sind die erste Kavität und die Referenzkavität bevorzugt mit gleichen Gasen mit gleichem Druck oder mit bevorzugt gleich gutem Vakuum gefüllt. Die piezoresistiven Referenzwiderstände R5, R6, R7, R8 der beispielhaften Referenz-Wheatstone-Brücke RW sind bevorzugt zumindest teilweise auf der zweiten Membran über der Referenzkavität angeordnet. Im optimalen Fall stimmen das Verhalten der ersten Wheatstone-Brücke WB im Zusammenwirken mit der ersten Membran und der ersten Kavität mit dem Verhalten der Referenz-Wheatstone-Brücke RW im Zusammenwirken mit der zweiten Membran und der Referenzkavität überein, sodass sich am dritten Ausgangssignal out3 im Wesentlichen kein von Null verschiedenes Signal außer Rauschen messen lässt. Ist am dritten Ausgang out3 ein von Null verschiedenes Signal zu messen, das außerhalb des dritten Erwartungswertintervalls liegt, so liegt ein Fehler vor.

Fall B) Referenzelement und Sensorelement sind ungleich ausgeführt und das Referenzelement ist gegenüber der physikalischen Größe anders empfindlich als das Sensorelement.

In diesem Drucksensorbeispiel des Falls B umfasst der Drucksensor eine Referenzkavität, die auf zumindest einer Seite durch eine zweite Membran verschlossen ist und von einem durchgängigen Wall umgeben ist. Der durch die Referenzkavität und die zweite Membran erzielte mechanische

Aufbau weicht in diesem Fall bevorzugt von dem mechanischen Aufbau, den die erste Kavität und die erste Membran erzielen, ab. Die zweite Membran kann beispielsweise anders als die erste Membran ausgeführt sein. Sie kann beispielsweise dicker, dünner, größer, kleiner, anders geformt oder anders strukturiert sein. Die Referenzkavität kann anders als die erste Kavität ausgeformt sein. Die Referenzkavität kann beispielsweise kleiner oder größer, tiefer oder flacher oder anders geformt oder anders gefüllt sein. Die der zweiten Membran gegenüberliegende Kavitätsfläche der Referenzkavität kann anders ausgeformt sein als die der ersten Membran gegenüberliegende Kavitätsfläche der ersten Kavität. Sie kann geschlossen sein, während die andere geöffnet ist oder sie kann geöffnet sein, während die andere geschlossen ist. Sind beide geöffnet, können Form, Lage der Öffnung innerhalb der jeweiligen Kavität und Größe voneinander abweichen. Im Falle von geschlossenen Kavitäten können diese mit ungleichen Gasen und/oder mit ungleichem Druck, wobei diese Schrift unter niedrigem Druck auch ein Vakuum versteht, gefüllt sein. Natürlich ist es auch denkbar, dass die piezoresistiven Widerstände R1, R2, R3, R4 der Wheatstone-Brücke WB anders ausgeführt sein können als die piezoresistiven Referenzwiderstände R5, R6, R7, R8 der Referenz-Wheatstone-Brücke RW. Diese andere Ausführung kann die Widerstandswerte, die Größe, Dimensionen, Ausführungen, Orientierungen, Dotierstoffe etc. betreffen. Das dritte Ausgangssignal out3 und das erste Ausgangssignal out1 bilden dabei zusammen einen Ausgangssignalvektor, dessen Ausgangssignalvektorwert sich nur in vorbestimmten Bereichen befinden darf. Es ist daher möglich, entweder den zweidimensionalen Ausgangssignalvektorwert dieses zweidimensionalen Vektors auf Übereinstimmung mit einem zweidimensionalen Erwartungswertbereich zu prüfen, oder aus diesem zweidimensionalen Ausgangssignalvektorwert die beiden Werte zweier verschiedener, das Sensorelement und das Referenzelement unterschiedlich beeinflussender physikalischer Parameter zu extrahieren. Verlässt der zweidimensionale Wert des zweidimensionalen Ausgangsvektors den zweidimensionalen Erwartungswertbereich, so kann das Sensorsystem oder ein übergeordnetes Rechnersystem auf einen Fehler schließen.

Fall C) Referenzelement und Sensorelement sind ungleich ausgeführt und das Referenzelement ist gegenüber der physikalischen Größe nicht empfindlich.

Im Fall C umfasst der Drucksensor bevorzugt keine Referenzkavität. Dadurch weicht der mechanische Aufbau des Referenzelements in Form der Referenz-Wheatstone-Brücke RW massiv von dem mechanischen Aufbau des Sensorelements in Form der Wheatstone-Brücke WB ab. Der Fall C ist im Idealfall ein Extremfall des Falls B. In diesem Extremfall weist dann typischerweise das Referenzelement in diesem Fall keine Empfindlichkeit gegenüber der physikalischen Größe mehr auf. Das Referenzelement hat hierbei die Form der Referenz-Wheatstone-Brücke RW. Die physikalische Größe ist dabei die physikalische Größe, die das Sensorsystem mittels des Sensorelements, hier in Form der Wheatstone-Brücke WB, erfassen soll. Das Referenzsensorelement RW erfasst dann typischerweise parasitäre Parameter, wie beispielsweise Druck oder Feuchtigkeit. Die Auswertung erfolgt analog der Auswertung im Fall B.

Bevorzugt sind in diesem beispielhaften Fall eines mikromechanischen Drucksensors die piezoresistiven Referenzwiderstände R5, R6, R7, R8 so angeordnet, dass eine Auslenkung der ersten Membran die Referenzwiderstände R5, R6, R7, R8 der Referenz-Wheatstone-Brücke RW nicht beeinflusst. Bevorzugt befinden sich die Referenzwiderstände R5, R6, R7, R8 zu diesem Zweck nicht auf der ersten Membran.

Der erste Widerstand R1 der Wheatstone-Brücke WB gleicht einem fünften Widerstand R5 der Referenz-Wheatstone-Brücke WB dadurch, dass er in der gleichen Weise konstruiert ist.

Der zweite Widerstand R2 der Wheatstone-Brücke WB gleicht einem sechsten Widerstand R6 der Referenz-Wheatstone-Brücke WB dadurch, dass er in der gleichen Weise konstruiert ist.

Der dritte Widerstand R3 der Wheatstone-Brücke WB gleicht einem siebten Widerstand R7 der Referenz-Wheatstone-Brücke WB dadurch, dass er in der gleichen Weise konstruiert ist.

Der vierte Widerstand R4 der Wheatstone-Brücke WB gleicht einem achten Widerstand R8 der Referenz-Wheatstone-Brücke WB dadurch, dass er in der gleichen Weise konstruiert ist.

Dieses Referenzelement in diesem Beispiel in Form einer Referenz-Wheatstone-Brücke RW nutzt das Sensorsystem dann bevorzugt als Referenzrauschquelle für die nachfolgende Signalverarbeitung des Eingangssignals Si aus dem Sensorelement, hier der Wheatstone-Brücke WB.

Diese Schrift schlägt somit einen Sensor zur Verwendung in einem der zuvor vorgestellten Verfahren vor. Der Sensor kann insbesondere ein Drucksensor sein. Der vorgeschlagene Sensor weist einen ersten Widerstand R1 mit einem ersten Anschluss und einem zweiten Anschluss auf. Der vorgeschlagene Sensor weist einen zweiten Widerstand R2 mit einem ersten Anschluss und einem zweiten Anschluss auf. Der vorgeschlagene Sensor weist einen dritten Widerstand R3 mit einem ersten Anschluss und einem zweiten Anschluss auf. Der vorgeschlagene Sensor weist einen vierten Widerstand R4 mit einem ersten Anschluss und einem zweiten Anschluss auf. Um nun eine erste differentielle Modulationsspannung $V_{mod1}$ erzeugen zu können, weist der Sensor in dieser Ausführungsvariante eine erste Spannungsquelle V1 mit einem ersten Anschluss und einem zweiten Anschluss und eine zweite Spannungsquelle V2 mit einem ersten Anschluss und einem zweiten Anschluss auf. Der erste Anschluss der ersten Spannungsquelle V1 ist mit einer ersten Versorgungsspannungsleitung VDD verbunden. Der zweite Anschluss der ersten Spannungsquelle V1 ist mit dem ersten Anschluss des ersten Widerstands R1 verbunden. Der zweite Anschluss des ersten Widerstands R1 ist mit dem ersten Anschluss des zweiten Widerstands R2 verbunden. Der zweite Anschluss des zweiten Widerstands R2 ist mit einer zweiten Versorgungsspannungsleitung GND verbunden. Der erste Anschluss der zweiten Spannungsquelle V2 ist mit der ersten Versorgungsspannungsleitung VDD verbunden. Der zweite Anschluss der zweiten Spannungsquelle V2 ist mit dem ersten Anschluss des dritten Widerstands R3 verbunden. Der zweite Anschluss des dritten Widerstands R3 ist mit dem ersten Anschluss des vierten Widerstands R4 verbunden. Der zweite Anschluss des vierten Widerstands R4 ist mit der zweiten Versorgungsspannungsleitung GND verbunden. Die erste Spannung der ersten Spannungsquelle V1 hängt von dem Testsignal TSS ab. Die zweite Spannung der zweiten Spannungsquelle V2 hängt von dem Testsignal TSS in umgekehrte Weise wie die erste Spannung der ersten Spannungsquelle V1 ab.

Statt der Einspeisung eines Testsignals über Spannungsquellen V1, V2, V1b, V2b kann die Einspeisung auch über entsprechende Stromquellenpaare erfolgen, wobei dann das Sensorsystem die Wheatstone-Brücke WB und die Referenz-Wheatstone-Brücke RW nicht aus mittels Spannungsquellenpaaren [V1, V2], [V1b, V2b], sondern aus mittels Stromquellenpaaren erregen muss. Der Wheatstone-Brücke WS ist dabei ein erstes Stromquellenpaar zugeordnet. Der Referenz-Wheatstone-Brücke RW ist dabei ein zweites Stromquellenpaar zugeordnet. Jedes Stromquellenpaar dieser Stromquellenpaare besteht dann aus jeweils zwei Stromquellen. Von den Stromquellen eines solchen Stromquellenpaares speist eine erste Stromquelle dieses Stromquellenpaares einen ersten Strom in einen ersten Zweig der Wheatstone-Brücke WB bzw. der Referenz-Wheatstone-Brücke RW je nach Zuordnung ein. Von den Stromquellen dieses Stromquellenpaares speist die zweite Stromquelle dieses Stromquellenpaares einen zweiten Strom in den zweiten Zweig der Wheatstone-Brücke WB bzw. der Referenz-Wheatstone-Brücke RW je nach Zuordnung ein. Der erste Strom und der zweite Strom hängen dabei vom Testsignal TSS mit unterschiedlichem Vorzeichen ab. Insgesamt benötigt das Sensorsystem dann also vier Stromquellen, die die Konstruktion des Sensorsystems bevorzugt wieder gleich (englisch: matchend) ausführt. Hierzu umfasst diese Schrift keine Zeichnung, weil dem Fachmann diese Möglichkeit offensichtlich ist.

Statt der Einspeisung des Testsignalanteils in das Eingangssignal Si durch Spannungs- oder Stromquellen ist auch die Modulation des Werts der Widerstände R1, R2, R3, R4 der Wheatstone-Brücke WB und der Referenzwiderstände R5, R6, R7, R8 der Referenz-Wheatstone-Brücke RW möglich. Hierzu schlägt die hier vorgelegte Schrift hier als weitere Ausführungsvariante einen Sensor, insbesondere einen Drucksensor, vor, der typischerweise zur Verwendung in einem Verfahren nach einem oder mehreren der zuvor vorgestellten Verfahren bestimmt ist. Der Sensor umfasst dann einen ersten Widerstand R1 mit einem ersten Anschluss und einem zweiten Anschluss und einen zweiten Widerstand R2 mit einem ersten Anschluss und einem zweiten Anschluss und einen dritten Widerstand R3 mit einem ersten Anschluss und einem zweiten Anschluss und einen vierten Widerstand R4 mit einem ersten Anschluss und einem zweiten Anschluss. Des Weiteren umfasst der Sensor einen ersten variablen Widerstand RV1 mit einem ersten Anschluss und einem zweiten Anschluss und einen zweiten variablen Widerstand RV2 mit einem ersten Anschluss und einem zweiten Anschluss.

Der erste Anschluss des ersten variablen Widerstands RV1 ist mit der ersten Versorgungsspannungsleitung VDD verbunden. Der zweite Anschluss des ersten variablen Widerstands RV1 ist mit dem ersten Anschluss des ersten Widerstands R1 verbunden. Der zweite Anschluss des ersten Widerstands R1 ist mit dem ersten Anschluss des zweiten Widerstands R2 verbunden. Der zweite Anschluss des zweiten Widerstands R2 ist mit einer zweiten Versorgungsspannungsleitung GND verbunden. Der erste Anschluss des zweiten variablen Widerstands RV2 ist mit der ersten Versorgungsspannungsleitung VDD verbunden. Der zweite Anschluss des zweiten variablen Widerstands RV2 ist mit dem ersten Anschluss des dritten Widerstands R3 verbunden. Der zweite Anschluss des dritten Widerstands R3 ist mit dem ersten Anschluss des vierten Widerstands R4 verbunden. Der zweite Anschluss des vierten Widerstands R4 ist mit der zweiten Versorgungsspannungsleitung GND verbunden. Der Widerstandswert des ersten variablen Widerstands RV1 hängt von einem Testsignal TSS ab und der Widerstandswert des zweiten variablen Widerstands RV2 hängt von dem Testsignal TSS in umgekehrter Weise wie der Widerstandswert des ersten variablen Widerstands RV1 ab. Bevorzugt führt die Konstruktion des Sensorsystems den ersten variablen Widerstand RV1 und den zweiten variablen Widerstand RV2 gleich (englisch: matchend) aus.

**Vorteil**

Solche Verfahren der folgenden Figuren ermöglichen zumindest in einigen Realisierungen die Überprüfung des Signalpfads während des Betriebs. Die Vorteile sind hierauf aber nicht beschränkt.

**Beschreibung der Figuren**

Die Figuren stellen beispielhafte Ausführungen der Vorschläge dieser Schrift dar. Sie sind schematisch und vereinfacht dargestellt.

Figur 1

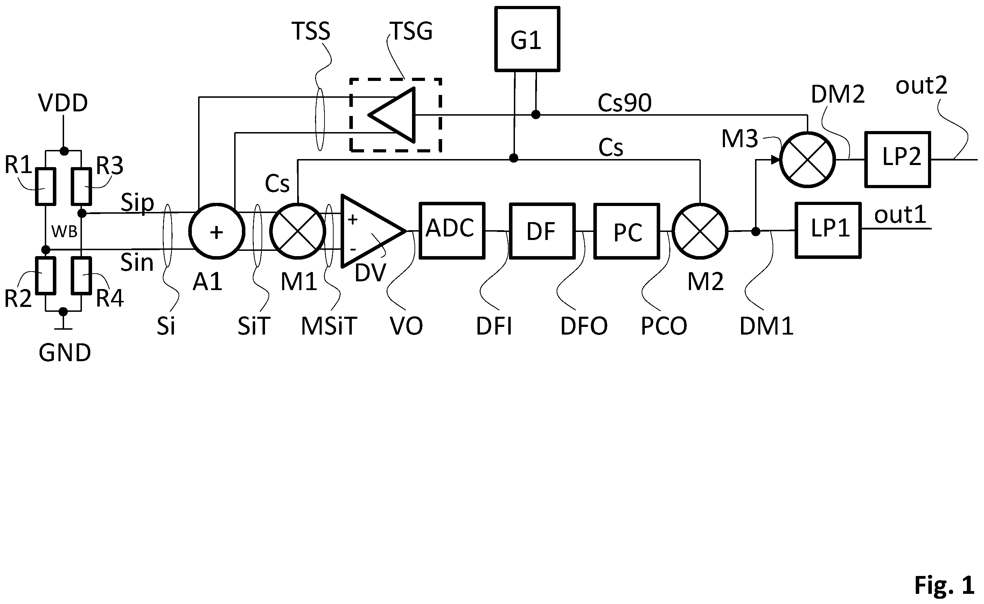

Figur 1 zeigt eine einfache, beispielhafte Ausführung der Erfindung. Als beispielhafter Sensor mit einem differentiellen Ausgang ist eine Wheatstone-Brücke WB gewählt. Die beispielhafte Wheatstone-Brücke WB umfasst einen ersten Widerstand R1, einen zweiten Widerstand R2, einen dritten Widerstand R3 und einen vierten Widerstand R4. Bei Verwendung in einem piezoresistiven Drucksensor sind beispielsweise der erste Widerstand R1 ein piezoresistiver erster Widerstand R1 und der zweite Widerstand R2 ein piezoresistiver zweiter Widerstand R2 und der dritte Widerstand R3 ein piezoresistiver dritter Widerstand R3 und der vierte Widerstand R4 ein piezoresistiver vierter Widerstand R4. Der erste Widerstand R1 ist mit dem zweiten Widerstand R2 zwischen der ersten Versorgungsspannungsleitung VDD und der zweiten Versorgungsspannungsleitung GND in Serie geschaltet. Der dritte Widerstand R3 ist mit dem vierten Widerstand R4 zwischen der ersten Versorgungsspannungsleitung VDD und der zweiten Versorgungsspannungsleitung GND ebenfalls in Serie geschaltet. Das Sensorsystem betreibt beispielhaft die Wheatstone-Brücke WB mit der Versorgungsspannung zwischen der ersten Versorgungsspannungsleitung VDD und der zweiten Versorgungsspannungsleitung GND. Die Wheatstone-Brücke WB ist dementsprechend mit einem ersten Anschluss mit der Versorgungsspannungsleitung VDD verbunden und mit einem zweiten Anschluss mit der zweiten Versorgungsspannungsleitung GND verbunden. Der Knoten zwischen dem ersten Widerstand R1 und dem zweiten Widerstand R2 bildet beispielhaft ein negative Eingangssignal Sin des differentiellen Eingangssignals Si. Der Knoten zwischen dem dritten Widerstand R3 und dem vierten Widerstand R4 bildet beispielhaft ein positives Eingangssignal Sip des differentiellen Eingangssignals Si.

Der Einsatz von Wheatstone-Brücken ist von vielen Sensorsystemen zur Wandlung des betreffenden physikalischen Parameters in ein Differenzspannungssignal zwischen einem positiven Eingangssignal Sip und einem negativen Eingangssignal Sin bekannt. Beispielsweise kann es sich bei der Wheatstone-Brücke WB um eine solche Brücke aus piezoresistiven Widerständen R1, R2, R3, R4 der Sensorelemente eines piezoresistiven mikromechanischen Drucksensors oder dergleichen handeln.

Das Signalpaar aus positivem Eingangssignal Sip und negativem Eingangssignal Sin bildet das differentielle Eingangssignal Si. In dem Beispiel der Figur 1 addiert ein erster Addierer A1 ein differentielles Testsignal TSS zu dem differentiellen Eingangssignal Si und bildet so das differentielle Eingangssignal mit Testsignalanteil SiT.

Der erste Multiplizierer M1 multipliziert das differentielle Eingangssignal mit Testsignalanteil SiT mit einem Chopper-Signal Cs und bildet so das differentielle, multiplizierte Eingangssignal mit Testsignalanteil MSiT. Bevorzugt ist das Chopper-Signal Cs ein digitales Signal mit zwei logischen Werten, hier beispielhaft mit 0 und 1 belegt. Beispielsweise kann eine Umschaltvorrichtung den ersten Multiplizierer M1 bilden. Die Konstruktion bildet die Funktion der Umschaltvorrichtung dann beispielsweise wie folgt:

A) Bei einer logischen 0 als Wert des Chopper-Signals Cs entspricht das differentielle, multiplizierte Eingangssignal mit Testsignalanteil MSiT dem differentiellen Eingangssignal mit Testsignalanteil SiT,

B) Bei einer logischen 1 als Wert des Chopper-Signals Cs entspricht das differentielle, multiplizierte Eingangssignal mit Testsignalanteil MSiT dem differentiellen Eingangssignal mit Testsignalanteil SiT mit vertauschten Leitungen.

Ein Differenzverstärker DV verstärkt das differentielle, multiplizierte Eingangssignal mit Testsignalanteil MSiT zu einem Verstärkerausgangssignal VO.

Ein Analog-zu-Digital-Wandler ADC wandelt das Verstärkerausgangssignal VO in ein Eingangssignal DFI eines digitalen Filters DF um. Dieses Eingangssignal DFI des digitalen Filters DF ist typischerweise ein digitales Signal von Abtastwerten des Verstärkerausgangssignals VO aus dem Analog-zu-Digital-Wandler ADC.

Der digitale Filter DF filtert das Eingangssignal DFI des digitalen Filters DF zu einem Ausgangssignal DFO des digitalen Filters DF. Dabei unterdrückt der digitale Filter ggf. vorhandene Signalanteile, die ggf. auf Störfrequenzen liegen.

Typischerweise handelt es sich um einen Dezimationsfilter für die durch die Abtastung mittels des Analog-zu-Digital-Wandlers ADC hinzugefügten Wandlungsartefakte.

Ein beispielhafter Phasen-Kompensator PC korrigiert die dabei entstehenden Phasenfehler und bildet ein Phasenkompensatorausgangssignal PCO.

Nach Verstärkung und Digitalisierung multipliziert ein zweiter Multiplizierer M2 das Phasenkompensatorausgangssignal PCO mit dem Chopper-Signal CS zu einem ersten demodulierten Signal DM1.

Ein erster Tiefpassfilter LP1 unterdrückt im ersten demodulierten Signal DM1 die Frequenzen, die den Frequenzen im Signalspektrum des Chopper-Signals Cs entsprechen. Der erste Tiefpassfilter LP1 unterdrückt auch die Frequenzen, die den Frequenzen im Signalspektrum eines orthogonalen Chopper-Signals Cs90 entsprechen. Des Weiteren unterdrückt der erste Tiefpassfilter LP1 die durch eine Multiplikation des Chopper-Signals Cs mit dem orthogonalen Chopper-Signal Cs90 ggf. entstehenden Mischfrequenzen. Der erste Tiefpassfilter LP1 unterdrückt diese Signalanteile bis auf einen Gleichanteil im ersten demodulierten Signal DM1. Der erste Tiefpassfilter LP1 bildet so ein erstes Ausgangssignal out1, dessen Wert mit dem Wert des differentiellen Eingangssignals Si korrespondiert.

Ein dritter Multiplizierer M3 mischt das erste demodulierte Signal DM1 mit dem orthogonalen Chopper-Signal Cs90 zu einem zweiten demodulierten Signal DM2. Ein zweiter Tiefpassfilter LP2 unterdrückt im zweiten demodulierten Signal DM2 die Frequenzen, die den Frequenzen im Signalspektrum des Chopper-Signals Cs entsprechen. Der zweite Tiefpassfilter LP2 unterdrückt darüber hinaus die Frequenzen, die den Frequenzen im Signalspektrum des orthogonalen Chopper-Signals Cs90 entsprechen. Der zweite Tiefpassfilter LP2 unterdrückt außerdem die durch eine Multiplikation des Chopper-Signals Cs mit dem orthogonalen Chopper-Signal Cs90 ggf. entstehenden Mischfrequenzen. Der zweite Tiefpassfilter LP2 unterdrückt diese Frequenzen bis auf einen Gleichanteil im zweiten demodulierten Signal DM2. Der zweite Tiefpassfilter LP2 bildet so ein zweites Ausgangssignal out2.

In dem Beispiel der Figur 1 erzeugt ein Signalgenerator G1 das Chopper-Signal Cs und das orthogonale Chopper-Signal Cs90. Bevorzugt ist das Chopper-Signal Cs bandbreitenbegrenzt oder monofrequent. Bevorzugt ist das orthogonale Chopper-Signal Cs90 ebenfalls bandbreitenbegrenzt oder monofrequent. Bevorzugt ist das orthogonale Chopper-Signal Cs90 vom Chopper-Signal Cs verschieden. Der erste Tiefpassfilter LP1 weist eine erste Filtereigenschaft in Form einer ersten Filterfunktion F1[] auf, sodass gilt: out1=F1[DM1]. Der zweite Tiefpassfilter LP2 weist eine Filtereigenschaft in Form einer zweiten Filterfunktion F2[] auf, sodass gilt: out2=F2[DM2]. Typischerweise weisen der erste Tiefpassfilter LP1 und der zweite Tiefpassfilter LP2 eine ganz besonders bevorzugt gleiche Filtereigenschaft in Form einer gleichen Filterfunktion F[]=F1[]=F2[] auf.

Das Chopper-Signal CS und das orthogonale Chopper-Signal Cs90 sollen zueinander orthogonal bezüglich des ersten Filters LP1 und bezüglich des zweiten Filters LP2 sein. Das heißt, es soll zumindest zu bevorzugten Zeitpunkten gelten:

a)

$$F1[Cs(t) \times Cs90(t)]=0$$

b)

$$F2[Cs(t) \times Cs90(t)]=0$$

Hierbei soll Cs(t) den zeitlichen Verlauf der Werte des Chopper-Signals Cs darstellen und Cs90(t) den zeitlichen Verlauf der Werte des orthogonalen Chopper-Signals Cs90 darstellen

Darüber hinaus soll die erste Filterfunktion F1[] bevorzugt eine im Wesentlichen lineare Filterfunktion sein. D.h. es soll für eine Signalsumme aus einem beliebigen ersten Beispielsignal X1(t) und einem beliebigen zweiten Beispielsignal X2(t) und für eine reelle Zahl $\alpha$ gelten:

A)

$$F1[X1(t)+X2(t)]= F1[X1(t)]+F1[X2(t)]$$

B)

$$F1[\alpha \times X1(t)]=\alpha \times F1[X1]$$

Darüber hinaus soll die zweite Filterfunktion F2[] bevorzugt eine im Wesentlichen lineare Filterfunktion sein. D.h. es soll für eine Signalsumme aus einem beliebigen ersten Beispielsignal X1(t) und einem beliebigen zweiten Beispielsignal X2(t) und für eine reelle Zahl α gelten:

C)

$$F2[X1(t)+X2(t)]= F2[X1(t)]+F2[X2(t)]$$

D)

$$F2[\alpha \times X1(t)]=\alpha \times F2[X1]$$

Schließlich sollen die erste Filterfunktion F1[] und die zweite Filterfunktion F2[] jeweils eine Tiefpasseigenschaft haben. D.h. es soll gelten:
F1[1]=$\beta_1$ und F2[1]=$\beta_2$ mit $\beta_1$ als reeller, von Null verschiedener Konstante und $\beta_2$ als reeller, von null verschiedener Konstante.

Beispielsweise kann es sich bei dem Chopper-Signal Cs um ein monofrequentes PWM-Signal mit den Werten -1 und 1 und einem Tastgrad von 50% und einer Chopper-Signalfrequenz handeln. Bei dem orthogonalen Chopper-Signal Cs90 kann es sich dann beispielsweise um ein um +/-90° phasenverschobenes Signal mit den Werten -1 und 1 handeln und einem Tastgrad von 50% handeln. Alternativ kann es sich um ein monofrequentes PWM-Signal mit den Werten -1 und 1 handeln und einem Tastgrad von 50% und einer Signalfrequenz, die beispielsweise ein ganzzahliges mehrfaches der Chopper-Signalfrequenz beträgt. Es kann sich bei dem Chopper-Signal Cs auch um ein bandbegrenztes, nicht monofrequentes Signal handeln. Wichtig ist nur die Erfüllung der Orthogonalitätsbedingungen. Typischerweise sind das Chopper-Signal Cs periodisch und das orthogonale Chopper-Signal Cs90 periodisch. Ggf. ist es sinnvoll, den ersten Tiefpassfilter LP1 und den zweiten Tiefpassfilter LP2 mit jeweils einer Halteschaltung (englisch: sample & hold) an ihrem jeweiligen Ausgang zu versehen. In diesem Fall ist es sinnvoll, zu Zeiten, zu denen die Orthogonalitätsbedingungen a) und b) erfüllt sind, den Ausgang des ersten Tiefpassfilters LP1 mit einer ersten Halteschaltung dieser Halteschaltungen abzutasten. Die erste Halteschaltung gibt den so abgetasteten ersten Wert als Wert des ersten Ausgangssignals out1 bis zur nächsten Erfüllung der Orthogonalitätsbedingungen a) und b) aus. In dem besagten Fall ist es auch sinnvoll, zu Zeiten, zu denen die Orthogonalitätsbedingungen a) und b) erfüllt sind, den Ausgang des zweiten Tiefpassfilters LP2 mit einer zweiten Halteschaltung dieser Halteschaltungen abzutasten. Die zweite Halteschaltung gibt dann den so abgetasteten zweiten Wert als Wert des zweiten Ausgangssignals out2 bis zur nächsten Erfüllung der Orthogonalitätsbedingungen a) und b) aus.

In dem Beispiel der Figur 1 erzeugt ein Testsignalgenerator TSG, der auch Teil des Signalgenerators G1 sein kann, das Testsignal TSS aus dem orthogonalen Chopper-Signal Cs90. Der Testsignalgenerator TSG stellt die Amplitude dabei typischerweise entsprechend einer Vorgabe ein.

Die Konstruktion kann den digitalen Filter DF, die Phasenkompensation PC, den Signalgenerator G1, den Testsignalgenerator TSG, den zweiten Multiplizierer M2, den dritten Multiplizierer M3, den ersten Tiefpassfilter LP1 und den zweiten Tiefpassfilter LP2 beispielsweise auch mit Hilfe einer digitalen Schaltung oder mittels eines Signalprozessorsystems mit einer entsprechenden Programmierung realisieren.

Bevorzugt vergleicht ein Vergleichsmittel, beispielsweise ein erster Komparator im Zusammenwirken mit einem zweiten Komparator oder der besagte Signalprozessor, den Wert des zweiten Ausgangssignals mit einem Erwartungswertbereich, der durch einen ersten Erwartungswert und einen zweiten Erwartungswert begrenzt ist. Liegt der Wert des zweiten Ausgangssignals zwischen dem ersten Erwartungswert und dem zweiten Erwartungswert, also innerhalb des Erwartungswertbereichs, so arbeitet die Eingangsstufe umfassend den ersten Multiplizierer M1, den Differenzverstärker DV1, den Analog-zu-Digital-Wandler ADC, den digitale Filter DF, den Phasenkompensator PC und den zweiten Multiplizierer M2 vermutlich korrekt. Somit kann das Sensorsystem auf diese Weise eine Aussage über die vermutlich korrekte Funktion der Eingangsstufe treffen.

Figur 2

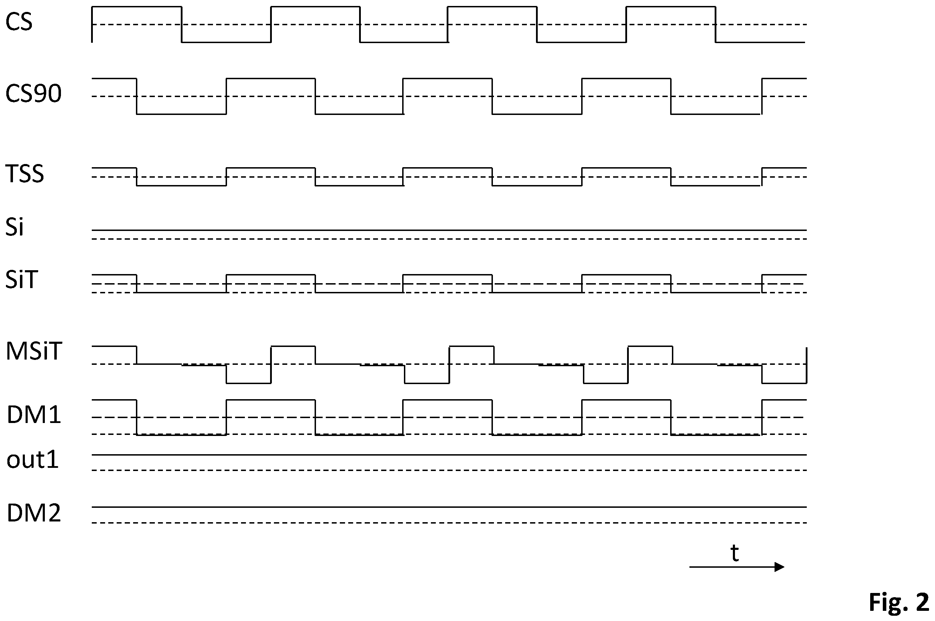

Figur 2 zeigt beispielhafte Signalformen für den Betrieb einer Vorrichtung gemäß Figur 1. Die Pegel sind willkürlich gewählt. Die mit kürzeren Strichen gestrichelte Linie soll die jeweilige Null-Line darstellen. Die mit längeren Strichen gestrichelte Linie soll die jeweilige Line des Mittelwerts darstellen.

Figur 3

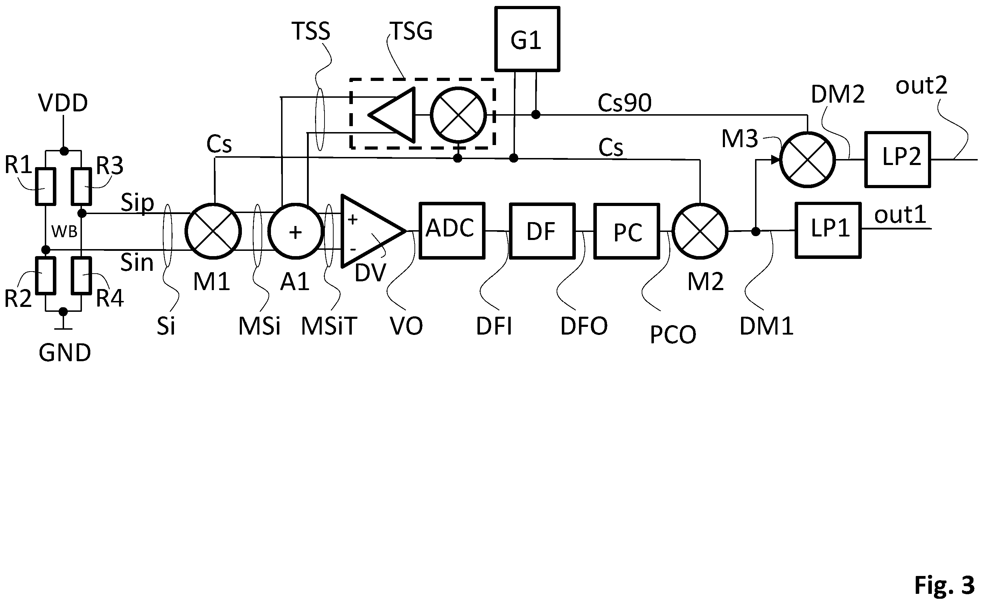

Die Figur 3 entspricht weitestgehend der Figur 1, wobei nun jedoch der erste Addierer A1 und der erste Multiplizierer M1 im Signalpfad vom Sensor zum ersten Ausgangssignal out1 die Reihenfolge getauscht haben. Dies hat den Vorteil, dass die Konstruktion des Sensorsystems den ersten Addierer A1 in der Regel in die Eingangsstufe des Differenzverstärkers DV leicht mitintegrieren kann. Dies hat jedoch den Nachteil, dass das Testsignal TSS den ersten Multiplizierer M1 nun nicht mehr mitprüft. Außerdem wird ein weiterer Multiplizierer innerhalb des Testsignalgenerators TSG notwendig, der das orthogonale Sendesignal Cs90 mit dem Sendesignal (Cs) multipliziert und zum Testsignal TSS aufbereitet.

Figur 4

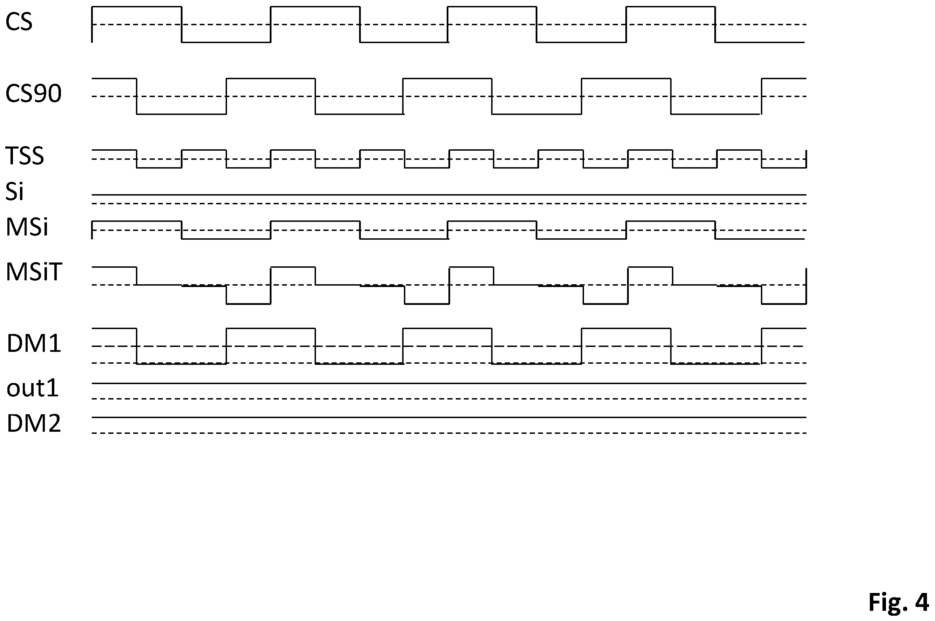

Figur 4 zeigt im Wesentlichen die beispielhaften Signale der Figur 2 nun aber angepasst an die Figur 3.

Figur 5

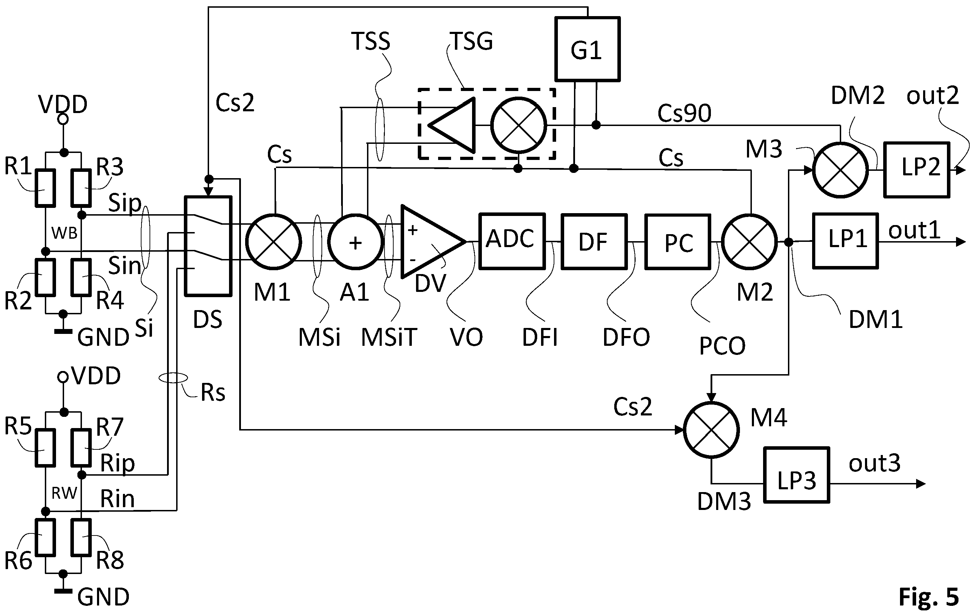

Die Figur 5 basiert auf der Figur 3. In dem Beispiel der Figur 3 ist eine Referenz-Wheatstone-Brücke RW zusätzlich vorgesehen.

Als beispielhafter Sensor mit einem differentiellen Ausgang ist wieder eine Wheatstone-Brücke WB gewählt. Die Wheatstone-Brücke WB umfasst einen ersten piezoresistiven Widerstand R1, einen zweiten piezoresistiven Widerstand R2, einen dritten piezoresistiven Widerstand R3 und einen vierten piezoresistiven Widerstand R4. Der erste Widerstand R1 ist mit dem zweiten Widerstand R2 zwischen der ersten Versorgungsspannungsleitung VDD und der zweiten Versorgungsspannungsleitung GND in Serie geschaltet. Der dritte Widerstand R3 ist mit dem vierten Widerstand R4 zwischen der ersten Versorgungsspannungsleitung VDD und der zweiten Versorgungsspannungsleitung GND ebenfalls in Serie geschaltet. Das Sensorsystem betreibt die Wheatstone-Brücke WB beispielhaft mit der Versorgungsspannung. Die Wheatstone-Brücke WB ist dementsprechend mit einem ersten Anschluss mit der ersten Versorgungsspannungsleitung VDD verbunden und mit einem zweiten Anschluss mit der zweiten Versorgungsspannungsleitung GND verbunden. Der Knoten zwischen dem ersten Widerstand R1 und dem zweiten Widerstand R2 bildet beispielhaft das negative Eingangssignal Sin des differentiellen Eingangssignals Si. Der Knoten zwischen dem dritten Widerstand R3 und dem vierten Widerstand R4 bildet beispielhaft das positive Eingangssignal Sip des differentiellen Eingangssignals Si.

Viele Sensorsysteme nutzen Wheatstone-Brücken zur Wandlung des betreffenden physikalischen Parameters in ein Differenzspannungssignal zwischen einem positiven Eingangssignal Sip und einem negativen Eingangssignal Sin. Beispielsweise kann es sich bei der Wheatstone-Brücke WB um eine solche Brücke aus piezoresistiven Widerständen der Sensorelemente eines piezoresistiven mikromechanischen Drucksensors oder dergleichen handeln. An dieser Stelle sei beispielsweise auf die Schutzrechte EP 2 524 389 B1,
EP 2 524 390 B1, EP 2 524 198 B1, EP 2 523 896 B1 und EP 2 523 895 B1 als Beispiele für solche Drucksensoren verwiesen.

Die Referenz-Wheatstone-Brücke RW umfasst beispielsweise einen fünften piezoresistiven Widerstand R5, einen sechsten piezoresistiven Widerstand R6, einen siebten piezoresistiven Widerstand R7 und einen achten piezoresistiven Widerstand R8. Der fünfte Widerstand R5 ist mit dem sechsten Widerstand R6 zwischen der ersten Versorgungsspannungsleitung VDD und der zweiten Versorgungsspannungsleitung GND in Serie geschaltet. Der siebte Widerstand R7 ist mit dem achten Widerstand R8 zwischen der ersten Versorgungsspannungsleitung VDD und der zweiten Versorgungsspannungsleitung GND ebenfalls in Serie geschaltet. Das Sensorsystem betreibt die Referenz-Wheatstone-Brücke RW beispielhaft mit der Versorgungsspannung. Die Referenz-Wheatstone-Brücke RW ist dementsprechend mit einem ersten Anschluss mit der ersten Versorgungsspannungsleitung VDD verbunden. Die Referenz-Wheatstone-Brücke RW ist mit einem zweiten Anschluss mit der zweiten Versorgungsspannungsleitung GND verbunden. Der Knoten zwischen dem fünften Widerstand R5 und dem sechsten Widerstand R6 bildet beispielhaft ein negatives Referenzsignal Rin eines differentiellen Referenzsignals Rs. Der Knoten zwischen dem siebten Widerstand R7 und dem achten Widerstand 8 bildet beispielhaft ein positives Referenzsignal Rip des differentiellen Referenzsignals Rs. Der fünfte Widerstand R5 und der sechste Widerstand R6 und der siebte Widerstand R7 und der achten Widerstand R8 stellen die Widerstände der Referenz-Wheatstone-Brücke RW dar. Der erste Widerstand R1 und der zweite Widerstand R2 und der dritte Widerstand R3 und der vierte Widerstand R4 stellen die Widerstände der Wheatstone-Brücke WB dar. Bevorzugt fertigt der Herstellungsprozess die Widerstände der Referenz-Wheatstone-Brücke RW mit den gleichen Arbeitsschritten zeitgleich mit den Widerständen der Wheatstone-Brücke WB. Beispielsweise kann es sich bei der Wheatstone-Brücke WB um die Messbrücke eines piezoelektrischen mikromechanischen Drucksensors, beispielsweise auf einem Siliziumeinkristallstück handeln. In einem solchen Beispiel fertigt der Herstellungsprozess entsprechend der Konstruktion bevorzugt die Referenz-Wheatstone-Brücke RW auf dem gleichen Siliziumeinkristallstück mit der Wheatstone-Brücke WB zusammen. In einem solchen Beispiel fertigt der Herstellungsprozess entsprechend der Konstruktion bevorzugt auch in gleicher Ausrichtung der korrespondierenden Widerstände. Der Fachausdruck hierfür ist "matchend". Die Referenz-Wheatstone-Brücke RW kann beispielsweise Teil eines zweiten Drucksensors sein, der dem Drucksensor der Wheatstone-Brücke WB gleicht und im gleichen Substrat, also beispielsweise im gleichen Halbleiterkristall, gefertigt ist. In dem Fall sollte ein drittes Ausgangssignal, out3, dass den Wert des Unterschieds zwischen dem differentiellen Wert des Referenzsignals Rs und dem differenziellen Wert des differenziellen Eingangssignals Si wiedergibt, nahezu Null sein.

Im Falle einer gleich zur Wheatstone-Brücke WB ausgeführten Referenz-Wheatstone-Brücke, sollte dann eine Abweichung zwischen dem differentiellen Wert des Referenzsignals Rs und dem differenziellen Wert des differenziellen Eingangssignals Si, den der Wert des dritten Ausgangssignals out3 repräsentiert, verschwinden. Ein Wert des dritten Ausgangssignals out3 außerhalb eines zulässigen Erwartungswertbereiches um diesen Nullwert herum deutet dann im Falle einer gleich zur Wheatstone-Brücke WB ausgeführten Referenz-Wheatstone-Brücke auf einen Fehler hin. In diesem Fall gibt übrigens der Wert des ersten Ausgangssignals nur den Mittelwert zwischen dem Signalanteil, der auf dem Wert des Eingangssignals Si beruht, und dem Signalanteil, der auf dem Wert des Referenzsignals beruht, an. Insofern hat das System der Figur 5 den Nachteil, dass die Empfindlichkeit typischerweise halbiert ist. Nur wenn die Referenz-Wheatstone-Brücke RW in gleicher Weise wie die Wheatstone-Brücke WB dem Einfluss des beeinflussenden physikalischen Parameters ausgesetzt ist, ändert die Referenz-Wheatstone-Brücke RW ihr Referenzsignal RS in Abhängigkeit vom Wert dieses physikalischen Parameters in gleicher Weise wie die Wheatstone-Brücke WB das Eingangssignal Si in Abhängigkeit von diesem physikalischen Parameter. Nur dann entspricht der Wert des ersten Ausgangssignals out1 bei maximaler Empfindlichkeit dem Wert dieses physikalischen Parameters. Bei dem physikalischen Parameter kann es sich beispielsweise um einen Druck im Falle von Drucksensoren handeln.

Im Falle einer ungleich zur Wheatstone-Brücke WB ausgeführten Referenz-Wheatstone-Brücke RW, kann dann aber eine Abweichung zwischen dem differenziellen Wert des Referenzsignals Rs und dem differenziellen Wert des differenziellen Eingangssignals Si, den der Wert des dritten Ausgangssignals out3 repräsentiert, nicht mehr verschwinden. Ist die Referenz-Wheatstone-Brücke für den von der Wheatstone-Brücke WB zu erfassenden physikalischen Parameter im Wesentlichen unempfindlich, so gibt der Wert des dritten Ausgangssignals out3 typischerweise einen Wert für diesen physikalischen Parameter wieder, der typischerweise um solche Einflussfaktoren im Wesentlichen bereinigt ist, die die Referenz-Wheatstone-Brücke RW und die Wheatstone-Brücke in gleicher Weise beeinflussen.

Es ist aber auch denkbar, dass in dem Beispiel eines mikromechanischen Drucksensors die Referenz-Wheatstone-Brücke RW sich nicht auf einer Membran befindet. In einem solchen Fall sollte die Referenz-Wheatstone-Brücke RW somit im Wesentlichen kein druckabhängiges Signal zeigen. Der Messwert erscheint dann in dem Beispiel der Figur 5 als Wert des dritten Ausgangssignals out3.

Der Vorteil der Anordnung der Figur 5 ist, dass bei einer guten thermischen Kopplung der Referenz-Wheatstone-Brücke RW mit der Wheatstone-Brücke WB die Referenz-Wheatstone-Brücke RW in gleicher Weise rauscht, wie die Wheatstone-Brücke WB selbst. Hierdurch kann das Sensorsystem das 1/f Rauschen der Wheatstone-Brücke WB selbst ebenfalls sicher unterdrücken, was in Figur 1 nicht möglich ist.

Das Signalpaar aus positivem Eingangssignal Sip und negativem Eingangssignal Sin bildet das differentielle Eingangssignal Si. Das Signalpaar aus positivem Referenzsignal Rip und negativem Referenzsignal Rin bildet das differentielle Referenzsignal Rs.

Ein Dicke-Schalter DS schaltet mit Hilfe eines zweiten Chopper-Signals Cs2 zwischen dem differentiellen Eingangssignal Si und dem differentiellen Referenzsignal Rs in Abhängigkeit von dem zweiten Chopper-Signal Cs2 hin und her.

In dem Beispiel der Figur 5 multipliziert ein erster Multiplizierer M1 das so entstandene Mischsignal aus differentiellem Eingangssignal Si und differenziellen Referenzsignal Rs mit dem Chopper-Signal Cs und bildet auf diese Weise das multiplizierte Eingangssignal MSi.

Der erste Addierer A1 addiert zum multiplizierten Eingangssignal MSi das differentielle Testsignal TSS und bildet daraus so wie in Figur 5 das differentielle, multiplizierte Eingangssignal mit Testsignalanteil MSiT. Bevorzugt ist das Chopper-Signal Cs wie zuvor ein digitales Signal mit zwei logischen Werten, hier beispielhaft mit 0 und 1 belegt.

Der Differenzverstärker DV verstärkt das differentielle, multiplizierte Eingangssignal mit Testsignalanteil MSiT zum Verstärkerausgangssignal VO.

Der Analog-zu-Digital-Wandler ADC wandelt das Verstärkerausgangssignal VO in das Eingangssignal DFI des digitalen Filters DF um. Dieses Eingangssignal DFI des digitalen Filters DF ist typischerweise ein digitales Signal von Abtastwerten des Verstärkerausgangssignals VO aus dem Analog-zu-Digital-Wandler ADC.

Der digitale Filter DF filtert das Eingangssignal DFI des digitalen Filters DF zum Ausgangssignal DFO des digitalen Filters DF. Dabei unterdrückt der digitale Filter DF ggf. vorhandene Signalanteile auf Störfrequenzen. Typischerweise handelt es sich um einen Dezimationsfilter für die durch die Abtastung mittels des Analog-zu-Digital-Wandlers ADC hinzugefügten Wandlungsartefakte.

Der Phasen-Kompensator PC korrigiert die dabei entstehenden Phasenfehler und bildet das Phasenkompensatorausgangssignal PCO.

Nach Verstärkung und Digitalisierung multipliziert ein zweiter Multiplizierer M2 das Phasenkompensatorausgangssignal PCO mit dem Chopper-Signal Cs zum ersten demodulierten Signal DM1.

Ein erster Tiefpassfilter LP1 unterdrückt im ersten demodulierten Signal DM1 die Frequenzen, die den Frequenzen im Signalspektrum des Chopper-Signals Cs entsprechen. Der erste Tiefpassfilter LP1 unterdrückt die Frequenzen, die den Frequenzen im Signalspektrum des orthogonalen Chopper-Signals Cs90 entsprechen. Der erste Tiefpassfilter LP1 unterdrückt die Frequenzen, die den Frequenzen im Signalspektrum des zweiten Chopper-Signals Cs2 entsprechen. Der erste Tiefpassfilter LP1 unterdrückt die durch eine Multiplikation des Chopper-Signals Cs mit dem orthogonalen Chopper-Signal Cs90 und dem zweiten Chopper-Signal Cs2 ggf. entstehenden Mischfrequenzen. Der erste Tiefpassfilter LP1 unterdrückt diese Frequenzen bis auf einen Gleichanteil im ersten demodulierten Signal DM1. Der erste Tiefpassfilter LP1 bildet so das erste Ausgangssignal out1. Der Wert des ersten Ausgangssignals out1 entspricht dem Wert des differentiellen Eingangssignals Si, wenn der Sensor der Referenz-Wheatstone-Brücke RW dem Sensor der Wheatstone-Brücke WB gleicht.

Ein dritter Multiplizierer M3 mischt das erste demodulierte Signal DM1 mit dem orthogonalen Chopper-Signal Cs90 zum zweiten demodulierten Signal DM2. Ein zweiter Tiefpassfilter LP2 unterdrückt im zweiten demodulierten Signal DM2 die Frequenzen, die den Frequenzen im Signalspektrum des Chopper-Signals Cs entsprechen. Der zweite Tiefpassfilter LP2 unterdrückt die Frequenzen, die den Frequenzen im Signalspektrum des orthogonalen Chopper-Signals Cs90 entsprechen. Der zweite Tiefpassfilter LP2 unterdrückt die Frequenzen, die den Frequenzen im Signalspektrum des zweiten Chopper-Signals Cs2 entsprechen. Der zweite Tiefpassfilter LP2 unterdrückt die durch eine Multiplikation des Chopper-Signals Cs mit dem orthogonalen Chopper-Signal Cs90 und dem zweiten Chopper-Signal Cs2 ggf. entstehenden Mischfrequenzen. Der zweite Tiefpassfilter LP2 unterdrückt diese Frequenzen bis auf einen Gleichanteil im zweiten demodulierten Signal DM2. Der zweite Tiefpassfilter LP2 bildet so das zweite Ausgangssignal out2. Wie zuvor ist der Wert dieses zweiten Ausgangssignals out2 ein Maß für die korrekte Funktion der Eingangsstufe.

Ein vierter Multiplizierer M4 mischt das erste demodulierte Signal DM1 mit dem zweiten Chopper-Signal Cs2 zum dritten demodulierten Signal DM3. Ein dritter Tiefpassfilter LP3 unterdrückt im dritten demodulierten Signal DM3 die Frequenzen, die den Frequenzen im Signalspektrum des Chopper-Signals Cs entsprechen. Der dritte Tiefpassfilter LP3 unterdrückt die Frequenzen, die den Frequenzen im Signalspektrum des orthogonalen Chopper-Signals Cs90 entsprechen. Der dritte Tiefpassfilter LP3 unterdrückt die Frequenzen, die den Frequenzen im Signalspektrum des zweiten Chopper-Signals Cs2 entsprechen. Der dritte Tiefpassfilter LP3 unterdrückt die durch eine Multiplikation des Chopper-Signals Cs mit dem orthogonalen Chopper-Signal Cs90 und dem zweiten Chopper-Signal Cs2 ggf. entstehenden Mischfrequenzen. Der dritte Tiefpassfilter LP3 unterdrückt diese Frequenzen bis auf einen Gleichanteil im dritten demodulierten Signal DM3. Der dritte Tiefpassfilter LP3 unterdrückt bildet so das dritte Ausgangssignal out3. Ein Nutzer oder ein übergeordnetes Rechnersystem oder ein andere übergeordnetes System können den Wert dieses dritten Ausgangssignals out3 kann als Maß für die korrekte Funktion der Wheatstone-Brücke WB verwenden, wenn der Sensor der Referenz-Wheatstone-Brücke RW dem Sensor der Wheatstone-Brücke WB gleicht.

In dem Beispiel der Figur 5 erzeugt ein Signalgenerator G1 das Chopper-Signal Cs und das orthogonale Chopper-Signal Cs90 und das zweite Chopper-Signal Cs2. Bevorzugt ist das Chopper-Signal Cs bandbreitenbegrenzt oder monofrequent. Bevorzugt ist das zweite Chopper-Signal Cs2 bandbreitenbegrenzt oder monofrequent. Bevorzugt ist das orthogonale Chopper-Signal Cs90 bandbreitenbegrenzt oder monofrequent. Bevorzugt ist das orthogonale Chopper-Signal Cs90 vom Chopper-Signal Cs verschieden. Bevorzugt ist das zweite Chopper-Signal Cs2 vom orthogonalen Chopper-Signal Cs90 und vom Chopper-Signal Cs verschieden. Der erste Tiefpassfilter LP1 weist eine Filtereigenschaft in Form einer ersten Filterfunktion F1[] auf, sodass gilt: out1=F1[DM1(t)]. Der zweite Tiefpassfilter LP2 weist eine Filtereigenschaft in Form einer zweiten Filterfunktion F2[] auf, sodass gilt: out2=F2[DM2(t)]. Der dritte Tiefpassfilter LP3 weist eine Filtereigenschaft in Form einer dritten Filterfunktion F3[] auf, sodass gilt: out3=F3[DM3(t)]. Typischerweise weisen der erste Tiefpassfilter LP1 und der zweite Tiefpassfilter LP2 und der dritte Tiefpassfilter LP3 eine bevorzugt gleiche Filtereigenschaft in Form einer gleichen Filterfunktion F[]=F1[]=F2[]=F3[] auf.

Das Chopper-Signal Cs und das zweite Chopper-Signal Cs2 und das orthogonale Chopper-Signal Cs90 sollen jeweils zueinander orthogonal bezüglich des ersten Filters LP1 und bezüglich des zweiten Filters LP2 und bezüglich des dritten Filters LP3 sein. Das heißt, es soll gelten:

i)

$$F1[Cs(t)]=0$$

ii)

$$F1[Cs90(t)]=0$$

iii)

$$F1[Cs2(t)]=0$$

iv)

$$F1[Cs(t) \times Cs90(t)]=0$$

v)

$$F1[Cs(t) \times Cs2(t)]=0$$

vi)

$$F1[Cs90(t) \times Cs2(t)]=0$$

vii)

$$F2[Cs(t)]=0$$

viii)

$$F2[Cs90(t)]=0$$

ix)

$$F2[Cs2(t)]=0$$

x)

$$F2[Cs(t) \times Cs90(t)]=0$$

xi)

$$F2[Cs(t) \times Cs2(t)]=0$$

xii)

$$F2[Cs90(t) \times Cs2(t)]=0$$

xiii)

$$F3[Cs(t)]=0$$

xiv)

$$F3[Cs90(t)]=0$$

xv)

$$F3[Cs2(t)]=0$$

xvi)

$$F3[Cs(t) \times Cs90(t)]=0$$

xvii)

$$F3[Cs(t) \times Cs2(t)]=0$$

xviii)

$$F3[Cs90(t) \times Cs2(t)]=0$$

Hierbei soll Cs(t) den zeitlichen Verlauf der Werte des Chopper-Signals Cs darstellen und Cs90(t) den zeitlichen Verlauf der Werte des orthogonalen Chopper-Signals Cs90 darstellen und Cs2(t) den zeitlichen Verlauf der Werte des zweiten Chopper-Signals Cs2 darstellen.

Darüber hinaus soll die erste Filterfunktion F1[] bevorzugt eine im Wesentlichen lineare Filterfunktion sein. D.h. es soll für eine Signalsumme aus einem ersten Beispielsignal X1(t) und einem zweiten Beispielsignal X2(t) und für eine reelle Zahl $\alpha$ gelten:

A)

$$F1[X1(t)+X2(t)]= F1[X1(t)]+F1[X2(t)]$$

B)

$$F1[\alpha \times X1(t)]=\alpha \times F1[X1]$$

Darüber hinaus soll die zweite Filterfunktion F2[] bevorzugt eine im Wesentlichen lineare Filterfunktion sein. D.h. es soll für eine Signalsumme aus einem ersten Beispielsignal X1(t) und einem zweiten Beispielsignal X2(t) und für eine reelle Zahl $\alpha$ gelten:

C)

$$F2[X1(t)+X2(t)]= F2[X1(t)]+F2[X2(t)]$$

D)

$$F2[\alpha \times X1(t)]=\alpha \times F2[X1]$$

Schließlich soll die dritte Filterfunktion F3[] bevorzugt eine im Wesentlichen lineare Filterfunktion sein. D.h. es soll für eine Signalsumme aus einem ersten Beispielsignal X1(t) und einem zweiten Beispielsignal X2(t) und für eine reelle Zahl $\alpha$ gelten:

E)

$$F3[X1(t)+X2(t)]= F3[X1(t)]+F3[X2(t)]$$

F)

$$F3[\alpha \times X1(t)]=\alpha \times F3[X1]$$

Schließlich sollen die erste Filterfunktion F1[] und die zweite Filterfunktion F2[] und die dritte Filterfunktion F3[] jeweils eine Tiefpasseigenschaft haben. D.h. es soll gelten:
F1[1]=$\beta_1$ und F2[1]=$\beta_2$ und F3[1]=$\beta_3$ mit $\beta_1$ als reeller, von Null verschiedener Konstante und $\beta_2$ als reeller, von null verschiedener Konstante und $\beta_3$ als reeller, von null verschiedener Konstante.

Beispielsweise kann es sich bei dem Chopper-Signal Cs um ein monofrequentes PWM-Signal mit den Werten -1 und 1 und einem Tastgrad von 50% und einer Chopper-Signalfrequenz handeln. Bei dem orthogonalen Chopper-Signal Cs90 kann es sich dann beispielsweise um ein um +/-90° phasenverschobenes Signal mit den Werten -1 und 1 handeln und einem Tastgrad von 50% mit der Chopper-Signalfrequenz handeln. Alternativ kann es sich um ein monofrequentes PWM-Signal mit den Werten -1 und 1 handeln und einem Tastgrad von 50% und einer Signalfrequenz, die beispielsweise ein ganzzahliges mehrfaches der Chopper-Signalfrequenz beträgt. Es kann sich bei dem Chopper-Signal Cs auch um ein bandbegrenztes, nicht monofrequentes Signal handeln. Auch bei dem orthogonalen Chopper-Signal Cs90 kann es sich um ein bandbegrenztes, nicht monofrequentes Signal handeln. Ebenso kann es sich bei dem zweiten Chopper-Signal Cs2 um ein bandbegrenztes, nicht monofrequentes Signal handeln. Wichtig ist nur die Erfüllung der Orthogonalitätsbedingungen i) bis xviii). Ansonsten ist die Wahl der Signale frei. Typischerweise sind das Chopper-Signal Cs periodisch und das zweite Chopper-Signal Cs2 und das orthogonale Chopper-Signal Cs90 periodisch. Ggf. ist es sinnvoll, den ersten Tiefpassfilter LP1 und den zweiten Tiefpassfilter LP2 und den dritten Tiefpassfilter LP3 mit jeweils einer Halteschaltung (englisch: sample & hold) zu versehen. In diesem Fall ist es sinnvoll zu Zeiten, zu denen die Orthogonalitätsbedingungen i) bis xviii) erfüllt sind, den Ausgang des ersten Tiefpassfilters LP1 mit einer ersten Halteschaltung dieser Halteschaltungen abzutasten. Die erste Halteschaltung gibt dann so abgetasteten ersten Wert als Wert des ersten Ausgangssignals out1 bis zur nächsten Erfüllung der Orthogonalitätsbedingungen i) bis xviii) aus. Außerdem ist es sinnvoll, zu Zeiten, zu denen die Orthogonalitätsbedingungen i) bis xviii) erfüllt sind, den Ausgang des zweiten Tiefpassfilters LP2 mit einer zweiten Halteschaltung dieser Halteschaltungen abzutasten. Die zweite Halteschaltung gibt dann den so abgetasteten zweiten Wert als Wert des zweiten Ausgangssignals out2 bis zur nächsten Erfüllung der Orthogonalitätsbedingungen i) bis xviii) aus. Schließlich ist es sinnvoll, zu Zeiten, zu denen die Orthogonalitätsbedingungen i) bis xviii) erfüllt sind, den Ausgang des dritten Tiefpassfilters LP3 mit einer dritten Halteschaltung dieser Halteschaltungen abzutasten. Die dritte Halteschaltung gibt dann den so abgetasteten dritten Wert als Wert des dritten Ausgangssignals out3 bis zur nächsten Erfüllung der Orthogonalitätsbedingungen i) bis xviii) aus.

In dem Beispiel der Figur 5 erzeugt ein Testsignalgenerator TSG, der auch Teil des Signalgenerators G1 sein kann, das Testsignal TSS aus dem orthogonalen Chopper-Signal Cs90. Dabei stellt der Testsignalgenerator TSG die Amplitude entsprechend einer Vorgabe ein.

Die Konstruktion des Sensorsystems kann einige Schaltungsteile auch mit Hilfe einer digitalen Schaltung oder mittels eines Signalprozessorsystems mit einer entsprechenden Programmierung realisieren. Dies betrifft vor allem den digitalen Filter DF, die Phasenkompensation PC, den Signalgenerator G1, den Testsignalgenerator TSG, den zweiten Multiplizierer M2, den dritten Multiplizierer M3, den vierten Multiplizierer M4, den ersten Tiefpassfilter LP1 und den zweiten Tiefpassfilter LP2 und den dritten Tiefpassfilter LP3.

Bevorzugt vergleicht ein Vergleichsmittel, beispielsweise ein erster Komparator im Zusammenwirken mit einem zweiten Komparator oder der besagte Signalprozessor den Wert des zweiten Ausgangssignals out2 mit einem Erwartungswertbereich, der durch einen ersten Erwartungswert und einen zweiten Erwartungswert begrenzt ist. Liegt der Wert des zweiten Ausgangssignals zwischen dem ersten Erwartungswert und dem zweiten Erwartungswert, also innerhalb des Erwartungswertbereichs, so arbeitet die Eingangsstufe umfassend den ersten Multiplizierer M1, den Differenzverstärker DV1, den Analog-zu-Digital-Wandler ADC, das digitale Filter DF, den Phasenkompensator PC und den zweiten Multiplizierer M2 korrekt. Somit können das Sensorsystem oder ein übergeordnetes Rechnersystem oder eine andere übergeordnete Vorrichtung auf diese Weise eine Aussage über die korrekte Funktion der Eingangsstufe treffen.

Bevorzugt vergleicht ein zweites Vergleichsmittel, beispielsweise ein dritter Komparator im Zusammenwirken mit einem vierten Komparator oder der besagte Signalprozessor den Wert des dritten Ausgangssignals out3 mit einem zweiten Erwartungswertbereich, der durch einen dritten Erwartungswert und einen vierten Erwartungswert begrenzt ist. Liegt der Wert des dritten Ausgangssignals out3 zwischen dem dritten Erwartungswert und dem vierten Erwartungswert, also innerhalb des Erwartungswertbereichs, so arbeitet die Wheatstone-Brücke WB relativ zur Referenz-Wheatstone-Brücke RW korrekt. Somit können das Sensorsystem oder ein übergeordnetes Rechnersystem oder eine andere übergeordnete Vorrichtung auf diese Weise eine Aussage über die korrekte Funktion der Wheatstone-Brücke WB treffen.

Somit ergeben sich im Wesentlichen die folgenden sechs Betriebsmöglichkeiten:

| Fall | Ausführung der Wheatstone-Brücken | Der physikalische Parameter (z.B. Druck) beeinflusst die Referenz-Wheatstone-Brücke in gleicher Weise. | Auswirkung auf das erste Ausgangssignal out1 | Auswirkung auf das dritte Ausgangssignal out3 | Bemerkungen |
|---|---|---|---|---|---|
| 1 | RW=BW | ja | Wert von out1 gibt Messwert mit vollem Brücken-Offset wieder. (entspricht $\alpha=1$) | out3≈0 (entspricht $\alpha=1$) | Übergeordnete Systeme können den Wert von out3 zur Erkennung von Fehlern verwenden. |

(fortgesetzt)

| Fall | Ausführung der Wheatstone-Brücken | Der physikalische Parameter (z.B. Druck) beeinflusst die Referenz-Wheatstone-Brücke in gleicher Weise. | Auswirkung auf das erste Ausgangssignal out1 | Auswirkung auf das dritte Ausgangssignal out3 | Bemerkungen |
|---|---|---|---|---|---|
| 2 | RW≠BW RW um Faktor $\alpha$ abweichend empfindlich für den physikalischen Parameter(Annahme gleicher Brücken-Offset) | ja | Wert von out1 gibt Messwert mit Faktor $(1+\alpha)/2$ mit vollem Brückenoffset wieder. | Wert von out3 gibt Messwert mit Faktor $(1-\alpha)/2$ ohne Brücken-Offset wieder. | Weniger geeignet. Übergeordnete Systeme können den Wert zur Erkennung von Fehlern verwenden. |
| 3 | RW≠BW RW nicht empfindlich für den physikalischen Parameter (Annahme gleicher Brücken-Offset) | ja | Wert von out1 gibt Messwert mit Faktor 1/2 und mit vollem Brückenoffset wieder. (entspricht $\alpha=0$) | Wert von out3 gibt 1/2 Messwert ohne Brückenoffset wieder. | Eine Messung ohne Brückenoffset ist möglich. |
| 4 | RW=BW | nein | Wert von out1 gibt Messwert mit vollem Brücken-Offset wieder. (entspricht $\alpha=1$) | Wert von out3 gibt 1/2 Messwert ohne Brücken-Offset wieder. | Eine Messung ohne Brückenoffset ist möglich. |
| 5 | RW≠BW RW um Faktor $\alpha$ abweichend empfindlich für den physikalischen Parameter (Annahme gleicher Brücken-Offset) | nein | Wert von out1 gibt Messwert mit Faktor $(1+\alpha)/2$ mit vollem Brückenoffset wieder. | Wert von out3 gibt 1/2 Messwert ohne Brücken-Offset wieder. | Eine Messung ohne Brückenoffset ist möglich |
| 6 | RW≠BW RW nicht empfindlich für den physikalischen Parameter (Annahme gleicher Brücken-Offset) | nein | Wert von out1 gibt Messwert mit Faktor 1/2 und mit vollem Brückenoffset wieder. (entspricht $\alpha=0$) | Wert von out3 gibt 1/2 Messwert ohne Brücken-Offset wieder. | Eine Messung ohne Brückenoffset ist möglich. |

Figur 6

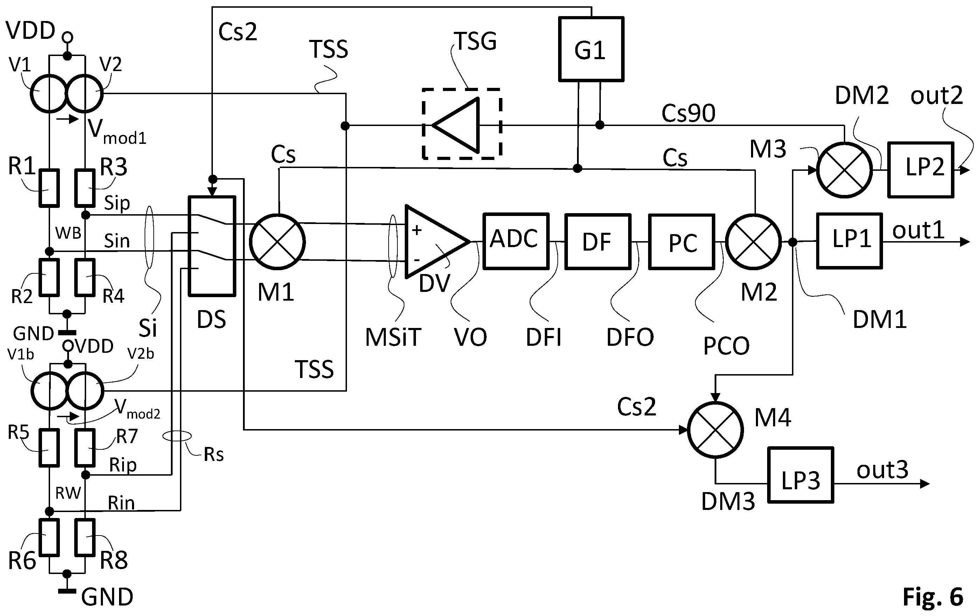

Figur 6 entspricht weitestgehend der Figur 5 mit dem Unterschied, dass eine von dem Testsignal TSS abhängige, erste differentielle Modulationsspannung $V_{mod1}$ aus einer ersten Spannungsquelle V1 und einer zweiten Spannungsquelle V2 die Erregungsspannung der Wheatstone-Brücke WB moduliert. Die jeweiligen Spannungen der ersten Spannungsquelle V1 und der zweiten Spannungsquelle V2 hängen bevorzugt in zueinander entgegengesetzter Weise vom Testsignal TSS ab. Ein weiterer Unterschied zwischen Figur 6 und Figur 5 ist, dass eine von dem Testsignal TSS abhängige, zweite differentielle Modulationsspannung $V_{mod2}$ aus einer dritten Spannungsquelle V1b und einer vierten Spannungsquelle V2b die Erregungsspannung der Referenz-Wheatstone-Brücke RW moduliert. Die jeweiligen Spannungen der dritten Spannungsquelle V1b und der vierten Spannungsquelle V2b hängen bevorzugt in zueinander entgegengesetzter Weise vom Testsignal TSS ab.

Dies moduliert sowohl das differentielle Eingangssignal Si, als auch das differentielle Referenzsignal Rs mit dem Testsignal TSS anteilig. Das System der Figur 6 hat den Vorteil, dass der überprüfte Signalpfad die Wheatstone-Brücke WB und die Referenz-Wheatstone-Brücke RW in einbezieht. Nachteilig sind die effektive Verringerung der Erregungsspannung und damit die effektive Verringerung des Nutzsignalhubes des Eingangssignals Si. Der erste Addierer entfällt dann. Die Signalverarbeitung erfolgt in analoger Weise, wie für die vorausgehenden Figuren erläutert.

Die differentielle Spannungsquelle, die die erste differentiellen Modulationsspannung $V_{mod1}$ in der Wheatstone-Brücke WB erzeugt, besteht beispielsweise aus einer ersten Spannungsquelle V1 und aus einer zweiten Spannungsquelle V2. Die erste Spannungsquelle V1 ist dabei zwischen den ersten Widerstand R1 und der ersten Versorgungsspannungsleitung VDD geschaltet. Die Spannung der ersten Spannungsquelle V1 hängt dabei von dem Testsignal TSS ab. Die zweite Spannungsquelle V2 ist zwischen den dritten Widerstand R3 und der ersten Versorgungsspannungsleitung VDD geschaltet. Die Spannung der zweiten Spannungsquelle V2 hängt von dem Testsignal TSS ab. Dabei hängt die Spannung der ersten Spannungsquelle V1 in umgekehrter Weise von dem Testsignal TSS ab, wie die Spannung der zweiten Spannungsquelle V2. Bis auf diesen Vorzeichenunterschied der Abhängigkeit von dem Testsignal TSS sind die erste Spannungsquelle V1 und die zweite Spannungsquelle V2 bevorzugt gleich ausgeführt. Bevorzugt sind sie thermisch so gekoppelt, dass sie sich im Wesentlichen gleich verhalten. Bevorzugt sind sie daher auf dem gleichen Halbleitersubstrat gefertigt.

Die differentielle Spannungsquelle, die die zweite differentielle Modulationsspannung $V_{mod2}$ in der Referenz-Wheatstone-Brücke RW erzeugt, besteht beispielsweise aus einer dritten Spannungsquelle V1b und aus einer vierten Spannungsquelle V2b. Die dritte Spannungsquelle V1b ist dabei zwischen den fünften Widerstand R5 und der ersten Versorgungsspannungsleitung VDD geschaltet. Die Spannung der dritten Spannungsquelle V1b hängt dabei von dem Testsignal TSS ab. Die vierte Spannungsquelle V2b ist zwischen den siebten Widerstand R7 und der ersten Versorgungsspannungsleitung VDD geschaltet. Die Spannung der vierten Spannungsquelle V2b hängt von dem Testsignal TSS ab. Dabei hängt die Spannung der dritten Spannungsquelle V1b in umgekehrter Weise von dem Testsignal TSS ab, wie die Spannung der vierten Spannungsquelle V2b. Bis auf diesen Vorzeichenunterschied der Abhängigkeit von dem Testsignal TSS sind die dritte Spannungsquelle V1b und die vierte Spannungsquelle V2b bevorzugt gleich ausgeführt. Bevorzugt sind sie thermisch so gekoppelt, dass sie sich im Wesentlichen gleich verhalten. Bevorzugt sind sie daher aus dem gleichen Halbleitersubstrat gefertigt.

Dabei hängt die Spannung der ersten Spannungsquelle V1 in gleicher Weise von dem Testsignal TSS ab, wie die Spannung der dritten Spannungsquelle V1b. Dabei hängt die Spannung der zweiten Spannungsquelle V2 in gleicher Weise von dem Testsignal TSS ab, wie die Spannung der vierten Spannungsquelle V2b. Die erste Spannungsquelle V1 und die dritte Spannungsquelle V1b sind bevorzugt gleich ausgeführt. Die zweite Spannungsquelle V2 und die vierte Spannungsquelle V2b sind bevorzugt gleich ausgeführt. Bevorzugt sind alle vier thermisch so gekoppelt, dass sie sich bis auf das besagte Vorzeichen im Verhalten im Wesentlichen gleich verhalten. Bevorzugt sind sie daher auf dem gleichen Halbleitersubstrat matchend gefertigt.

Figur 7

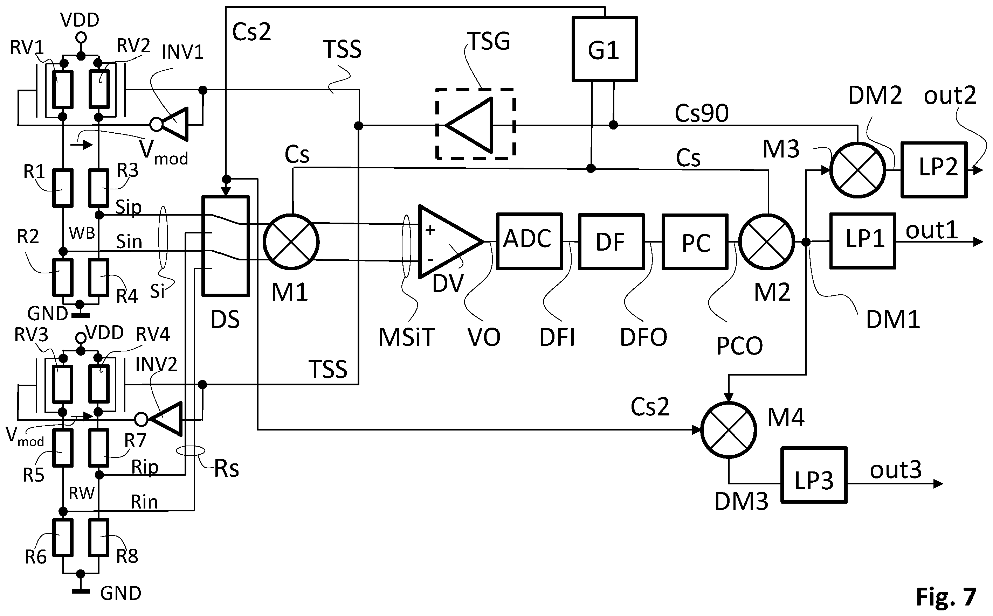

Figur 7 entspricht weitestgehend der Figur 6 mit dem Unterschied, dass eine von dem Testsignal TSS abhängige erste differentiellen Modulationsspannung $V_{mod1}$ die Erregungsspannung der Wheatstone-Brücke WB nicht moduliert. Dabei ist die erste differentiellen Modulationsspannung $V_{mod1}$ die Differenzspannung zwischen dem Ausgangspotenzial einer ersten Spannungsquelle V1 und dem Ausgangspotenzial einer zweiten Spannungsquelle V2. Die jeweiligen Spannungen der ersten Spannungsquelle V1 und der zweiten Spannungsquelle V2 hängen vorzugsweise in zueinander entgegengesetzter Weise vom Testsignal TSS ab. Im Unterschied zur Figur 6 moduliert eine, von dem Testsignal TSS abhängige, zweite differentielle Modulationsspannung $V_{mod2}$ die Erregungsspannung der Referenz-Wheatstone-Brücke RW nicht. Die zweite differentiellen Modulationsspannung $V_{mod2}$ ist dabei die Differenzspannung zwischen dem Ausgangspotenzial einer dritten Spannungsquelle V1b und dem Ausgangspotenzial einer vierten Spannungsquelle V2b. Die jeweiligen Spannungen der dritten Spannungsquelle V1b und der vierten Spannungsquelle V2b hängen bevorzugt in zueinander entgegengesetzter Weise vom Testsignal TSS ab.

Stattdessen moduliert das Sensorsystem in der Wheatstone-Brücke WB den Wert des ersten Widerstands R1 und den Wert des dritten Widerstands R3 und in der Referenz-Wheatstone-Brücke RW den Wert des fünften Widerstands R5 und den Wert des siebten Widerstands R7.

In der Figur 7 moduliert das Sensorsystem den effektiven Wert des ersten Widerstands R1. Hierzu ist der erste Anschluss des ersten Widerstands R1 mit dem zweiten Anschluss eines ersten variablen Widerstands RV1 verbunden. Des Weiteren ist zu diesem Zweck der erste Anschluss des ersten variablen Widerstands RV1 statt des ersten Anschlusses des ersten Widerstands R1 mit der ersten Versorgungsspannungsleitung VDD verbunden. Der Widerstandswert des ersten variablen Widerstands RV1 hängt hierbei von dem Wert des Testsignals TSS ab. In dem Beispiel der Figur 7 schaltet das Testsignal TSS einen Transistor, der parallel zum Widerstandswert des ersten variablen Widerstands RV1 geschaltet ist. Im Sinne dieser Schrift bilden dieser Transistor und der zu diesem Transistor parallelgeschaltete Widerstandswert zusammen den ersten variablen Widerstand RV1. Das mittels eines ersten invertierenden Verstärkers INV1 invertierte Testsignals TSS steuert den Transistor des ersten variablen Widerstands RV1.

In der Figur 7 moduliert das Sensorsystem den effektiven Wert des dritten Widerstands R3. Hierzu ist der erste Anschluss des dritten Widerstands R3 mit dem zweiten Anschluss eines zweiten variablen Widerstands RV2 verbunden. Des Weitere ist zu diesem Zweck der erste Anschluss des zweiten variablen Widerstands RV2 statt des ersten Anschlusses des dritten Widerstands R3 mit der ersten Versorgungsspannungsleitung VDD verbunden. Der Widerstandswert des zweiten variablen Widerstands RV2 hängt hierbei von dem Wert des Testsignals TSS ab. In dem Beispiel der Figur 7 schaltet das Testsignal TSS einen Transistor, der parallel zum Widerstandswert des zweiten variablen Widerstands RV2 geschaltet ist. Im Sinne dieser Schrift bilden dieser Transistor und der zu diesem Transistor parallelgeschaltete Widerstandswert zusammen den zweiten variablen Widerstand RV2. Das Testsignal TSS steuert dabei den Transistor des zweiten variablen Widerstands RV2.

In der Figur 7 moduliert das Sensorsystem den effektiven Wert des fünften Widerstands R5. Hierzu ist der erste Anschluss des fünften Widerstands R5 mit dem zweiten Anschluss eines dritten variablen Widerstands RV3 verbunden. Des Weiteren ist hierzu der erste Anschluss des dritten variablen Widerstands RV3 statt des ersten Anschlusses des fünften Widerstands R5 mit der ersten Versorgungsspannungsleitung VDD verbunden. Der Widerstandswert des dritten variablen Widerstands RV3 hängt hierbei von dem Wert des Testsignals TSS ab. In dem Beispiel der Figur 7 schaltet das Testsignal TSS einen Transistor, der parallel zum Widerstandswert des dritten variablen Widerstands RV3 geschaltet ist. Im Sinne dieser Schrift bilden dieser Transistor und der zu diesem Transistor parallelgeschaltete Widerstandswert zusammen den dritten variablen Widerstand RV3. Das mittels eines zweiten invertierenden Verstärkers INV2 invertierte Testsignals TSS steuert dabei den Transistor des dritten variablen Widerstands RV3.

In der Figur 7 moduliert das Sensorsystem den effektiven Wert des siebten Widerstands R7. Hierzu ist der erste Anschluss des siebten Widerstands R7 mit dem zweiten Anschluss eines vierten variablen Widerstands RV4 verbunden. Des Weiteren ist hierzu der erste Anschluss des vierten variablen Widerstands RV4 statt des ersten Anschlusses des siebten Widerstands R7 mit der ersten Versorgungsspannungsleitung VDD verbunden. Der Widerstandswert des vierten variablen Widerstands RV4 hängt hierbei von dem Wert des Testsignals TSS ab. In dem Beispiel der Figur 7 schaltet das Testsignal TSS einen Transistor, der parallel zum Widerstandswert des vierten variablen Widerstands RV4 geschaltet ist. Im Sinne dieser Schrift bilden dieser Transistor und der zu diesem Transistor parallelgeschaltete Widerstandswert zusammen den vierten variablen Widerstand RV4. Das Testsignal TSS steuert dabei den Transistor des vierten variablen Widerstands RV4.

Durch diese beispielhafte Konstruktion moduliert das Testsignal TSS sowohl das differentielle Eingangssignal Si als auch das differentielle Referenzsignal Rs anteilig. Das System der Figur 7 hat den Vorteil, dass der überprüfte Signalpfad die Wheatstone-Brücke WB und die Referenz-Wheatstone-Brücke RW miteinbezieht. Nachteilig sind die effektive Verringerung der Erregungsspannung und damit die effektive Verringerung des Hubes. Der erste Addierer entfällt dann. Die Signalverarbeitung erfolgt in analoger Weise, wie für die vorausgehenden Figuren erläutert.

Dabei hängen bevorzugt die Widerstandswerte des ersten variablen Widerstands RV1 und des dritten variablen Widerstands RV3 bevorzugt in gleicher Weise von dem Testsignal TSS ab.

Dabei hängen bevorzugt die Widerstandswerte des zweiten variablen Widerstands RV2 und des vierten variablen Widerstands RV4 bevorzugt in gleicher Weise von dem Testsignal TSS ab.

Dabei hängen bevorzugt die Widerstandswerte des ersten variablen Widerstands RV1 und des zweiten variablen Widerstands RV2 bevorzugt in umgekehrter, aber ansonsten gleicher Weise von dem Testsignal TSS ab.

Dabei hängen bevorzugt die Widerstandswerte des dritten variablen Widerstands RV3 und des vierten variablen Widerstands RV4 bevorzugt in umgekehrter, aber ansonsten gleicher Weise von dem Testsignal TSS ab.

Bevorzugt ist der erste variable Widerstand RV1 gleich (englisch: matchend) zum zweiten variablen Widerstand RV2 ausgeführt.

Bevorzugt ist der dritte variable Widerstand RV3 gleich (englisch: matchend) zum vierten variablen Widerstand RV4 ausgeführt.

Bevorzugt ist der erste variable Widerstand RV1 gleich (englisch: matchend) zum dritten variablen Widerstand RV3 ausgeführt.

Bevorzugt ist der zweite variable Widerstand RV2 gleich (englisch: matchend) zum vierten variablen Widerstand RV4 ausgeführt.


Bezugszeichenliste

A1      erster Addierer;

ADC     Analog-zu-Digital-Wandler;

| | |
|---|---|
| Cs | Chopper-Signal; |
| Cs2 | zweites Chopper-Signal; |
| Cs90 | orthogonales Chopper-Signal; |
| DF | digitaler Filter; |
| DFI | Eingangssignal des digitalen Filters (DF); |
| DFO | Ausgangssignal des digitalen Filters (DF); |
| DM1 | erstes demoduliertes Signal; |
| DM2 | zweites demoduliertes Signal; |
| DM3 | drittes demoduliertes Signal; |
| DS | Dicke-Schalter; |
| DV | Differenzverstärker; |
| G1 | Signalgenerator; |
| GND | zweite Versorgungsspannungsleitung; |
| INV1 | erster invertierender Verstärker oder Inverter; |
| INV2 | zweiter invertierender Verstärker oder Inverter; |
| LP1 | erstes Tiefpassfilter; |
| LP2 | zweites Tiefpassfilter; |
| LP3 | drittes Tiefpassfilter; |
| M1 | erster Multiplizierer; |
| M2 | zweiter Multiplizierer; |
| M3 | dritter Multiplizierer; |
| M4 | vierter Multiplizierer; |
| MSi | multipliziertes Eingangssignal; |
| MSiT | differentielles, multipliziertes Eingangssignal mit Testsignalanteil; |
| out1 | erstes Ausgangssignal; |
| out2 | zweites Ausgangssignal; |
| out3 | drittes Ausgangssignal; |
| PC | Phasenkompensator; |
| PCO | Phasenkompensatorausgangssignal; |

R1      erster Widerstand;

R2      zweiter Widerstand;

R3      dritter Widerstand;

R4      vierter Widerstand;

R5      fünfter Widerstand;

R6      sechster Widerstand;

R7      siebter Widerstand;

R8      achter Widerstand;

Rin     negatives Referenzsignal;

Rip     positives Referenzsignal;

Rs      Referenzsignal;

RV1     erster variabler Widerstand;

RV2     zweiter variabler Widerstand;

RV3     dritter variabler Widerstand;

RV4     vierter variabler Widerstand;

RW      Referenz-Wheatstone-Brücke;

Si      differentielles Eingangssignal;

Sin     negatives Eingangssignal;

Sip     positives Eingangssignal;

SiT     differentielles Eingangssignal mit Testsignalanteil;

t       Zeit;

TSG     Testsignalgenerator;

TSS     Testsignal;

WB      Wheatstone-Brücke aus erstem Widerstand (R1), zweitem Widerstand (R2), drittem Widerstand (R3) und viertem Widerstand (R4);

V1      erste Spannungsquelle;

V1b     dritte Spannungsquelle;

V2      zweite Spannungsquelle;

V2b     vierte Spannungsquelle;

$V_{mod1}$   erste differentiellen Modulationsspannung;

$V_{mod2}$     zweite differentiellen Modulationsspannung;

VO       Verstärkerausgangssignal;

VDD     erste Versorgungsspannungsleitung;

**Liste der zitierten Schriften**

EP 2 524 389 B1,
EP 2 524 390 B1,
EP 2 524 198 B1,
EP 2 523 896 B1,
EP 2 523 895 B1.

Nicht-Patentliteratur

Skriptum "Einführung in die Differentialgeometrie" von Christopher R. Nerz

Links

https://de.wikipedia.org/wiki/Lp-Raum#Der_Hilbertraum_L2
https://www.math.uni-tuebingen.de/de/forschung/gadr/lehre/sose2015/diffgeo.pdf

**Liste der zitierten Schriften**

EP 2 524 389 B1,
EP 2 524 390 B1,
EP 2 524 198 B1,
EP 2 523 896 B1,
EP 2 523 895 B1.

Nicht-Patentliteratur

Skriptum "Einführung in die Differentialgeometrie" von Christopher R. Nerz

Links

https://de.wikipedia.org/wiki/Lp-Raum#Der_Hilbertraum_L2
https://www.math.uni-tuebingen.de/de/forschung/gadr/lehre/sose2015/diffgeo.pd

**Patentansprüche**

1.   Verfahren zur Überwachung eines Sensorsystems im Betrieb,

wobei das Sensorsystem ein Sensorelement (WB) aufweist, das ein Eingangssignal (Si) mit einem zeitlichen Verlauf (Si(t)) eines Eingangssignalwerts des Eingangssignals (Si) liefert und
wobei das Sensorsystem einen Signalpfad aufweist und
wobei der Signalpfad an einer ersten Stelle des Signalpfads einen Verstärker (DV) mit einem Eingang und einem Ausgang umfasst und

wobei der Signalpfad mit dem Eingangssignal (Si) des Sensorelements (WB) beginnt und
wobei der Signalpfad mit einem ersten Ausgangssignal (out1) des Sensorsystems endet und
wobei ein Wert des ersten Ausgangssignals (out1) oder ein Wert eines daraus abgeleiteten Signals einen Messwert darstellt,
umfassend die Schritte

a) erstes Mischen des Eingangssignals (Si) im Signalpfad mit einem Chopper-Signal (Cs) an einer zweiten Stelle im Signalpfad,

- wobei sich diese zweite Stelle im Signalpfad zwischen dem Sensorelement (WB) und dem Eingang des Verstärkers (DV) befindet und
- wobei das Chopper-Signal (Cs) bandbegrenzt oder monofrequent ist;

b) zweites Mischen des Eingangssignals (Si) an einer dritten Stelle im Signalpfad mit dem Chopper-Signal (Cs) zu einem ersten demodulierten Signal (DM1),

- wobei sich die dritte Stelle im Signalpfad zwischen Ausgang des Verstärkers (DV) an der ersten Stelle im Signalpfad und erstem Ausgangssignal (out1) des Sensorsystems am Ende des Signalpfads befindet;

c) erstes Filtern des ersten demodulierten Signals (DM1) oder eines daraus abgeleiteten Signals an einer vierten Stelle im Signalpfad zwischen der dritten Stelle im Signalpfad einerseits und dem ersten Ausgangssignal (out1) des Sensorsystems am Ende des Signalpfads andererseits,

- wobei dieses erste Filtern mittels Anwendung einer ersten Filterfunktion F1[] auf das erste demodulierte Signal (DM1) oder des daraus abgeleiteten Signals erfolgt und
- wobei die erste Filterfunktion F1[] den Zusammenhang zwischen einem zeitlichen Verlauf (DM1(t)) des ersten demodulierten Signals (DM1) oder des daraus abgeleiteten Signals einerseits und einem zeitlichen Verlauf des Signals unmittelbar nach der ersten Filterung beschreibt und
- wobei das erste Ausgangssignal (out1) von diesem ersten demodulierten Signal (DM1) unmittelbar nach der ersten Filterung abhängt oder das Ergebnis dieser ersten Filterung ist,

**gekennzeichnet durch** die zusätzlichen Schritte,
d) Addieren eines orthogonalen Chopper-Signals (Cs90) oder eines daraus abgeleiteten Testsignals (TSS) zu dem Eingangssignal (Si) in dem Signalpfad an einer fünften Stelle im Signalpfad zwischen dem Sensorelement (WB) und dem Verstärker (DV),

- wobei das Chopper-Signal (Cs) einen zeitlichen Verlauf (Cs(t)) des Chopper-Signals (Cs) aufweist und
- wobei das orthogonale Chopper-Signal (Cs90) einen zeitlichen Verlauf (Cs90(t)) des orthogonalen Chopper-Signals (Cs90) aufweist und
- wobei der zeitliche Verlauf (Cs90(t)) des orthogonalen Chopper-Signals (Cs) bezüglich der besagten ersten Filterfunktion F1[] im Wesentlichen bis auf Rauschen und ähnliche Signalfehler die Eigenschaft F1[Cs90(t) x Cs(t)]=0 zumindest zeitweise aufweist;

e) drittes Mischen des ersten demodulierten Signals (DM1) oder eines daraus abgeleiteten Signals mit dem orthogonalen Chopper-Signal (Cs90) oder einem daraus abgeleiteten Signal und Erzeugung eines zweiten demodulierten Signals (DM2);
f) zweites Filtern des zweiten demodulierten Signals (DM2) oder eines daraus abgeleiteten Signals mittels einer zweiten Filterfunktion F2[] zu einem zweiten Ausgangssignal (out2), wobei

- die zweite Filterfunktion F2[] so gewählt ist, dass im Wesentlichen

$$F2[Cs(t)]=0$$

und

$$F2[Cs90(t)]=0$$

und

$$F2[Cs(t) \times Cs90(t)] = 0$$

und
F2[1]=$\beta_2$ mit $\beta_2$ als reellem oder komplexen Wert gilt und
- die erste Filterfunktion F1[] so gewählt ist, dass im Wesentlichen

$$F1[Cs(t)] = 0$$

und

$$F1[Cs90(t)] = 0$$

und

$$F1[Cs(t) \times Cs90(t)] = 0$$

und
F1[1]=$\beta_1$ mit $\beta_1$ als reellem oder komplexen Wert gilt;

g) erster Vergleich des Werts des zweiten Ausgangssignals (out2) oder des Werts eines daraus abgeleiteten Signals mit einem Erwartungswertintervall und schließen auf einen Fehler, wenn der Wert des zweiten Ausgangssignals (out2) oder des daraus abgeleiteten Signals außerhalb des Erwartungswertintervalls liegt.

2. Verfahren nach Anspruch 1
   umfassend die zusätzlichen Schritte

   h) Bereitstellen eines Referenzelements (RW), das ein Referenzsignal (Rs) liefert,
   i) Verarbeiten des Referenzsignals (Rs) in einem Referenzsignalpfad,

   - wobei der Referenzsignalpfad gleich dem Signalpfad zur Verarbeitung des Eingangssignals (Si) gestaltet ist, und
   - wobei der Referenzsignalpfad mit dem Referenzsignal (Rs) beginnt und
   - wobei der Referenzsignalpfad mit dem zweiten Ausgangssignal (out2) endet und
   - wobei der Referenzsignalpfad am Beginn des Referenzpfads beim Referenzsignal (Rs) vom Signalpfad am Beginn des Signalpfads beim Eingangssignal (Si) verschieden ist und
   - wobei der Referenzsignalpfad an einer ersten Stelle des Referenzsignalpfads den Verstärker (DV) mit dem Eingang und dem Ausgang umfasst und
   - wobei somit der Verstärker (DV) Teil des Referenzsignalpfads an der ersten Stelle im Referenzsignalpfad und Teil des Signalpfads an der ersten Stelle des Signalpfads ist und
   - wobei der Referenzsignalpfad an einer sechsten Stelle im Referenzsignalpfad zwischen dem Referenzelement (RW) und dem Eingang des Verstärkers (DV) einen Umschalter (DS) mit einem ersten Eingang und einem zweiten Eingang aufweist, wobei die sechste Stelle im Referenzsignalpfad einer sechsten Stelle im Signalpfad entspricht, sodass der Umschalter (DS) zugleich auch an der sechsten Stelle im Signalpfad zwischen dem Sensorelement (WB) und dem Eingang des Verstärkers (DV) angeordnet ist, und somit der Umschalter (DS) ein gemeinsamer Umschalter (DS) ist, und
   - wobei der gemeinsame Umschalter (DS) einen aktiven Eingang in Abhängigkeit von einem zweiten Chopper-Signal (Cs2) zwischen seinem ersten Eingang und seinem zweiten Eingang auswählt und
   - wobei der Signalpfad den ersten Eingang des Umschalters (DS) umfasst und
   - wobei der Referenzsignalpfad den zweiten Eingang des Umschalters (DS) umfasst und
   - wobei der Signalpfad den zweiten Eingang des Umschalters (DS) nicht umfasst und
   - wobei der Referenzpfad den ersten Eingang des Umschalters (DS) nicht umfasst und
   - wobei der gemeinsame Umschalter (DS) seinen aktiven, in Abhängigkeit von dem zweiten Chopper-Signal (Cs2) gewählten, jeweiligen Eingang auswählt und den jeweiligen aktuellen Wert an diesem jeweils ausgewählten, aktiven Eingang des gemeinsamen Umschalters (DS) an einen Ausgang des gemeinsamen Umschalters (DS) durchschaltet und

- wobei der Referenzsignalpfad und der Signalpfad in einem Abschnitt vom Ausgang des gemeinsamen Umschalters (DS) an der sechsten Stelle im Referenzsignalpfad und an der sechsten Stelle im Signalpfad einerseits und dem Eingang des Verstärkers (DV) an der ersten Stelle im Referenzsignalpfad und Signalpfad andererseits identisch sind und
- wobei die erste Filterung mit der ersten Filterfunktion F1[] lediglich Teil des Signalpfads und nicht Teil des Referenzpfads ist;

j) viertes Mischen des ersten demodulierten Signals (DM1) oder eines daraus abgeleiteten Signals mit dem zweiten Chopper-Signal (Cs2) zu einem dritten demodulierten Signal (DM3);
k) drittes Filtern des dritten demodulierten Signals (DM3) oder eines daraus abgeleiteten Signals mittels einer dritten Filterfunktion F3[] zu einem dritten Ausgangssignal (out3),

- wobei die erste Filterfunktion F1[] so gewählt ist, dass im Wesentlichen

$$F1[Cs(t)]=0$$

und

$$F1[Cs2(t)]=0$$

und

$$F1[Cs90(t)]=0$$

und

$$F1[Cs(t)x\ Cs2(t)]=0$$

und

$$F1[Cs(t)x\ Cs90(t)]=0$$

und

$$F1[Cs2(t)x\ Cs90(t)]=0$$

und

$$F1[Cs(t)\ x\ Cs2(t)x\ Cs90(t)]=0$$

und
und $F1[1]=\beta_1$ mit $\beta_1$ als reellem oder komplexen Wert gilt, und
- wobei die zweite Filterfunktion F2[] so gewählt ist, dass im Wesentlichen

$$F2[Cs(t)]=0,$$

$$F2[Cs2(t)]=0,$$

$$F2[Cs90(t)]=0,$$

$$F2[Cs(t)x\ Cs2(t)]=0,$$

$$F2[Cs(t) \times Cs90(t)]=0,$$

$$F2[Cs2(t) \times Cs90(t)]=0,$$

$$F2[Cs(t) \times Cs2(t) \times Cs90(t)]=0,$$

und $F2[1]=\beta_2$ mit $\beta_2$ als reellem oder komplexen Wert gilt, und
- wobei die dritte Filterfunktion F3[] so gewählt ist, dass im Wesentlichen

$$F3[Cs(t)]=0,$$

$$F3[Cs2(t)]=0,$$

$$F3[Cs90(t)]=0,$$

$$F3[Cs(t) \times Cs2(t)]=0,$$

$$F3[Cs(t) \times Cs90(t)]=0,$$

$$F3[Cs2(t) \times Cs90(t)]=0,$$

$$F3[Cs(t) \times Cs2(t) \times Cs90(t)]=0,$$

und $F3[1]=\beta_3$ mit $\beta_3$ als reellem oder komplexen Wert gilt;

l) zweiter Vergleich eines Werts des dritten Ausgangssignals (out3) oder eines Werts eines daraus abgeleiteten Signals mit einem dritten Erwartungswertintervall und schließen auf einen Fehler, wenn der Wert des dritten Ausgangssignals (out3) oder der Wert des daraus abgeleiteten Signals außerhalb des dritten Erwartungswertintervalls liegt.

3. Verfahren zur Überwachung eines Sensorsystems im Betrieb,

wobei das Sensorsystem ein Sensorelement (WB) aufweist, das ein Eingangssignal (Si) mit einem Eingangssignalwert in Abhängigkeit von einem Testsignal (TSS) liefert und wobei das Sensorsystem einen Signalpfad aufweist und
wobei der Signalpfad an einer ersten Stelle im Signalpfad einen Verstärker (DV) mit einem Eingang und einem Ausgang umfasst und
wobei der Signalpfad mit dem Eingangssignal (Si) des Sensorelements (WB) beginnt und
wobei der Signalpfad mit einem ersten Ausgangssignal (out1) endet und
wobei ein Wert des Ausgangssignals (out1) einen Messwert darstellt,
umfassend die Schritte

a) erstes Mischen des Eingangssignals (Si) mit einem Chopper-Signal (Cs) an einer zweiten Stelle im Signalpfad

- wobei sich diese zweite Stelle im Signalpfad zwischen dem Sensorelement (WB) und dem Eingang des Verstärkers (DV) befindet und
- wobei das Chopper-Signal (Cs) bandbegrenzt oder monofrequent ist;

b) zweites Mischen des Signals an einer dritten Stelle im Signalpfad mit dem Chopper-Signal (Cs) zu einem ersten demodulierten Signal (DM1)

- wobei sich die dritte Stelle im Signalpfad zwischen Ausgang des Verstärkers (DV) einerseits und dem ersten Ausgangssignal (out1) des Sensorsystems andererseits befindet;

c) erstes Filtern des ersten demodulierten Signals (DM1) oder eines daraus abgeleiteten Signals an einer vierten Stelle im Signalpfad zwischen der dritten Stelle im Signalpfad einerseits und dem Ausgangssignal (out1) am Ende des Signalpfads andererseits,

    - wobei dieses erste Filtern mittels Anwendung einer erste Filterfunktion F1[] auf das erste demodulierte Signal (DM1) oder des daraus abgeleiteten Signals erfolgt und

    - wobei die erste Filterfunktion F1[] einen Zusammenhang zwischen einem zeitlichen Verlauf (DM1(t)) des ersten demodulierten Signals (DM1) oder des daraus abgeleiteten Signals einerseits und einem zeitlichen Verlauf des Eingangssignals (Si) beschreibt, wobei dieser Zusammenhang zwischen dem zeitlichen Verlauf (DM1(t)) des ersten demodulierten Signals (DM1) oder des daraus abgeleiteten Signals und dem zeitlichen Verlauf des Eingangssignals (Si) das Ergebnis der Filterung des ersten demodulierten Signals (DM1) mit der ersten Filterfunktion F1[] ist, und

    - wobei das erste Ausgangssignal (out1) von diesem ersten demodulierten Signal (DM1) abhängt oder das Ergebnis dieser ersten Filterung ist,

**gekennzeichnet durch** die Schritte,

d) Erzeugen des Testsignals (TSS) in Abhängigkeit von einem orthogonalen Chopper-Signal (Cs90);

    - wobei das Chopper-Signal (Cs) einen zeitlichen Verlauf (Cs(t)) des Chopper-Signals (Cs) aufweist und

    - wobei das orthogonale Chopper-Signal (Cs90) einen zeitlichen Verlauf (Cs90(t)) des orthogonalen Chopper-Signals (Cs90) aufweist und

    - wobei der zeitliche Verlauf (Cs90(t)) des orthogonalen Chopper-Signals (Cs90) bezüglich der besagten ersten Filterfunktion F1[] im Wesentlichen bis auf Rauschen und ähnliche Signalfehler die Eigenschaft

$$F1[Cs90(t) \times Cs(t)] = 0$$ zumindest zeitweise aufweist;

e) drittes Mischen des ersten demodulierten Signals (DM1) oder eines daraus abgeleiteten Signals mit dem orthogonalen Chopper-Signal (Cs90) oder einem daraus abgeleiteten Signal und Erzeugung eines zweiten demodulierten Signals (DM2);

f) zweites Filtern des zweiten demodulierten Signals (DM2) oder eines daraus abgeleiteten Signals mittels einer zweiten Filterfunktion F2[] zu einem zweiten Ausgangssignal (out2),

    - wobei die zweite Filterfunktion F2[] so gewählt ist, dass im Wesentlichen

$$F2[Cs(t)] = 0$$

und

$$F2[Cs90(t)] = 0$$

und

$$F2[Cs(t) \times Cs90(t)] = 0$$

und
$F2[1] = \beta_2$ mit $\beta_2$ als reellem oder komplexen Wert gilt und
    - wobei die erste Filterfunktion F1[] so gewählt ist, dass im Wesentlichen

$$F1[Cs(t)] = 0$$

und

$$F1[Cs90(t)] = 0$$

und

$$F1[Cs(t) \times Cs90(t)] = 0$$

und

$F1[1] = \beta_1$ mit $\beta_1$ als reellem oder komplexen Wert gilt;

g) erster Vergleich des Werts des zweiten Ausgangssignals (out2) oder des Werts eines daraus abgeleiteten Signals mit einem Erwartungswertintervall und schließen auf einen Fehler, wenn der Wert des zweiten Ausgangssignals (out2) oder des daraus abgeleiteten Signals außerhalb des Erwartungswertintervalls liegt.

**4.** Verfahren nach Anspruch 3

h) Bereitstellen eines Referenzelements (RW), das ein Referenzsignal (Rs) liefert,
i) Verarbeiten des Referenzsignals (Rs) in einem Referenzsignalpfad,

- wobei der Referenzsignalpfad gleich dem Signalpfad zur Verarbeitung des Eingangssignals (Si) gestaltet ist,
- wobei der Referenzsignalpfad mit dem Referenzsignal (Rs) beginnt und
- wobei der Referenzsignalpfad mit dem zweiten Ausgangssignal (out2) endet und
- wobei der Referenzsignalpfad am Beginn des Referenzsignalpfads beim Referenzsignal (Rs) vom Signalpfad am Beginn des Signalpfads beim Eingangssignal (Si) verschieden ist und
- wobei der Referenzsignalpfad an einer ersten Stelle des Referenzsignalpfads den Verstärker (DV) mit dem Eingang und dem Ausgang umfasst und
- wobei somit der Verstärker (DV) Teil des Referenzsignalpfads an der ersten Stelle im Referenzsignalpfad und Teil des Signalpfads an der ersten Stelle des Signalpfads ist und
- wobei an einer sechsten Stelle im Referenzsignalpfad zwischen dem Referenzelement (RW) und Eingang des Verstärkers (DV), welche einer sechsten Stelle im Signalpfad zwischen dem Sensorelement (WB) und dem Eingang des Verstärkers (DV) entspricht, ein dem Signalpfad und dem Referenzsignalpfad gemeinsamer Umschalter (DS) mit einem ersten Eingang und einem zweiten Eingang eingefügt ist,
- wobei der gemeinsame Umschalter (DS) in Abhängigkeit von einem zweiten Chopper-Signal (Cs2) seinen ersten Eingang oder seinen zweiten Eingang als einen jeweils aktiven Eingang auswählt und
- wobei der Signalpfad den ersten Eingang des Umschalters (DS) umfasst und
- wobei der Referenzsignalpfad den zweiten Eingang des Umschalters (DS) umfasst und
- wobei der Signalpfad den zweiten Eingang des Umschalters (DS) nicht umfasst und
- wobei der Referenzsignalpfad den ersten Eingang des Umschalters (DS) nicht umfasst und
- wobei der gemeinsame Umschalter (DS) seinen aktiven, in Abhängigkeit von einem zweiten Chopper-Signal (Cs2) gewählten Eingang auswählt und einen Wert an diesem aktiven Eingang des gemeinsamen Umschalters (DS), welcher entsprechend dem Eingangssignal (Si) oder dem Referenzsignal (Rs) entspricht, an den Ausgang des gemeinsamen Umschalters (DS) durchschaltet und
- wobei der Referenzsignalpfad und der Signalpfad in einem Abschnitt vom Ausgang des gemeinsamen Umschalters (DS) einerseits und dem Eingang des Verstärkers (DV) andererseits identisch sind und
- wobei die erste Filterung mit der ersten Filterfunktion F1[] nicht Teil des Referenzpfads ist;

j) viertes Mischen des ersten demodulierten Signals (DM1) oder eines daraus abgeleiteten Signals mit dem zweiten Chopper-Signal (Cs2) zu einem dritten demodulierten Signal (DM3);
k) drittes Filtern des dritten demodulierten Signals (DM3) oder eines daraus abgeleiteten Signals mittels einer dritten Filterfunktion F3[] zu einem dritten Ausgangssignal (out3),

- wobei die erste Filterfunktion F1[] so gewählt ist, dass im Wesentlichen

$$F1[Cs(t)] = 0$$

und

$$F1[Cs2(t)] = 0$$

und

$$F1[Cs90(t)]=0$$

und

$$F1[Cs(t) \times Cs2(t)]=0$$

und

$$F1[Cs(t) \times Cs90(t)]=0$$

und

$$F1[Cs2(t) \times Cs90(t)]=0$$

und

$$F1[Cs(t) \times Cs2(t) \times Cs90(t)]=0$$

und
$F1[1]=\beta_1$ mit $\beta_1$ als reellem oder komplexen Wert gilt, und
- wobei die zweite Filterfunktion F2[] so gewählt ist, dass im Wesentlichen $F2[Cs(t)]=0$ und

$$F2[Cs2(t)]=0$$

und

$$F2[Cs90(t)]=0$$

und

$$F2[Cs(t) \times Cs2(t)]=0$$

und

$$F2[Cs(t) \times Cs90(t)]=0$$

und

$$F2[Cs2(t) \times Cs90(t)]=0$$

und

$$F2[Cs(t) \times Cs2(t) \times Cs90(t)]=0$$

und
$F2[1]=\beta_2$ mit $\beta_2$ als reellem oder komplexen Wert gilt, und
- wobei die dritte Filterfunktion F3[] so gewählt ist, dass im Wesentlichen

$$F3[Cs(t)]=0$$

und

$$F3[Cs2(t)]=0$$

und

$$F3[Cs90(t)]=0$$

und

$$F3[Cs(t) \times Cs2(t)]=0$$

und

$$F3[Cs(t) \times Cs90(t)]=0$$

und

$$F3[Cs2(t) \times Cs90(t)]=0$$

und

$$F3[Cs(t) \times Cs2(t) \times Cs90(t)]=0$$

und
$F3[1]=\beta_3$ mit $\beta_3$ als reellem oder komplexen Wert gilt;

l) zweiter Vergleich des Werts des dritten Ausgangssignals (out3) oder des Werts eines daraus abgeleiteten Signals mit einem dritten Erwartungswertintervall und schließen auf einen Fehler, wenn der Wert des dritten Ausgangssignals (out3) oder der Wert des daraus abgeleiteten Signals außerhalb des dritten Erwartungswertintervalls liegt.

## Claims

1. Method for monitoring a sensor system during operation,

wherein the sensor system comprises a sensor element (WB) that supplies an input signal (Si) with a time course (Si(t)) of an input signal value of the input signal (Si), and
wherein the sensor system comprises a signal path, and
wherein the signal path comprises an amplifier (DV) with an input and an output at a first location of the signal path, and
wherein the signal path begins with the input signal (Si) of the sensor element (WB) and
wherein the signal path ends with a first output signal (out1) of the sensor system, and
wherein a value of the first output signal (out1) or a value of a signal derived therefrom represents a measured value,
comprising the steps

a. first mixing the input signal (Si) in the signal path with a chopper signal (Cs) at a second location in the signal path,

- wherein this second location in the signal path is located between the sensor element (WB) and the input of the amplifier (DV)
and
- wherein the chopper signal (Cs) is band-limited or monofrequent;

b. second mixing of the input signal (Si) at a third point in the signal path with the chopper signal (Cs) to form a first demodulated signal (DM1),

- wherein the third location in the signal path is located between the output of the amplifier (DV) at the first location in the signal path and the first output signal (out1) of the sensor system at the end of the signal path;

c. first filtering of the first demodulated signal (DM1) or a signal derived therefrom at a fourth point in the signal path between the third point in the signal path on the one hand and the first output signal (out1) of the sensor system at the end of the signal path on the other hand,

- wherein this first filtering is performed by applying a first filter function F1[] to the first demodulated signal (DM1) or the signal derived therefrom, and
- wherein the first filter function F1[] describes the relationship between a time curve (DM1(t)) of the first demodulated signal (DM1) or of the signal derived therefrom on the one hand and a time curve of the signal immediately after the first filtering on the other hand
and
- wherein the first output signal (out1) depends on this first demodulated signal (DM1) immediately after the first filtering or is the result of this first filtering,

**characterized by** the additional steps of
d. adding an orthogonal chopper signal (Cs90) or a test signal (TSS) derived therefrom to the input signal (Si) in the signal path at a fifth location in the signal path between the sensor element (WB) and the amplifier (DV),

- wherein the chopper signal (Cs) has a time course (Cs(t)) of the chopper signal (Cs) and
- wherein the orthogonal chopper signal (Cs90) has a time course (Cs90(t)) of the orthogonal chopper signal (Cs90) and
- wherein the time course (Cs90(t)) of the orthogonal chopper signal (Cs) with respect to said first filter function F1[] has, at least temporarily, the property F1[Cs90(t) x Cs(t)]=0, essentially except for noise and similar signal errors;

e. third mixing of the first demodulated signal (DM1) or a signal derived therefrom with the orthogonal chopper signal (Cs90) or a signal derived therefrom and generation of a second demodulated signal (DM2);
f. second filtering of the second demodulated signal (DM2) or a signal derived therefrom by means of a second filter function F2[] to produce a second output signal (out2), wherein

- the second filter function F2[] is selected such that essentially

$$F2[Cs(t)]=0$$

and

$$F2[Cs90(t)]=0$$

and

$$F2[Cs(t) \times Cs90(t)]=0$$

and
F2[1]=$\beta_2$ with $\beta_2$ as a real or complex value and
- the first filter function F1[] is chosen such that essentially

$$F1[Cs(t)]=0$$

and

$$F1[Cs90(t)]=0$$

and

$$F1[Cs(t) \times Cs90(t)]=0$$

and

$F1[1]=\beta_1$ with $\beta_1$ as a real or complex value applies;

g. first comparison of the value of the second output signal (out2) or the value of a signal derived therefrom with an expected value interval and conclude that there is a fault if the value of the second output signal (out2) or the signal derived therefrom lies outside the expected value interval.

2.  Method according to claim 1
    comprising the additional steps

    h. providing a reference element (RW) that supplies a reference signal (Rs),
    i. processing the reference signal (Rs) in a reference signal path,

    - wherein the reference signal path is designed to be the same as the signal path for processing the input signal (Si), and
    - wherein the reference signal path begins with the reference signal (Rs) and
    - wherein the reference signal path ends with the second output signal (out2) and
    - wherein the reference signal path at the beginning of the reference path at the reference signal (Rs) is different from the signal path at the beginning of the signal path at the input signal (Si), and
    - wherein the reference signal path at a first location of the reference signal path comprises the amplifier (DV) with the input and the output, and
    - wherein the amplifier (DV) is thus part of the reference signal path at the first location in the reference signal path and part of the signal path at the first location of the signal path, and
    - wherein the reference signal path at a sixth location in the reference signal path between the reference element (RW) and the input of the amplifier (DV) has a switch (DS) with a first input and a second input, wherein the sixth location in the reference signal path corresponds to a sixth location in the signal path, so that the switch (DS) is also arranged at the sixth position in the signal path between the sensor element (WB) and the input of the amplifier (DV), and thus the switch (DS) is a common switch (DS), and
    - wherein the common switch (DS) selects an active input between its first input and its second input in dependence on a second chopper signal (Cs2), and
    - wherein the signal path comprises the first input of the switch (DS) and
    - wherein the reference signal path comprises the second input of the switch (DS) and
    - wherein the signal path does not comprise the second input of the switch (DS) and
    - wherein the reference path does not comprise the first input of the switch (DS) and
    - wherein the common switch (DS) selects its active input selected in dependence on the second chopper signal (Cs2) and passes the respective current value at this respectively selected active input of the common switch (DS) to an output of the common switch (DS), and
    - wherein the reference signal path and the signal path are identical in a section from the output of the common switch (DS) at the sixth position in the reference signal path and at the sixth position in the signal path on the one hand and the input of the amplifier (DV) at the first position in the reference signal path and signal path on the other hand, and
    - wherein the first filtering with the first filter function F1[] is only part of the signal path and not part of the reference path;

    j. fourth mixing of the first demodulated signal (DM1) or a signal derived therefrom with the second chopper signal (Cs2) to form a third demodulated signal (DM3);
    k. third filtering of the third demodulated signal (DM3) or a signal derived therefrom by means of a third filter function F3[] to form a third output signal (out3),

    - where the first filter function F1[] is selected such that essentially

$$F1[Cs(t)]=0$$

    and

$$F1[Cs2(t)]=0$$

and

$$F1[Cs90(t)]=0$$

and

$$F1[Cs(t)\times Cs2(t)]=0$$

and

$$F1[Cs(t)\times Cs90(t)]=0$$

and

$$F1[Cs2(t)\times Cs90(t)]=0$$

and

$$F1[Cs(t)\times Cs2(t)\times Cs90(t)]=0$$

and
$F1[1]=\beta_1$ with $\beta_1$ as a real or complex value applies, and
- where the second filter function F2[] is chosen such that essentially

$$F2[Cs(t)]=0,$$

$$F2[Cs2(t)]=0,$$

$$F2[Cs90(t)]=0,$$

$$F2[Cs(t)\times Cs2(t)]=0,$$

$$F2[Cs(t)\times Cs90(t)]=0,$$

$$F2[Cs2(t)\times Cs90(t)]=0,$$

$$F2[Cs(t)\times Cs2(t)\times Cs90(t)]=0,$$

and $F2[1]=\beta_2$ with $\beta_2$ as a real or complex value and
- where the third filter function F3[] is chosen such that essentially

$$F3[Cs(t)]=0,$$

$$F3[Cs2(t)]=0,$$

$$F3[Cs90(t)]=0,$$

$$F3[Cs(t)\times Cs2(t)]=0,$$

$$F3[Cs(t)\times Cs90(t)]=0,$$

$$F3[Cs2(t) \times Cs90(t)]=0,$$

$$F3[Cs(t) \times Cs2(t) \times Cs90(t)]=0,$$

and $F3[1]=\beta_3$ with $\beta_3$ as a real or complex value applies;

I. second comparison of a value of the third output signal (out3) or a value of a signal derived therefrom with a third expected value interval and conclude that there is a fault if the value of the third output signal (out3) or the value of the signal derived therefrom lies outside the third expected value interval.

3. Method for monitoring a sensor system in operation,

wherein the sensor system comprises a sensor element (WB) which supplies an input signal (Si) with an input signal value dependent on a test signal (TSS), and
wherein the sensor system has a signal path and
wherein the signal path comprises an amplifier (DV) with an input and an output at a first location in the signal path, and
wherein the signal path begins with the input signal (Si) of the sensor element (WB) and
wherein the signal path ends with a first output signal (out1) and
wherein a value of the output signal (out1) represents a measured value,
comprising the steps

a. first mixing the input signal (Si) with a chopper signal (Cs) at a second point in the signal path

- wherein this second location in the signal path is located between the sensor element (WB) and the input of the amplifier (DV) and
- wherein the chopper signal (Cs) is band-limited or monofrequent;

b. second mixing of the signal at a third point in the signal path with the chopper signal (Cs) to form a first demodulated signal (DM1)

- wherein the third location in the signal path is located between the output of the amplifier (DV) on the one hand and the first output signal (out1) of the sensor system on the other hand;

c. first filtering the first demodulated signal (DM1) or a signal derived therefrom at a fourth location in the signal path between the third location in the signal path on the one hand and the output signal (out1) at the end of the signal path on the other hand,

- wherein this first filtering is performed by applying a first filter function F1[] to the first demodulated signal (DM1) or the signal derived therefrom, and
- wherein the first filter function F1[] describes a relationship between a time curve (DM1(t)) of the first demodulated signal (DM1) or of the signal derived therefrom on the one hand and a time curve of the input signal (Si) on the other hand, wherein this relationship between the time curve (DM1(t)) of the first demodulated signal (DM1) or the signal derived therefrom and the time course of the input signal (Si) is the result of filtering the first demodulated signal (DM1) with the first filter function F1[], and
- wherein the first output signal (out1) depends on this first demodulated signal (DM1) or is the result of this first filtering,

**characterized by** the steps of
d. generating the test signal (TSS) as a function of an orthogonal chopper signal (Cs90);

- wherein the chopper signal (Cs) has a time course (Cs(t)) of the chopper signal (Cs) and
- wherein the orthogonal chopper signal (Cs90) has a time course (Cs90(t)) of the orthogonal chopper signal (Cs90) and
- where the time course (Cs90(t)) of the orthogonal chopper signal (Cs90) with respect to the said first filter function F1[] essentially has the property F1[Cs90(t) x Cs(t)]=0 at least temporarily;

e. third mixing of the first demodulated signal (DM1) or a signal derived therefrom with the orthogonal chopper signal (Cs90) or a signal derived therefrom in a manner described in, and generation of a second demodulated signal (DM2);

f. second filtering of the second demodulated signal (DM2) or a signal derived therefrom by means of a second filter function F2[] to produce a second output signal (out2),

- where the second filter function F2[] is selected such that essentially

$$F2[Cs(t)]=0$$

and

$$F2[Cs90(t)]=0$$

and

$$F2[Cs(t) \times Cs90(t)]=0$$

and
$F2[1]=\beta_2$ with $\beta_2$ as a real or complex value and
- where the first filter function F1[] is chosen such that essentially

$$F1[Cs(t)]=0$$

and

$$F1[Cs90(t)]=0$$

and

$$F1[Cs(t) \times Cs90(t)]=0$$

and
$F1[1]=\beta_1$ with $\beta_1$ as a real or complex value;

g. first comparison of the value of the second output signal (out2) or the value of a signal derived therefrom with an expected value interval and conclude that there is an error if the value of the second output signal (out2) or the signal derived therefrom lies outside the expected value interval.

4. Method according to claim 3

h. Providing a reference element (RW) that supplies a reference signal (Rs),
i. processing the reference signal (Rs) in a reference signal path,

- wherein the reference signal path is designed to be the same as the signal path for processing the input signal (Si),
- wherein the reference signal path begins with the reference signal (Rs) and
- wherein the reference signal path ends with the second output signal (out2), and
- wherein the reference signal path at the beginning of the reference signal path at the reference signal (Rs) is different from the signal path at the beginning of the signal path at the input signal (Si), and
- wherein the reference signal path at a first location of the reference signal path comprises the amplifier (DV) with the input and the output, and
- wherein the amplifier (DV) is thus part of the reference signal path at the first location in the reference signal path and part of the signal path at the first location of the signal path, and
- wherein at a sixth location in the reference signal path between the reference element (RW) and the input of the amplifier (DV), which corresponds to a sixth position in the signal path between the sensor element (WB) and the input of the amplifier (DV), a switch (DS) common to the signal path and the reference signal path is inserted with a first input and a second input,
- wherein the common switch (DS) selects its first input or its second input as a respective active input in dependence on a second chopper signal (Cs2) and
- wherein the signal path comprises the first input of the switch (DS) and
- wherein the reference signal path comprises the second input of the switch (DS) and
- wherein the signal path does not comprise the second input of the switch (DS) and
- wherein the reference signal path does not comprise the first input of the switch (DS) and
- wherein the common switch (DS) selects its active input selected in dependence on a second chopper signal (Cs2) and passes a value at this active input of the common switch (DS), which corresponds to the input signal (Si) or the reference signal (Rs), to the output of the common switch (DS), and
- wherein the reference signal path and the signal path are identical in a section from the output of the common switch (DS) on the one hand and the input of the amplifier (DV) on the other hand, and
- wherein the first filtering with the first filter function F1[] is not part of the reference path;

j. fourthly mixing the first demodulated signal (DM1) or a signal derived therefrom with the second chopper signal (Cs2) to form a third demodulated signal (DM3);
k. third filtering of the third demodulated signal (DM3) or a signal derived therefrom by means of a third filter function F3[] to form a third output signal (out3),

- wherein the first filter function F1[] is selected such that essentially

$$F1[Cs(t)]=0$$

and

$$F1[Cs2(t)]=0$$

and

$$F1[Cs90(t)]=0$$

and

$$F1[Cs(t) \times Cs2(t)]=0$$

and

$$F1[Cs(t) \times Cs90(t)]=0$$

and

$$F1[Cs2(t) \times Cs90(t)]=0$$

and

$$F1[Cs(t) \times Cs2(t) \times Cs90(t)]=0$$

and
$F1[1]=\beta_1$ with $\beta_1$ as a real or complex value applies, and
- where the second filter function F2[] is chosen such that essentially

$$F2[Cs(t)]=0$$

and

$$F2[Cs2(t)]=0$$

and

$$F2[Cs90(t)]=0$$

and

$$F2[Cs(t) \times Cs2(t)]=0$$

and

$$F2[Cs(t) \times Cs90(t)]=0$$

and

$$F2[Cs2(t) \times Cs90(t)]=0$$

and

$$F2[Cs(t) \times Cs2(t) \times Cs90(t)]=0$$

and
$F2[1]=\beta_2$ with $\beta_2$ as a real or complex value applies, and
- where the third filter function F3[] is chosen such that essentially

$$F3[Cs(t)]=0$$

and

$$F3[Cs2(t)]=0$$

and

$$F3[Cs90(t)]=0$$

and

$$F3[Cs(t) \times Cs2(t)]=0$$

and

$$F3[Cs(t) \times Cs90(t)]=0$$

and

$$F3[Cs2(t) \times Cs90(t)]=0$$

and

$$F3[Cs(t) \times Cs2(t) \times Cs90(t)]=0$$

and

F3[1]=$\beta_3$ with $\beta_3$ as a real or complex value applies;

I. second comparison of the value of the third output signal (out3) or the value of a signal derived therefrom with a third expected value interval and conclude that there is a fault if the value of the third output signal (out3) or the value of the signal derived therefrom lies outside the third expected value interval.

**Revendications**

1.  Procédé de surveillance d'un système de capteurs en fonctionnement,

    le système de capteurs comportant un élément capteur (WB) qui fournit un signal d'entrée (Si) avec une courbe temporelle (Si(t)) d'une valeur de signal d'entrée du signal d'entrée (Si) et
    le système de capteurs comportant un chemin de signal
    le chemin de signal comprenant, à un premier emplacement du chemin de signal, un amplificateur (DV) avec une entrée et une sortie, et
    le chemin de signal commençant avec le signal d'entrée (Si) de l'élément capteur (WB) et
    le chemin de signal se terminant par un premier signal de sortie (out1) du système de capteur et
    une valeur du premier signal de sortie (out1) ou une valeur d'un signal dérivé de celui-ci représentant une valeur mesurée,
    comprenant les étapes

    a. premier mélange du signal d'entrée (Si) dans le trajet du signal avec un signal de hache (Cs) à un deuxième emplacement dans le trajet du signal,

    - ce deuxième emplacement dans le trajet du signal étant situé entre l'élément capteur (WB) et l'entrée de l'amplificateur (DV)
    et
    - le signal de hachage (Cs) étant limité en bande ou monofréquence ;

    b. deuxième mélange du signal d'entrée (Si) à un troisième emplacement dans le trajet du signal avec le signal hacheur (Cs) pour former un premier signal démodulé (DM1),

    - le troisième emplacement dans le trajet du signal étant situé entre la sortie de l'amplificateur (DV) au premier emplacement dans le trajet du signal et le premier signal de sortie (out1) du système de capteurs à la fin du trajet du signal;

    c. premier filtrage du premier signal démodulé (DM1) ou d'un signal dérivé de celui-ci à un quatrième emplacement dans le trajet du signal entre le troisième emplacement dans le trajet du signal d'une part et le premier signal de sortie (out1) du système de capteurs à la fin du trajet du signal d'autre part,

    - ce premier filtrage s'effectuant par application d'une première fonction de filtrage F1[] au premier signal démodulé (DM1) ou au signal dérivé de celui-ci, et
    - la première fonction de filtrage F1[] décrivant la relation entre une évolution temporelle (DM1(t)) du premier signal démodulé (DM1) ou du signal dérivé de celui-ci d'une part, et une évolution temporelle du signal immédiatement après le premier filtrage d'autre part
    et
    - le premier signal de sortie (out1) dépendant de ce premier signal démodulé (DM1) immédiatement après le premier filtrage ou étant le résultat de ce premier filtrage,

    **caractérisé par** les étapes supplémentaires consistant à
    d. l'ajout d'un signal hacheur orthogonal (Cs90) ou d'un signal de test (TSS) dérivé de celui-ci au signal d'entrée (Si) dans le chemin du signal à un cinquième emplacement dans le chemin du signal entre l'élément capteur (WB) et l'amplificateur (DV),

    - le signal de hachage (Cs) présentant une évolution temporelle (Cs(t)) du signal de hachage (Cs) et
    - le signal chopper orthogonal (Cs90) présentant une courbe temporelle (Cs90(t)) du signal chopper orthogonal (Cs90) et

- l'évolution temporelle (Cs90(t)) du signal de hachage orthogonal (Cs) par rapport à ladite première fonction de filtrage F1[] présentant, au moins temporairement, la propriété F1[Cs90(t) x Cs(t)]=0, à l'exception du bruit et d'erreurs de signal similaires.

e. troisième mélange du premier signal démodulé (DM1) ou d'un signal dérivé de celui-ci avec le signal chopper orthogonal (Cs90) ou un signal dérivé de celui-ci et génération d'un deuxième signal démodulé (DM2);

f. deuxième filtrage du deuxième signal démodulé (DM2) ou d'un signal dérivé de celui-ci au moyen d'une deuxième fonction de filtrage F2[] pour obtenir un deuxième signal de sortie (out2),

- la deuxième fonction de filtrage F2[] est choisie de telle sorte que, pour l'essentiel

$$F2[Cs(t)]=0$$

et

$$F2[Cs90(t)]=0$$

et

$$F2[Cs(t)x\ Cs90(t)]=0$$

et
$F2[1]=\beta_2$ avec $\beta_2$ comme valeur réelle ou complexe
et
- la première fonction de filtrage F1[] est choisie de telle sorte que, pour l'essentiel

$$F1[Cs(t)]=0$$

et

$$F1[Cs90(t)]=0$$

et

$$F1[Cs(t)x\ Cs90(t)]=0$$

et
$F1[1]=\beta_1$ avec $\beta_1$ comme valeur réelle ou complexe;

g. première comparaison de la valeur du deuxième signal de sortie (out2) ou de la valeur d'un signal dérivé de celui-ci avec un intervalle de valeur attendue et conclusion d'un défaut lorsque la valeur du deuxième signal de sortie (out2) ou du signal dérivé de celui-ci se situe en dehors de l'intervalle de valeur attendue.

2. Procédé selon la revendication 1
comprenant les étapes supplémentaires

h. fournir un élément de référence (RW) qui fournit un signal de référence (Rs),
i. traitement du signal de référence (Rs) dans un chemin de signal de référence,

- le chemin de signal de référence étant conçu de manière identique au chemin de signal pour le traitement du signal d'entrée (Si), et
- le chemin de signal de référence commençant avec le signal de référence (Rs) et
- le chemin de signal de référence se terminant avec le deuxième signal de sortie (out2) et
- le chemin de signal de référence au début du chemin de référence au niveau du signal de référence (Rs) étant différent du chemin de signal au début du chemin de signal au niveau du signal d'entrée (Si) et

- dans lequel le trajet de signal de référence comprend, à un premier emplacement du trajet de signal de référence, l'amplificateur (DV) avec l'entrée et la sortie, et

- l'amplificateur (DV) faisant ainsi partie du chemin de signal de référence au premier emplacement dans le chemin de signal de référence et faisant partie du chemin de signal au premier emplacement du chemin de signal, et

- le chemin de signal de référence comportant, à un sixième emplacement dans le chemin de signal de référence, entre l'élément de référence (RW) et l'entrée de l'amplificateur (DV), un commutateur (DS) avec une première entrée et une deuxième entrée, le sixième emplacement dans le chemin de signal de référence correspondant à un sixième emplacement dans le chemin de signal, de sorte que le commutateur (DS) est également disposé à la sixième position dans le chemin de signal entre l'élément capteur (WB) et l'entrée de l'amplificateur (DV), et que le commutateur (DS) est ainsi un commutateur commun (DS), et

- le commutateur commun (DS) sélectionnant une entrée active en fonction d'un deuxième signal de hacheur (Cs2) entre sa première entrée et sa deuxième entrée, et

- le trajet de signal comprenant la première entrée du commutateur (DS) et

- le chemin de signal de référence comprenant la deuxième entrée du commutateur (DS) et

- dans lequel le chemin de signal ne comprend pas la deuxième entrée du commutateur (DS) et

- le chemin de référence ne comprenant pas la première entrée du commutateur (DS) et

- dans lequel le commutateur commun (DS) sélectionne son entrée active, choisie en fonction du deuxième signal de hacheur (Cs2), et transmet la valeur actuelle respective à cette entrée active sélectionnée du commutateur commun (DS) à une sortie du commutateur commun (DS) et

- le chemin de signal de référence et le chemin de signal étant identiques dans une section allant de la sortie du commutateur commun (DS) à la sixième position dans le chemin de signal de référence et à la sixième position dans le chemin de signal d'une part, et l'entrée de l'amplificateur (DV) à la première position dans le chemin de signal de référence et le chemin de signal d'autre part, et

- la première filtrage avec la première fonction de filtrage F1[] n'étant qu'une partie du chemin de signal et ne faisant pas partie du chemin de référence;

j. quatrième mélange du premier signal démodulé (DM1) ou d'un signal dérivé de celui-ci avec le deuxième signal de hachage (Cs2) pour obtenir un troisième signal démodulé (DM3);

k. troisième filtrage du troisième signal démodulé (DM3) ou d'un signal dérivé de celui-ci au moyen d'une troisième fonction de filtrage F3[] pour obtenir un troisième signal de sortie (out3),

- la première fonction de filtrage F1[] étant choisie de telle sorte que, pour l'essentiel

$$F1[Cs(t)]=0$$

et

$$F1[Cs2(t)]=0$$

et

$$F1[Cs90(t)]=0$$

et

$$F1[Cs(t) \times Cs2(t)]=0$$

et

$$F1[Cs(t) \times Cs90(t)]=0$$

et

$$F1[Cs2(t) \times Cs90(t)]=0$$

et

$$F1[Cs(t) \times Cs2(t) \times Cs90(t)]=0$$

et
F1[1]=$\beta_1$ avec $\beta_1$ comme valeur réelle ou complexe s'applique, et
- la deuxième fonction de filtrage F2[] étant choisie de telle sorte que, pour l'essentiel,

$$F2[Cs(t)]=0,$$

$$F2[Cs2(t)]=0,$$

$$F2[Cs90(t)]=0,$$

$$F2[Cs(t) \times Cs2(t)]=0,$$

$$F2[Cs(t) \times Cs90(t)]=0,$$

$$F2[Cs2(t) \times Cs90(t)]=0,$$

$$F2[Cs(t) \times Cs2(t) \times Cs90(t)]=0,$$

et F2[1]=$\beta_2$ avec $\beta_2$ comme valeur réelle ou complexe, et
- la troisième fonction de filtrage F3[] étant choisie de telle sorte que, pour l'essentiel,

$$F3[Cs(t)]=0,$$

$$F3[Cs2(t)]=0,$$

$$F3[Cs90(t)]=0,$$

$$F3[Cs(t) \times Cs2(t)]=0,$$

$$F3[Cs(t) \times Cs90(t)]=0,$$

$$F3[Cs2(t) \times Cs90(t)]=0,$$

$$F3[Cs(t) \times Cs2(t) \times Cs90(t)]=0,$$

et F3[1]=$\beta_3$ avec $\beta_3$ comme valeur réelle ou complexe;

l. deuxième comparaison d'une valeur du troisième signal de sortie (out3) ou d'une valeur d'un signal dérivé de celui-ci avec un troisième intervalle de valeur attendue et conclusion d'un défaut si la valeur du troisième signal de sortie (out3) ou la valeur du signal dérivé de celui-ci se situe en dehors du troisième intervalle de valeur attendue.

3. Procédé de surveillance d'un système de capteurs en fonctionnement,

le système de capteurs comportant un élément capteur (WB) qui délivre un signal d'entrée (Si) avec une valeur de signal d'entrée en fonction d'un signal de test (TSS) et
le système de capteurs comportant un chemin de signal et
le chemin de signal comprenant, à un premier emplacement dans le chemin de signal, un amplificateur (DV) avec une entrée et une sortie, et

le chemin de signal commençant avec le signal d'entrée (Si) de l'élément capteur (WB) et

le chemin de signal se terminant par un premier signal de sortie (out1) et

une valeur du signal de sortie (out1) représentant une valeur mesurée,

comprenant les étapes

a. premier mélange du signal d'entrée (Si) avec un signal de hache (Cs) à un deuxième emplacement dans le trajet du signal

- ce deuxième emplacement dans le trajet du signal étant situé entre l'élément capteur (WB) et l'entrée de l'amplificateur (DV)
et
- le signal de hachage (Cs) étant limité en bande ou monofréquence;

b. deuxième mélange du signal à un troisième emplacement dans le trajet du signal avec le signal hacheur (Cs) pour former un premier signal démodulé (DM1)

- le troisième emplacement dans le trajet du signal étant situé entre la sortie de l'amplificateur (DV) d'une part et le premier signal de sortie (out1) du système de capteurs d'autre part;

c. premier filtrage du premier signal démodulé (DM1) ou d'un signal dérivé de celui-ci en un quatrième emplacement dans le trajet du signal entre le troisième emplacement dans le trajet du signal d'une part et le signal de sortie (out1) à la fin du trajet du signal d'autre part,

- ce premier filtrage s'effectuant par application d'une première fonction de filtrage F1[] au premier signal démodulé (DM1) ou au signal dérivé de celui-ci, et
- la première fonction de filtrage F1[] décrivant une relation entre une évolution temporelle (DM1(t)) du premier signal démodulé (DM1) ou du signal dérivé de celui-ci d'une part, et une évolution temporelle du signal d'entrée (Si) d'autre part, cette relation entre l'évolution temporelle (DM1(t)) du premier signal démodulé (DM1) ou du signal dérivé de celui-ci et la courbe temporelle du signal d'entrée (Si) est le résultat du filtrage du premier signal démodulé (DM1) avec la première fonction de filtrage F1[] et
- le premier signal de sortie (out1) dépendant de ce premier signal démodulé (DM1) ou étant le résultat de ce premier filtrage,

**caractérisé par** les étapes suivantes :

d. générer le signal de test (TSS) en fonction d'un signal de hachage orthogonal (Cs90) ;

- le signal de hachage (Cs) présentant une évolution temporelle (Cs(t)) du signal de hachage (Cs) et
- le signal de hachage orthogonal (Cs90) présentant une courbe temporelle (Cs90(t)) du signal de hachage orthogonal (Cs90) et
- où la courbe temporelle (Cs90(t)) du signal orthogonal Chopper (Cs90) par rapport à ladite première fonction de filtrage F1[] présente essentiellement, à l'exception du bruit et d'erreurs de signal similaires, la propriété
F1[Cs90(t) x Cs(t)]=0, au moins temporairement;

e. troisième mélange du premier signal démodulé (DM1) ou d'un signal dérivé de celui-ci avec le signal chopper orthogonal (Cs90) ou un signal dérivé de celui-ci de manière à et génération d'un deuxième signal démodulé (DM2);

f. deuxième filtrage du deuxième signal démodulé (DM2) ou d'un signal dérivé de celui-ci au moyen d'une deuxième fonction de filtrage F2[] pour obtenir un deuxième signal de sortie (out2),

- la deuxième fonction de filtrage F2[] étant choisie de telle sorte que, pour l'essentiel

$$F2[Cs(t)]=0$$

et

$$F2[Cs90(t)]=0$$

et

$$F2[Cs(t)x\ Cs90(t)]=0$$

et
$F2[1]=\beta_2$ avec $\beta_2$ comme valeur réelle ou complexe
et
- la première fonction de filtrage F1[] étant choisie de telle sorte que, pour l'essentiel

$$F1[Cs(t)]=0$$

et

$$F1[Cs90(t)]=0$$

et

$$F1[Cs(t)x\ Cs90(t)]=0$$

et
$F1[1]=\beta_1$ avec $\beta_1$ comme valeur réelle ou complexe;

g. première comparaison de la valeur du deuxième signal de sortie (out2) ou de la valeur d'un signal dérivé de celui-ci avec un intervalle de valeur attendue et conclusion d'un défaut lorsque la valeur du deuxième signal de sortie (out2) ou du signal dérivé de celui-ci se situe en dehors de l'intervalle de valeur attendue.

**4.** Procédé selon la revendication 3

h. Fournir un élément de référence (RW) qui fournit un signal de référence (Rs),
i. traitement du signal de référence (Rs) dans un chemin de signal de référence,

- le chemin de signal de référence étant conçu de manière identique au chemin de signal pour le traitement du signal d'entrée (Si),
- le chemin de signal de référence commençant avec le signal de référence (Rs) et
- le chemin de signal de référence se terminant avec le deuxième signal de sortie (out2) et
- le chemin de signal de référence au début du chemin de signal de référence au niveau du signal de référence (Rs) étant différent du chemin de signal au début du chemin de signal au niveau du signal d'entrée (Si) et
- le chemin de signal de référence comprenant, à un premier emplacement du chemin de signal de référence, l'amplificateur (DV) avec l'entrée et la sortie, et
- l'amplificateur (DV) faisant ainsi partie du chemin de signal de référence au premier emplacement dans le chemin de signal de référence et faisant partie du chemin de signal au premier emplacement du chemin de signal, et
- dans lequel, à un sixième emplacement dans le trajet de signal de référence entre l'élément de référence (RW) et l'entrée de l'amplificateur (DV) qui correspond à un sixième emplacement dans le trajet du signal entre l'élément capteur (WB) et l'entrée de l'amplificateur (DV), un commutateur (DS) commun au trajet du signal et au trajet du signal de référence est inséré avec une première entrée et une deuxième entrée,
- le commutateur commun (DS) sélectionnant, en fonction d'un deuxième signal de hacheur (Cs2), sa première entrée ou sa deuxième entrée comme entrée active, et
- le chemin de signal comprenant la première entrée du commutateur (DS) et
- le chemin de signal de référence comprenant la deuxième entrée du commutateur (DS) et
- le chemin de signal ne comprenant pas la deuxième entrée du commutateur (DS) et
- le chemin de signal de référence ne comprenant pas la première entrée du commutateur (DS) et

- le commutateur commun (DS) sélectionnant son entrée active, choisie en fonction d'un deuxième signal de hacheur (Cs2) et transmet à la sortie du commutateur commun (DS) une valeur à cette entrée active du commutateur commun (DS) qui correspond au signal d'entrée (Si) ou au signal de référence (Rs)

- dans lequel le chemin de signal de référence et le chemin de signal sont identiques dans une section comprise entre la sortie du commutateur commun (DS) d'une part et l'entrée de l'amplificateur (DV) d'autre part, et

- le premier filtrage avec la première fonction de filtrage F1[] ne faisant pas partie du chemin de référence;

j. quatrième mélange du premier signal démodulé (DM1) ou d'un signal dérivé de celui-ci avec le deuxième signal de hache (Cs2) pour former un troisième signal démodulé (DM3);

k. troisième filtrage du troisième signal démodulé (DM3) ou d'un signal dérivé de celui-ci au moyen d'une troisième fonction de filtrage F3[] pour obtenir un troisième signal de sortie (out3),

- la première fonction de filtrage F1[] étant choisie de telle sorte que, pour l'essentiel

$$F1[Cs(t)]=0$$

et

$$F1[Cs2(t)]=0$$

et

$$F1[Cs90(t)]=0$$

et

$$F1[Cs(t) \times Cs2(t)]=0$$

et

$$F1[Cs(t) \times Cs90(t)]=0$$

et

$$F1[Cs2(t) \times Cs90(t)]=0$$

et

$$F1[Cs(t) \times Cs2(t) \times Cs90(t)]=0$$

et
$F1[1]=\beta_1$ avec $\beta_1$ comme valeur réelle ou complexe s'applique, et

- la deuxième fonction de filtrage F2[] étant choisie de telle sorte que, pour l'essentiel

$$F2[Cs(t)]=0$$

et

$$F2[Cs2(t)]=0$$

et

$$F2[Cs90(t)]=0$$

et

$$F2[Cs(t) \times Cs2(t)]=0$$

et

$$F2[Cs(t) \times Cs90(t)]=0$$

et

$$F2[Cs2(t) \times Cs90(t)]=0$$

et

$$F2[Cs(t) \times Cs2(t) \times Cs90(t)]=0$$

et
$F2[1]=\beta_2$ avec $\beta_2$ comme valeur réelle ou complexe s'applique, et
- la troisième fonction de filtrage F3[] étant choisie de telle sorte que, pour l'essentiel

$$F3[Cs(t)]=0$$

et

$$F3[Cs2(t)]=0$$

et

$$F3[Cs90(t)]=0$$

et

$$F3[Cs(t) \times Cs2(t)]=0$$

et

$$F3[Cs(t) \times Cs90(t)]=0$$

et

$$F3[Cs2(t) \times Cs90(t)]=0$$

et

$$F3[Cs(t) \times Cs2(t) \times Cs90(t)]=0$$

et
$F3[1]=\beta_3$ avec $\beta_3$ comme valeur réelle ou complexe s'applique ;

l. deuxième comparaison de la valeur du troisième signal de sortie (out3) ou de la valeur d'un signal dérivé de celui-ci avec un troisième intervalle de valeur attendue et conclusion d'un défaut si la valeur du troisième signal de sortie (out3) ou la valeur du signal dérivé de celui-ci se situe en dehors du troisième intervalle de valeur attendue.

Fig. 1

EP 4 217 700 B1

CS

CS90

TSS

Si

SiT

MSiT

DM1

out1

DM2

t

EP 4 217 700 B1

**Fig. 2**

Fig. 3

CS

CS90

TSS
Si

MSi

MSiT

DM1

out1

DM2

EP 4 217 700 B1

Fig. 4

Fig. 5

EP 4 217 700 B1

Fig. 6

EP 4 217 700 B1

Fig. 7

EP 4 217 700 B1

**EP 4 217 700 B1**

**In der Beschreibung aufgeführte Patentdokumente**

- US 2005038623 A1
- CN 109212258 A
- EP 2524389 B1
- EP 2524390 B1
- EP 2524198 B1
- EP 2523896 B1
- EP 2523895 B1

**In der Beschreibung aufgeführte Nicht-Patentliteratur**

- **WEI CHIA-LING et al.** Respiration Detection Chip With Integrated Temperature-Insensitive MEMS Sensors and CMOS Signal Processing Circuits. *IEEE Transactions on biomedical circuits and systems*, vol. 9 (1), 105-112
- **GODOY et al.** Chopper Stabilization of Analog Multipliers, variable gain amplifiers, and mixers. *IEEE Journal of solid-state circuits*, vol. 43 (10), 2311-2321